# EUROPEAN PATENT APPLICATION

(11) **EP 4 325 292 A1**
(43) Date of publication of application: **21.02.2024**
(21) Application number: 23190382.4
(22) Date of filing: 08.08.2023
(51) Int. Cl.: G03F 7/039, G03F 7/004

(54) **CHEMICALLY AMPLIFIED POSITIVE RESIST COMPOSITION AND RESIST PATTERN FORMING PROCESS**

(30) Priority: 10.08.2022 JP 2022127513
(71) Applicant: SHIN-ETSU CHEMICAL CO., LTD., Tokyo 1000005 (JP)
(72) Inventor: MASUNAGA, Keichii, NIIGATA-KEN (JP); WATANABE, Satoshi, NIIGATA-KEN (JP); FUNATSU, Kenji, NIIGATA-KEN (JP); FUKUSHIMA, Masahiro, NIIGATA-KEN (JP); KOTAKE, Masaaki, NIIGATA-KEN (JP); MATSUZAWA, Yuta, NIIGATA-KEN (JP)
(74) Representative: Ter Meer Steinmeister & Partner

(57) **Abstract**

A chemically amplified positive resist composition comprising (A) a base polymer, (B) a photoacid generator, and (C) a quencher is provided. The base polymer (A) contains a polymer comprising phenolic hydroxy group-containing units, aromatic ring-containing units, and units containing a phenolic hydroxy group protected with an acid labile group. The photoacid generator (B) and the quencher (C) are present in a weight ratio (B)/(C) of less than 3/1. The resist composition exhibits a very high isolated-space resolution and forms a pattern with reduced LER, rectangularity, minimized influences of develop loading and residue defects.

## Description

### TECHNICAL FIELD

This invention relates to a chemically amplified positive resist composition and a resist pattern forming process using the same.

### BACKGROUND ART

To meet the recent demand for higher integration in integrated circuits, pattern formation to a smaller feature size is required. Acid-catalyzed chemically amplified resist compositions are most often used in forming resist patterns with a feature size of 0.2 µm or less. High-energy radiation such as UV, deep-UV, EUV or EB is used as the energy source for exposure of these resist compositions. In particular, the EB lithography, which is utilized as the ultra-fine microfabrication technique, is also indispensable in processing a photomask blank into a photomask for use in the fabrication of semiconductor devices.

In general, the EB lithography is by writing an image with EB, without using a mask. In the case of positive resist, those regions of a resist film other than the regions to be retained are successively irradiated with EB having a minute area. In the case of negative resist, those regions of a resist film to be retained are successively irradiated with EB having a minute area. The operation of successively scanning all finely divided regions on the work surface takes a long time as compared with one-shot exposure through a photomask. To avoid any throughput decline, a resist film having a high sensitivity is required. One of the important applications of chemically amplified resist material resides in processing of photomask blanks. Some photomask blanks have a surface material that can have an impact on the pattern profile of the overlying chemically amplified resist film, for example, a layer of a chromium compound, typically chromium oxide deposited on a photomask substrate. For high resolution and profile retention after etching, it is one important performance factor to maintain the profile of a resist film pattern rectangular independent of the type of substrate. A small line edge roughness (LER) is another important performance factor. In recent years, the multibeam mask writing (MBMW) process is used in the processing of mask blanks to achieve further miniaturization. The resist used in the MBMW process is a low-sensitivity resist composition (or high-dose region) which is advantageous in roughness while a spotlight is brought to the optimization of the resist composition in the high-dose region.

The control of resist sensitivity and pattern profile has been improved by a proper selection and combination of resist material components and processing conditions. One improvement pertains to the diffusion of acid that largely affects the resolution of a resist film. In the processing of photomasks, it is required that the profile of a resist pattern formed do not change with a lapse of time from the end of exposure to bake. The major cause of such a change of resist pattern profile with time is diffusion of an acid generated upon exposure. The problem of acid diffusion has been widely studied not only in terms of photomask processing, but also in terms of general resist compositions because the acid diffusion has a significant impact on sensitivity and resolution.

Patent Documents 1 and 2 describe acid generators capable of generating bulky acids for controlling acid diffusion and reducing LER. Since these acid generators are still insufficient to control acid diffusion, it is desired to have an acid generator with more controlled acid diffusion.

Patent Document 3 discloses a resist composition comprising a base polymer having introduced therein repeat units having a sulfonium structure capable of generating a sulfonic acid upon light exposure. This approach of controlling acid diffusion by introducing repeat units capable of generating acid upon exposure into a base polymer is effective in forming a pattern with small LER. However, the base polymer having introduced therein repeat units capable of generating acid upon exposure sometimes encounters a problem with respect to its solubility in organic solvent, depending on the structure and proportion of the repeat units.

Polymers comprising a major proportion of aromatic structure having an acidic side chain, for example, polyhydroxystyrene are useful as a base polymer in resist materials for the KrF excimer laser lithography. These polymers are not used in resist materials for the ArF excimer laser lithography because they exhibit strong absorption to radiation of wavelength around 200 nm. These polymers, however, are expected to form useful resist materials for the EB and EUV lithography for forming patterns of smaller size than the processing limit of ArF excimer laser because they offer high etching resistance.

Often used as the base polymer in positive resist compositions for EB and EUV lithography is a polymer having an acidic functional group on phenol side chain masked with an acid labile group. Upon exposure to high-energy radiation, a photoacid generator generates an acid and the acid labile group is deprotected by the catalysis of the generated acid whereby the polymer turns soluble in alkaline developer. Typical of the acid labile group are tertiary alkyl, tert-butoxycarbonyl, and acetal groups. See Patent Documents 4 to 7.

The use of acid labile groups (e.g., acetal groups) requiring a relatively low level of activation energy for deprotection offers the advantage that a resist film having a high sensitivity is obtainable. In the MBMW image writing process by the EB lithography for the fabrication of advanced photomasks of 10 nm node or less, images are written in thin-film regions where a resist film has a thickness of 100 nm or less and in high-dose regions having a high level of irradiation energy. If acetal has a high reactivity and a bulky structure, deprotection reaction can occur even in the unexposed region of the resist film and residues are left in the exposed region. There arise such problems as degradations of resolution of isolated spaces and LER, which are regarded important for positive resist compositions, and formation of defects.

It is known that a develop loading phenomenon arises in the development step of the photomask fabrication process. That is, the finish size of pattern features differs between a grouped region and an isolated region on a photomask. Due to the develop loading, the distribution of pattern finish size becomes non-uniform depending on the surrounding pattern feature distribution. This is caused by a difference in elimination reaction during acid generation due to an energy difference of EB and a difference of dissolution rate in alkaline developer between grouped and isolated images. As one solution, Patent Document 8 discloses a beam dose computing method of an EB writing apparatus comprising the steps of adjusting an input dose in the EB writing apparatus so as to correct develop loading effects, and irradiating EB in the adjusted dose for thereby writing a pattern on a photomask. However, since the prior art correcting method has not fully taken into account the develop loading phenomenon for correction, the accuracy of correcting develop loading effects is not so high. To solve such problems, Patent Document 9 discloses an imaging method and Patent Document 10 discloses a method of improving a development mode after patterning. These methods are insufficient for establishing a uniform distribution of grouped and isolated features in the lithography of advanced generation. It is desired to improve a resist composition so as to achieve a high resolution and reductions of develop loading and residue defects in the lithography of advanced generation.

### Citation List

Patent Document 1: JP-A 2009-053518
Patent Document 2: JP-A 2010-100604
Patent Document 3: JP-A 2011-022564
Patent Document 4: JP 3963625
Patent Document 5: JP 5385017
Patent Document 6: JP-A 2019-167419
Patent Document 7: JP 6987873
Patent Document 8: JP-A 2007-150243 (USP 7740991)
Patent Document 9: JP 5443548
Patent Document 10: JP 6281244

### SUMMARY OF INVENTION

An object of the invention is to provide a chemically amplified positive resist composition which is lithographically processed into a resist pattern with a very high resolution of isolated spaces, reduced LER, improved rectangularity, and minimized influences of develop loading and residue defects, and a resist pattern forming process using the same.

The inventors have found that when a resist composition comprises a base polymer having acid labile groups of acetal type, a photoacid generator, and a quencher wherein the photoacid generator and the quencher are present in a controlled ratio, a resist pattern with satisfactory isolated-space resolution, pattern profile and LER is formed even in high dose regions while controlling the influences of develop loading and residue defects.

Accordingly, the invention provides a chemically amplified positive resist composition and resist pattern forming process, as defined below.
1. A chemically amplified positive resist composition adapted for EB lithography comprising (A) a base polymer, (B) a photoacid generator, and (C) a quencher,
   the base polymer (A) containing a polymer comprising phenolic hydroxy group-containing units having the formula (A1), aromatic ring-containing units having any one of the formulae (A2) to (A4), and units containing a phenolic hydroxy group protected with an acid labile group, having the formula (A5), all the repeat units of the polymer having an aromatic ring structure, 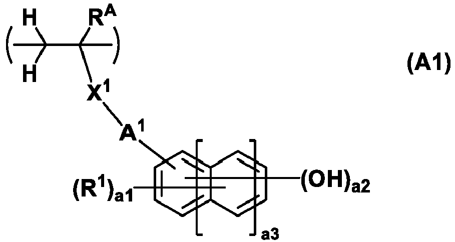 wherein a1 is an integer meeting 0 ≤ a1 ≤ 5+2a3-a2, a2 is an integer of 1 to 3, a3 is an integer of 0 to 2,
   R^{A} is hydrogen, fluorine, methyl or trifluoromethyl,
   X¹ is a single bond, *-C(=O)-O- or *-C(=O)-NH-, * designates a point of attachment to the carbon atom in the backbone,
   A¹ is a single bond or a C₁-C₁₀ saturated hydrocarbylene group in which some -CH₂-may be replaced by -O-,
   R¹ is halogen, optionally halogenated C₂-C₈ saturated hydrocarbylcarbonyloxy group, optionally halogenated C₁-C₆ saturated hydrocarbyl group or optionally halogenated C₁-C₆ saturated hydrocarbyloxy group, 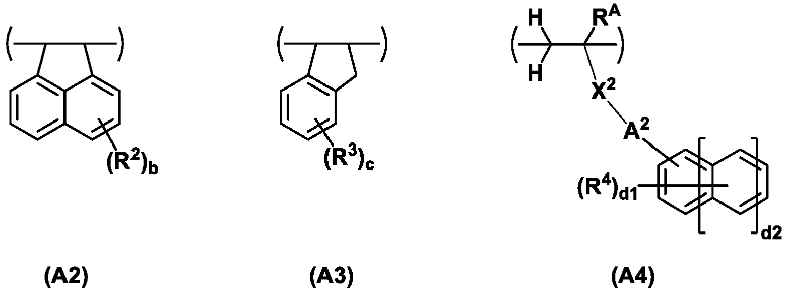 wherein R^{A} is as defined above,
   b and c are each independently an integer of 0 to 4, d1 is an integer of 0 to 5, d2 is an integer of 0 to 2,
   X² is a single bond, *-C(=O)-O- or *-C(=O)-NH-, * designates a point of attachment to the carbon atom in the backbone,
   A² is a single bond or a C₁-C₁₀ saturated hydrocarbylene group in which some -CH₂-may be replaced by -O-,
   R² and R³ are each independently hydroxy, halogen, optionally halogenated C₂-C₈ saturated hydrocarbylcarbonyloxy group, optionally halogenated C₁-C₈ saturated hydrocarbyl group or optionally halogenated C₁-C₈ saturated hydrocarbyloxy group,
   R⁴ is an acetyl group, C₁-C₂₀ saturated hydrocarbyl group, C₁-C₂₀ saturated hydrocarbyloxy group, C₂-C₂₀ saturated hydrocarbylcarbonyloxy group, C₂-C₂₀ saturated hydrocarbyloxyhydrocarbyl group, C₂-C₂₀ saturated hydrocarbylthiohydrocarbyl group, halogen, nitro group, or cyano group, R⁴ may be hydroxy in case of d2=1 or 2, 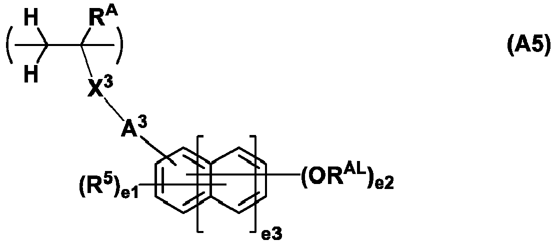 wherein R^{A} is as defined above,
   e1 is an integer meeting 0 ≤ e1 ≤ 5+2e3-e2, e2 is an integer of 1 to 3, e3 is an integer of 0 to 2,
   X³ is a single bond, *-C(=O)-O- or *-C(=O)-NH-, * designates a point of attachment to the carbon atom in the backbone,
   A³ is a single bond or a C₁-C₁₀ saturated hydrocarbylene group in which some -CH₂-may be replaced by -O-,
   R⁵ is halogen, optionally halogenated C₂-C₈ saturated hydrocarbylcarbonyloxy group, optionally halogenated C₁-C₆ saturated hydrocarbyl group or optionally halogenated C₁-C₆ saturated hydrocarbyloxy group,
   in case of e2=1, R^{AL} is an acetal type acid labile group having the formula (A5-1): 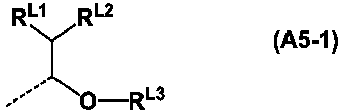 wherein R^{L1} and R^{L2} are each independently a C₁-C₃ saturated hydrocarbyl group, R^{L1} and R^{L2} may bond together to form a ring with the carbon atom to which they are attached, R^{L3} is a C₁-C₅ hydrocarbyl group, the broken line designates a point of attachment,
   in case of e2 ≥ 2, R^{AL} is hydrogen or an acetal type acid labile group having formula (A5-1), at least one R^{AL} being an acetal type acid labile group having formula (A5-1),
   the photoacid generator (B) and the quencher (C) being present in a weight ratio (B)/(C) of less than 3/1.
2. The resist composition of 1 wherein the phenolic hydroxy group-containing units have the formula (A1-1): 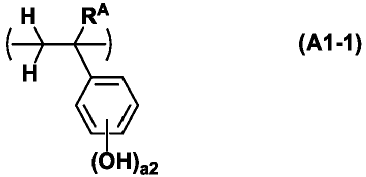 wherein R^{A} and a2 are as defined above.
3. The resist composition of 1 or 2 wherein the units containing a phenolic hydroxy group protected with an acid labile group have the formula (A5-2): 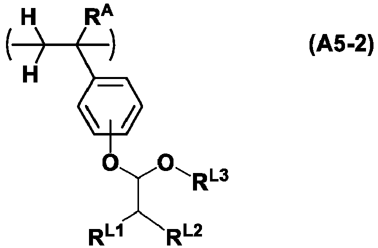 wherein R^{A}, R^{L1}, R^{L2} and R^{L3} are as defined above.
4. The resist composition of any one of 1 to 3 wherein the photoacid generator (B) generates an acid having an acid strength (pKa) of -2.0 or more.
5. The resist composition of 4 wherein the photoacid generator (B) is a salt compound containing an anion having the formula (B-1): 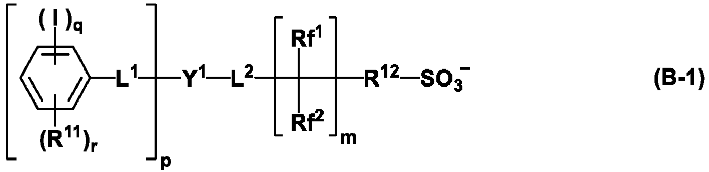 wherein m is 0 or 1, p is an integer of 1 to 3, q is an integer of 1 to 5, r is an integer of 0 to 3,
   L¹ is a single bond, ether bond, ester bond, sulfonic ester bond, carbonate bond or carbamate bond,
   L² is an ether bond, ester bond, sulfonic ester bond, carbonate bond or carbamate bond,
   in case of p=1, Y¹ is a single bond or a C₁-C₂₀ hydrocarbylene group, in case of p=2 or 3, Y¹ is a C₁-C₂₀ (p+1)-valent hydrocarbon group, the hydrocarbylene group and (p+1)-valent hydrocarbon group may contain at least one moiety selected from ether bond, carbonyl moiety, ester bond, amide bond, sultone ring, lactam ring, carbonate bond, halogen, hydroxy moiety and carboxy moiety,
   Rf¹ and Rf² are each independently hydrogen, fluorine or trifluoromethyl, at least one being fluorine or trifluoromethyl,
   R¹¹ is hydroxy, carboxy, C₁-C₆ saturated hydrocarbyl group, C₁-C₆ saturated hydrocarbyloxy group, C₂-C₆ saturated hydrocarbylcarbonyloxy group, fluorine, chlorine, bromine, amino, -N(R^{11A})-C(=O)-R^{11B} or -N(R^{11A})-C(=O)-O-R^{11B}, R^{11A} is hydrogen or a C₁-C₆ saturated hydrocarbyl group, R^{11B} is a C₁-C₆ saturated hydrocarbyl group or C₂-C₈ unsaturated aliphatic hydrocarbyl group, and
   R¹² is a C₁-C₂₀ saturated hydrocarbylene group or C₆-C₁₄ arylene group, some or all of the hydrogen atoms in the saturated hydrocarbylene group may be substituted by halogen other than fluorine, some or all of the hydrogen atoms in the arylene group may be substituted by a substituent selected from C₁-C₂₀ saturated hydrocarbyl groups, C₁-C₂₀ saturated hydrocarbyloxy groups, C₆-C₁₄ aryl groups, halogen, and hydroxy.
6. The positive resist composition of any one of 1 to 5, further comprising (D) a fluorinated polymer comprising repeat units of at least one type selected from repeat units having the formula (D1), repeat units having the formula (D2), repeat units having the formula (D3) and repeat units having the formula (D4) and optionally repeat units of at least one type selected from repeat units having the formula (D5) and repeat units having the formula (D6): 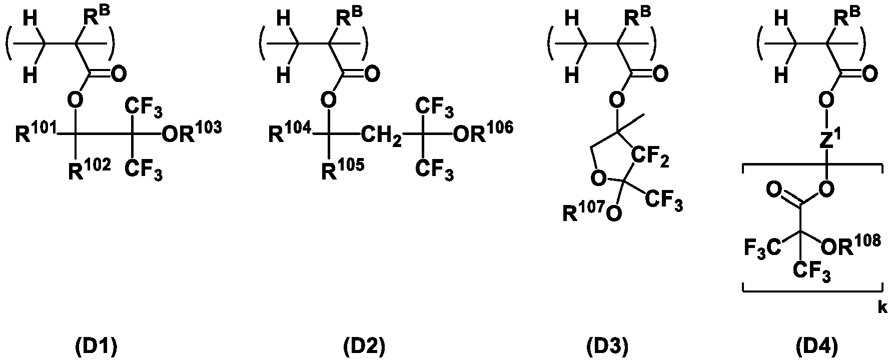 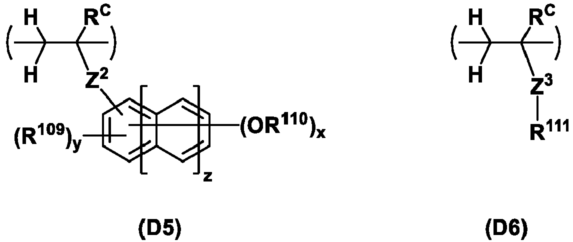 wherein R^{B} is each independently hydrogen, fluorine, methyl or trifluoromethyl,
   R^{C} is each independently hydrogen or methyl,
   R¹⁰¹, R¹⁰², R¹⁰⁴ and R¹⁰⁵ are each independently hydrogen or a C₁-C₁₀ saturated hydrocarbyl group,
   R¹⁰³, R¹⁰⁶, R¹⁰⁷ and R¹⁰⁸ are each independently hydrogen, a C₁-C₁₅ hydrocarbyl group, C₁-C₁₅ fluorinated hydrocarbyl group, or acid labile group,
   when R¹⁰³, R¹⁰⁶, R¹⁰⁷ and R¹⁰⁸ each are a hydrocarbyl or fluorinated hydrocarbyl group, an ether bond or carbonyl moiety may intervene in a carbon-carbon bond,
   R¹⁰⁹ is hydrogen or a C₁-C₅ straight or branched hydrocarbyl group in which a heteroatom-containing moiety may intervene in a carbon-carbon bond,
   R¹¹⁰ is hydrogen or a C₁-C₅ straight or branched hydrocarbyl group in which a heteroatom-containing moiety may intervene in a carbon-carbon bond,
   R¹¹¹ is a C₁-C₂₀ saturated hydrocarbyl group in which at least one hydrogen is substituted by fluorine, and in which some constituent -CH₂- may be replaced by an ester bond or ether bond,
   x is an integer of 1 to 3, y is an integer satisfying 0 ≤ y ≤ 5+2z-x, z is 0 or 1, k is an integer of 1 to 3,
   Z¹ is a C₁-C₂₀ (k+1)-valent hydrocarbon group or C₁-C₂₀ (k+1)-valent fluorinated hydrocarbon group,
   Z² is a single bond, *-C(=O)-O- or *-C(=O)-NH-, * designates a point of attachment to the carbon atom in the backbone,
   Z³ is a single bond, -O-, ^{∗}-C(=O)=O-Z³¹-Z³²- or ^{∗}-C(=O)-NH-Z³¹-Z³²-, Z³¹ is a single bond or C₁-C₁₀ saturated hydrocarbylene group, Z³² is a single bond, ester bond, ether bond, or sulfonamide bond, and * designates a point of attachment to the carbon atom in the backbone.
7. The positive resist composition of any one of 1 to 6, further comprising an organic solvent.
8. The positive resist composition of any one of 1 to 7 wherein the base polymer has a dissolution rate in alkaline developer of up to 5 nm/min.
9. The positive resist composition of any one of 1 to 8 which forms a resist film, the resist film in an unexposed region having a dissolution rate in alkaline developer of up to 10 nm/min.
10. The positive resist composition of any one of 1 to 9 which forms a resist film, the resist film in an exposed region having a dissolution rate in alkaline developer of at least 50 nm/sec.
11. A resist pattern forming process comprising the steps of:
   applying the chemically amplified positive resist composition of any one of 1 to 10 onto a substrate to form a resist film thereon,
   exposing the resist film to a pattern of EB, and
   developing the exposed resist film in an alkaline developer.
12. The process of 11 wherein the substrate has the outermost surface of a material containing at least one element selected from chromium, silicon, tantalum, molybdenum, cobalt, nickel, tungsten, and tin.
13. The process of 11 or 12 wherein the substrate is a mask blank of transmission or reflection type.
14. A mask blank of transmission or reflection type which is coated with the chemically amplified positive resist composition of any one of 1 to 10.

### ADVANTAGEOUS EFFECTS OF INVENTION

The chemically amplified positive resist composition can be processed to form a resist pattern of good profile with a high resolution, reduced LER, and improved rectangularity while controlling the influence of residue defects. It is thus suited as a resist composition for forming a resist film which is sensitive to EB and useful in the processing of semiconductor substrates and photomask blanks. The pattern forming process using the positive resist composition can form a resist pattern with a high resolution, reduced LER, etch resistance, and controlled influence of residue defects and is thus best suited in the micropatterning technology, typically EB lithography.

### DESCRIPTION OF EMBODIMENTS

As used herein, the singular forms "a," "an" and "the" include plural referents unless the context clearly dictates otherwise. "Optional" or "optionally" means that the subsequently described event or circumstances may or may not occur, and that description includes instances where the event or circumstance occurs and instances where it does not. The notation (Cn-Cm) means a group containing from n to m carbon atoms per group. The terms "group" and "moiety" are interchangeable. In chemical formulae, Me stands for methyl, Ac stands for acetyl, and the broken line designates a valence bond.

The abbreviations and acronyms have the following meaning.
EB: electron beam
EUV: extreme ultraviolet
Mw: weight average molecular weight
Mn: number average molecular weight
Mw/Mn: molecular weight distribution or dispersity
GPC: gel permeation chromatography
PEB: post-exposure bake
PAG: photoacid generator
LER: line edge roughness
CDU: critical dimension uniformity

It is understood that for some structures represented by chemical formulae, there can exist enantiomers and diastereomers because of the presence of asymmetric carbon atoms. In such a case, a single formula collectively represents all such isomers. The isomers may be used alone or in admixture.

### Positive resist composition

One embodiment of the invention is a chemically amplified positive resist composition adapted for EB lithography comprising (A) a base polymer, (B) a photoacid generator, and (C) a quencher.

### (A) Base polymer

Component (A) is a base polymer containing a polymer comprising phenolic hydroxy group-containing units having the formula (A1), referred to as repeat units A1, hereinafter.

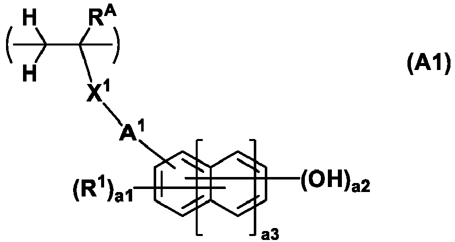

In formula (A1), a1 is an integer meeting 0 ≤ a1 ≤ 5+2a3-a2, a2 is an integer of 1 to 3, and a3 is an integer of 0 to 2.

In formula (A1), R^{A} is hydrogen, fluorine, methyl or trifluoromethyl.

In formula (A1), X¹ is a single bond, *-C(=O)-O- or *-C(=O)-NH-. The asterisk (*) designates a point of attachment to the carbon atom in the backbone.

In formula (A1), A¹ is a single bond or a C₁-C₁₀ saturated hydrocarbylene group in which some -CH₂- may be replaced by -O-. The saturated hydrocarbylene group may be straight, branched or cyclic and examples thereof include C₁-C₁₀ alkanediyl groups such as methylene, ethane-1,2-diyl, propane-1,3-diyl, butane-1,4-diyl, pentane-1,5-diyl, hexane-1,6-diyl, and structural isomers thereof; C₃-C₁₀ cyclic saturated hydrocarbylene groups such as cyclopropanediyl, cyclobutanediyl, cyclopentanediyl, and cyclohexanediyl; and combinations thereof.

In formula (A1), R¹ is halogen, optionally halogenated C₂-C₈ saturated hydrocarbylcarbonyloxy group, optionally halogenated C₁-C₆ saturated hydrocarbyl group or optionally halogenated C₁-C₆ saturated hydrocarbyloxy group. The saturated hydrocarbyl group and saturated hydrocarbyl moiety in the saturated hydrocarbylcarbonyloxy group and saturated hydrocarbyloxy group may be straight, branched or cyclic, and examples thereof include alkyl groups such as methyl, ethyl, n-propyl, isopropyl, butyl, pentyl, and hexyl, cycloalkyl groups such as cyclopropyl, cyclobutyl, cyclopentyl and cyclohexyl, and combinations thereof. A carbon count within the upper limit ensures good solubility in alkaline developer. A plurality of R¹ may be identical or different when a1 is 2 or more.

Preferred examples of the repeat unit A1 wherein both X¹ and A¹ are a single bond include units derived from 3-hydroxystyrene, 4-hydroxystyrene, 5-hydroxy-2-vinylnaphthalene, and 6-hydroxy-2-vinylnaphthalene. Of these, repeat units having the formula (A1-1) are more preferred. 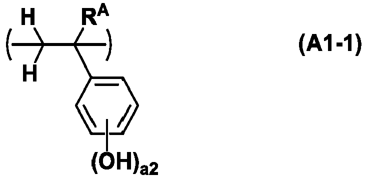 Herein R^{A} and a2 are as defined above.

Preferred examples of the repeat unit A1 wherein X¹ is other than a single bond are shown below, but not limited thereto. Herein R^{A} is as defined above.

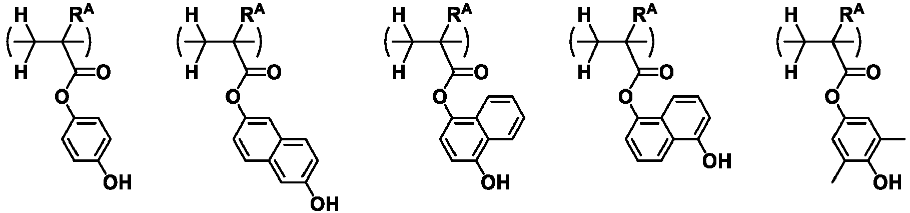

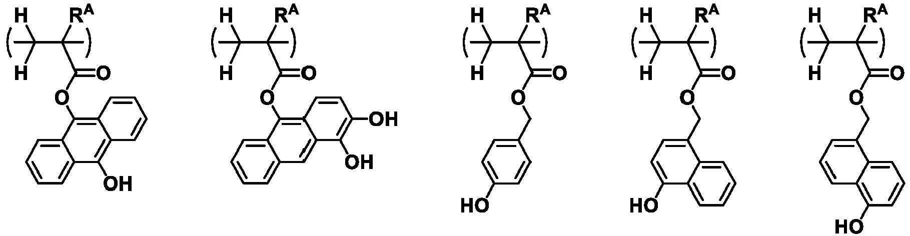

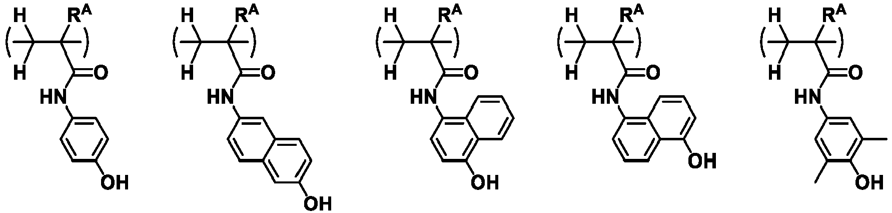

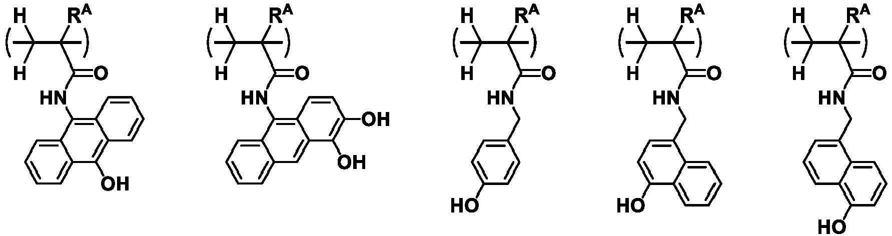

The repeat units A1 are preferably incorporated in a range of 30 to 90 mol%, more preferably 40 to 85 mol% based on the overall repeat units of the polymer in the base polymer. It is noted that when the polymer contains additional repeat units of at least one type selected from repeat units having formulae (A2) and (A3) contributing to high etching resistance, the additional repeat units having a phenolic hydroxy group as a substituent group, the sum of repeat units A1 and additional repeat units preferably falls in the above range. The repeat units A1 used herein may be of one type or a mixture of two or more types.

The polymer further comprises repeat units of at least one type selected from aromatic ring-containing units having the formula (A2), aromatic ring-containing units having the formula (A3), and aromatic ring-containing units having the formula (A4), which are referred to as repeat units A2, A3, and A4, hereinafter.

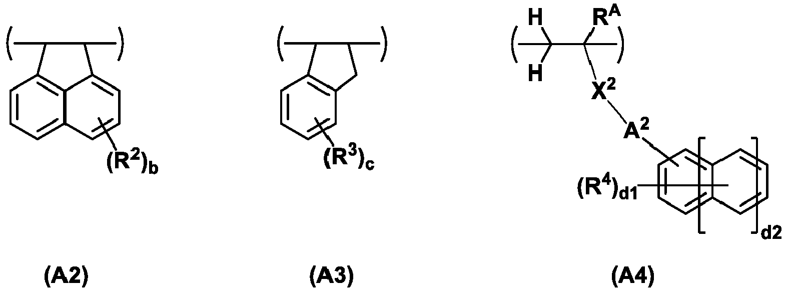

In formulae (A2) and (A3), b and c are each independently an integer of 0 to 4.

In formulae (A2) and (A3), R² and R³ are each independently hydroxy, halogen, optionally halogenated C₂-C₈ saturated hydrocarbylcarbonyloxy group, optionally halogenated C₁-C₈ saturated hydrocarbyl group or optionally halogenated C₁-C₈ saturated hydrocarbyloxy group. The saturated hydrocarbyl, saturated hydrocarbyloxy and saturated hydrocarbylcarbonyloxy groups may be straight, branched or cyclic. A plurality of R² may be identical or different when b is 2 or more. A plurality of R³ may be identical or different when c is 2 or more.

In formula (A4), R^{A} is as defined above, d1 is an integer of 0 to 5, and d2 is an integer of 0 to 2.

In formula (A4), R⁴ is an acetyl group, C₁-C₂₀ saturated hydrocarbyl group, C₁-C₂₀ saturated hydrocarbyloxy group, C₂-C₂₀ saturated hydrocarbylcarbonyloxy group, C₂-C₂₀ saturated hydrocarbyloxyhydrocarbyl group, C₂-C₂₀ saturated hydrocarbylthiohydrocarbyl group, halogen, nitro group, or cyano group. In case of d2=1 or 2, R⁴ may be hydroxy. The saturated hydrocarbyl, saturated hydrocarbyloxy, saturated hydrocarbylcarbonyloxy, saturated hydrocarbyloxyhydrocarbyl, and saturated hydrocarbylthiohydrocarbyl groups may be straight, branched or cyclic. A plurality of R⁴ may be identical or different when d1 is 2 or more.

In formula (A4), X² is a single bond, ^{∗}-C(=O)-O- or *-C(=O)-NH-. The asterisk (*) designates a point of attachment to the carbon atom in the backbone.

In formula (A4), A² is a single bond or a C₁-C₁₀ saturated hydrocarbylene group in which some constituent -CH₂- may be replaced by -O-. The saturated hydrocarbylene group may be straight, branched or cyclic and examples thereof are as exemplified above for A¹ in formula (A1).

When repeat units of at least one type selected from repeat units A2 to A4 are incorporated, better performance is obtained because not only the aromatic ring possesses etch resistance, but the cyclic structure incorporated into the main chain also exerts the effect of improving resistance to etching and EB irradiation during pattern inspection step.

The repeat units A2 to A4 are preferably incorporated in a range of at least 5 mol% based on the overall repeat units of the polymer in the base polymer for obtaining the effect of improving etch resistance. Also, the repeat units A2 to A4 are preferably incorporated in a range of up to 25 mol%, more preferably up to 20 mol% based on the overall repeat units of the polymer in the base polymer. When the relevant units are free of functional groups or have a functional group other than hydroxy, their content of up to 25 mol% is preferred because the risk of forming development defects is eliminated. Each of the repeat units A2 to A4 may be of one type or a combination of plural types.

The total content of repeat units A1 and repeat units of at least one type selected from repeat units A2 to A4 is preferably at least 50 mol%, more preferably at least 60 mol% based on the overall repeat units of the polymer in the base polymer.

The polymer further comprises units containing a phenolic hydroxy group protected with an acid labile group, having the formula (A5), which are referred to as repeat units A5, hereinafter.

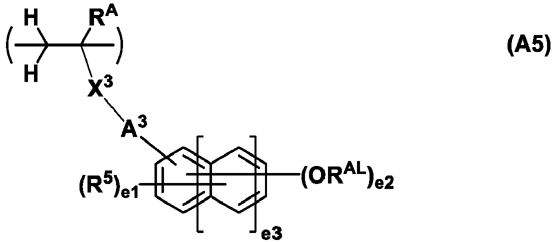

In formula (A5), R^{A} is as defined above, e1 is an integer meeting 0 ≤ e1 ≤ 5+2e3-e2, e2 is an integer of 1 to 3, and e3 is an integer of 0 to 2.

In formula (A5), X³ is a single bond, *-C(=O)-O- or *-C(=O)-NH-, * designates a point of attachment to the carbon atom in the backbone.

In formula (A5), A³ is a single bond or a C₁-C₁₀ saturated hydrocarbylene group in which some -CH₂- may be replaced by -O-. The saturated hydrocarbylene group may be straight, branched or cyclic and examples thereof are as exemplified above for A¹ in formula (A1).

In formula (A5), R⁵ is halogen, optionally halogenated C₂-C₈ saturated hydrocarbylcarbonyloxy group, optionally halogenated C₁-C₆ saturated hydrocarbyl group or optionally halogenated C₁-C₆ saturated hydrocarbyloxy group. The saturated hydrocarbyl group and saturated hydrocarbyl moiety in the saturated hydrocarbylcarbonyloxy and saturated hydrocarbyloxy groups may be straight, branched or cyclic and examples thereof are as exemplified above for R¹ in formula (A1). A carbon count within the upper limit ensures a high solubility in alkaline developer. A plurality of R⁵ may be identical or different when e1 is 2 or more.

In formula (A5), when e2=1, R^{AL} is an acetal type acid labile group having the formula (A5-1); when e2 is 2 or more, R^{AL} is hydrogen or an acetal type acid labile group having formula (A5-1), at least one R^{AL} being an acetal type acid labile group having formula (A5-1).

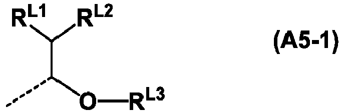

In formula (A5-1), R^{L1} and R^{L2} are each independently a C₁-C₃ saturated hydrocarbyl group, R^{L1} and R^{L2} may bond together to form a ring with the carbon atom to which they are attached. R^{L3} is a C₁-C₅ hydrocarbyl group. The broken line designates a point of attachment.

R^{L1} and R^{L2} are selected in accordance with how to design the sensitivity of the labile group to acid. For example, a straight alkyl group is selected for the design that utilizes a relatively high reactivity to provide a high sensitivity relative to pH changes and to control residue defects. Illustrative examples of R^{L1} and R^{L2} include methyl, ethyl, n-propyl and isopropyl. Of these, methyl is preferred because an optimum acid elimination ability is available. When R^{L1} and R^{L2} bond together to form a ring with the carbon atom to which they are attached, suitable rings include cyclopentane and cyclohexane.

In the acetal structure, it is preferred from the aspects of the polymer's stability and reactivity with acid that the carbon atom to which R^{L1} and R^{L2} are attached be a secondary carbon atom. When the carbon atom to which R^{L1} and R^{L2} are attached is a primary carbon atom, the polymer has too high a reactivity and hence, poor stability. When the carbon atom to which R^{L1} and R^{L2} are attached is a tertiary carbon atom, the polymer has a poor reactivity and hence, low reaction contrast.

Of the acetal type acid labile groups, it is preferred from the aspect of gaining a higher resolution that R^{L3} be selected from methyl, ethyl, n-propyl, isopropyl, n-butyl, isobutyl, sec-butyl, tert-butyl, n-pentyl, isopentyl, and cyclopentyl, more preferably from methyl, ethyl, n-propyl, isopropyl, tert-butyl, and cyclopentyl. If the carbon count is 6 or more, the alcohol component as eliminated becomes less soluble in alkaline developer under the influence of bulkiness of the acid eliminating group, the degradation of isolated-space resolution and residual components after development become outstanding, which is detrimental to the processing of photomasks in the lithography of the sub-10 nm node generation.

Known methods of protecting a polymer after polymerization with an acetal type acid labile group include a method using a vinyl ether and an acid catalyst, a method using an acetalizing agent having a haloalkoxy group along with a base, and the like. Any of these methods may be used herein.

For example, in the former method using a vinyl ether and an acid catalyst, suitable acid catalysts include methanesulfonic acid, trifluoroacetic acid, oxalic acid, and methanesulfonic acid pyridine salt. The reaction is preferably carried out at a temperature of 5°C to 30°C for a time of 0.2 to 10 hours, more preferably 0.5 to 6 hours.

In the latter method using an acetalizing agent having a haloalkoxy group along with a base, the acetalizing agent having a haloalkoxy group is added dropwise in the presence of a basic compound such as triethylamine. The reaction is preferably carried out at a temperature of -20°C to 50°C for a time of 0.2 to 10 hours, more preferably 0.5 to 6 hours.

It is noted that in the latter method using an acetalizing agent having a haloalkoxy group along with a base, a corrosive strong acid, typically hydrochloric acid is released, which causes corrosion of kettles and conduits of metal material. There is a risk that semiconductor products are contaminated with metal components which cause defects. Since starting ingredients for the resist composition used in the lithography of advanced generation are required to clear a metal impurity content of up to 10 ppb, the former method using a vinyl ether and an acid catalyst is preferred.

The repeat units protected with an acetal type acid labile group are preferably incorporated in a range of 10 to 40 mol%, more preferably 10 to 35 mol%, even more preferably 20 to 30 mol% based on the overall repeat units of the polymer in the base polymer.

In addition to the polymer having an acetal type acid labile group, the base polymer may contain a polymer having any of well-known acid labile groups other than the acetal type acid labile group having formula (A5-1), such as tertiary alkyl groups or tert-butoxycarbonyl groups. The polymer having an acid labile group other than the acetal type acid labile group having formula (A5-1) preferably comprises repeat units having an acid labile group other than the acetal type acid labile group having formula (A5-1) and repeat units A1 and optionally, any of repeat units A2 to A4. Preferably the polymer having an acetal type acid labile group accounts for at least 30% by weight of the base polymer in order that the chemically amplified positive resist composition comprising the base polymer exert the desired effect.

Since the acetal type acid labile group is also effective for controlling the influence of backward scattering during EB image writing, a pattern of rectangular profile is obtained without the risk of the pattern profile being inversely tapered in a sensitivity region of at least 50 µC/cm², preferably at least 80 µC/cm², more preferably at least 100 µC/cm².

The polymer should preferably have a Mw of 1,000 to 20,000, and more preferably 3,000 to 9,000. A Mw of at least 1,000 eliminates the risk that pattern features are rounded at their top, inviting degradations of resolution and LER. A Mw of up to 20,000 eliminates the risk that LER is degraded when a pattern with a line width of up to 100 nm is formed. As used herein, Mw is measured by GPC versus polystyrene standards using tetrahydrofuran (THF) or dimethylformamide (DMF) solvent.

The polymer preferably has a narrow molecular weight distribution or dispersity (Mw/Mn) of 1.0 to 2.0, more preferably 1.0 to 1.9, even more preferably 1.0 to 1.8. A polymer with such a narrow dispersity eliminates the risk that foreign particles are left on the pattern after development and the pattern profile is aggravated.

The base polymer is designed such that the dissolution rate in alkaline developer is preferably up to 10 nm/min, more preferably up to 7 nm/min, even more preferably up to 5 nm/min. In the advanced generation of lithography wherein the coating film on the substrate is in a thin film range of up to 100 nm, the influence of pattern film thickness loss during alkaline development becomes strong. When the polymer has an alkaline dissolution rate of greater than 10 nm/min, pattern collapse occurs, i.e., a small size pattern cannot be formed. The problem becomes outstanding in the fabrication of photomasks requiring to be defectless and having a tendency of strong development process. It is noted that the dissolution rate of a base polymer in alkaline developer is computed by spin coating a 16.7 wt% solution of a polymer in propylene glycol monomethyl ether acetate (PGMEA) solvent onto a 8-inch silicon wafer, baking at 100°C for 90 seconds to form a film of 1,000 nm thick, developing the film in a 2.38 wt% aqueous solution of tetramethylammonium hydroxide (TMAH) at 23°C for 100 seconds, and measuring a loss of film thickness.

### (B) Photoacid generator

The positive resist composition further comprises a photoacid generator (PAG) as component (B). The PAG used herein may be any compound capable of generating an acid upon exposure to high-energy radiation. Suitable PAGs include sulfonium salts, iodonium salts, sulfonyldiazomethane, N-sulfonyloxyimide, and oxime-O-sulfonate acid generators.

Suitable PAGs include nonafluorobutane sulfonate, partially fluorinated sulfonates described in JP-A 2012-189977, paragraphs [0247]-[0251], partially fluorinated sulfonates described in JP-A 2013-101271, paragraphs [0261]-[0265], and those described in JP-A 2008-111103, paragraphs [0122]-[0142] and JP-A 2010-215608, paragraphs [0080]-[0081]. Among others, arylsulfonate and alkanesulfonate type PAGs are preferred because they generate acids having an appropriate strength to deprotect the acid labile group in the repeat units having formula (A5).

The preferred PAGs are salt compounds having a sulfonium anion of the structure shown below.

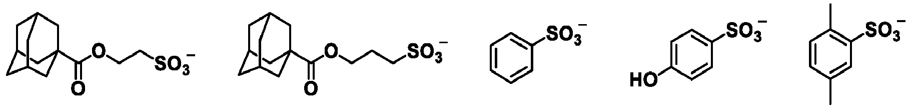

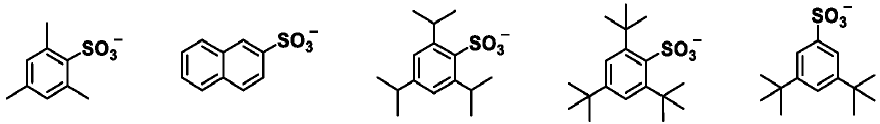

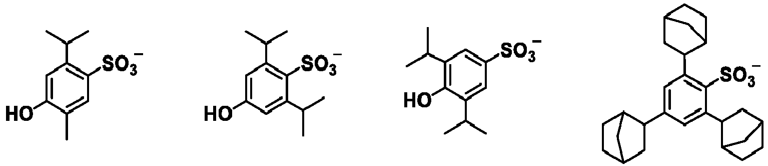

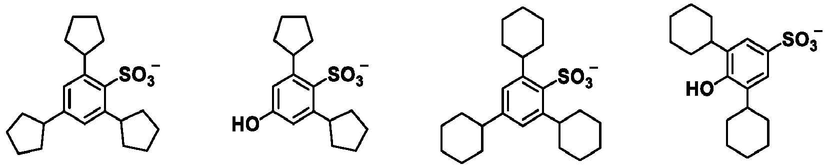

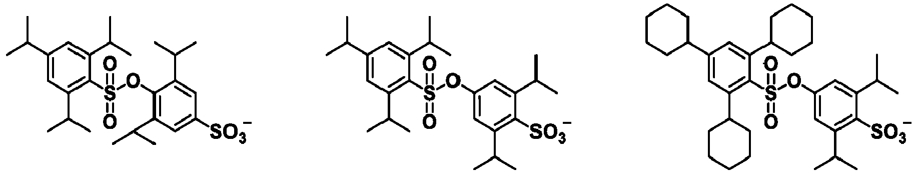

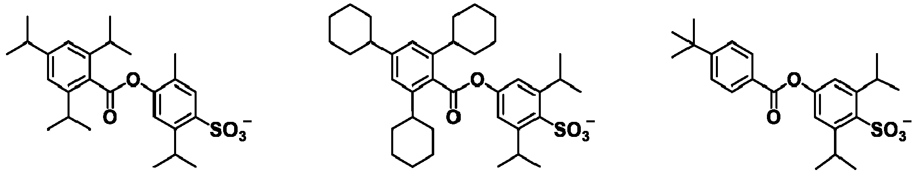

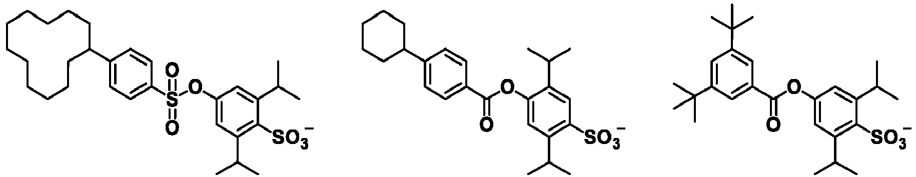

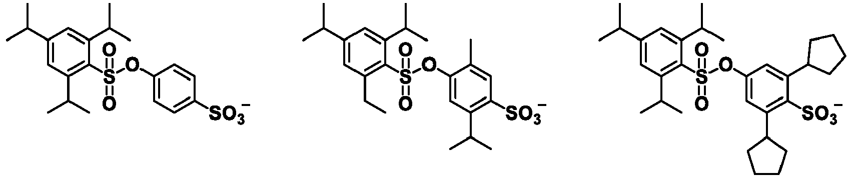

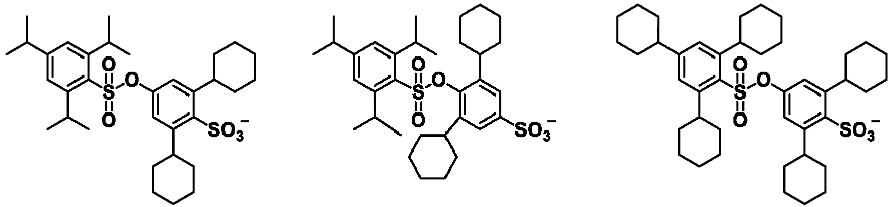

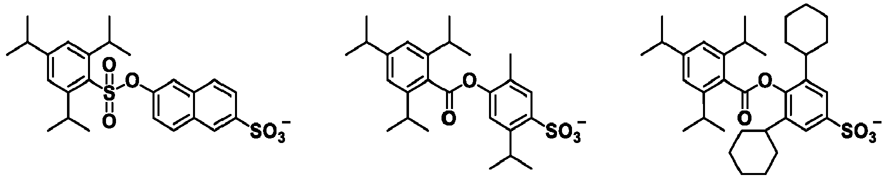

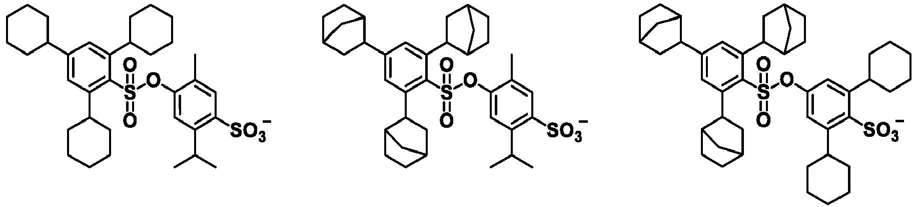

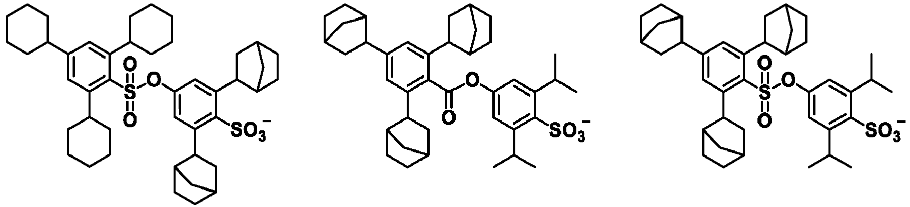

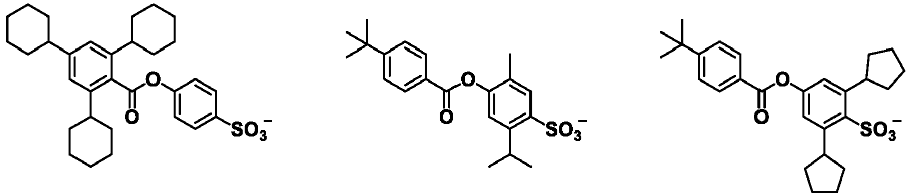

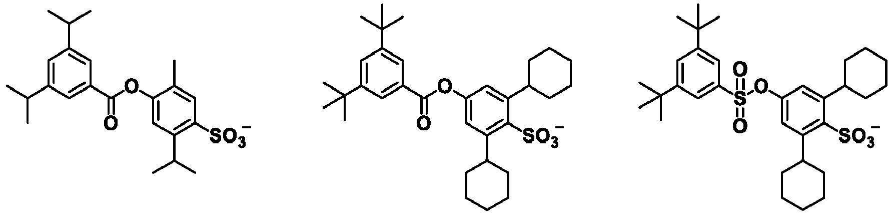

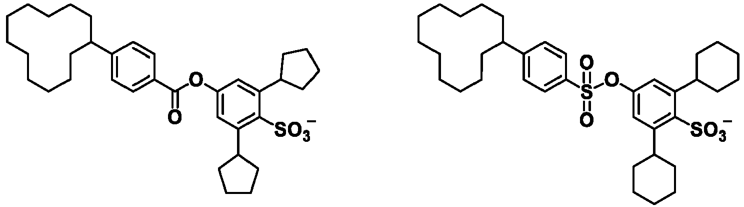

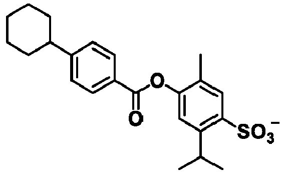

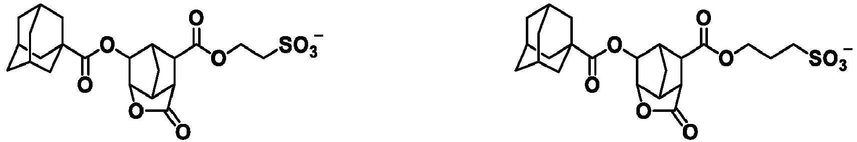

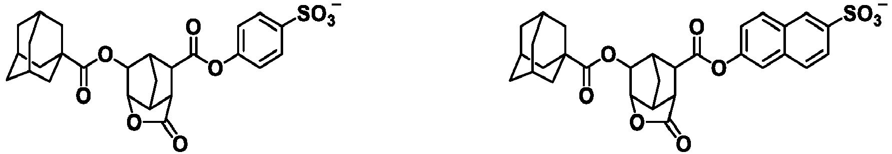

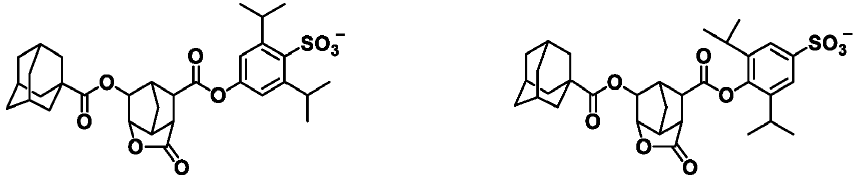

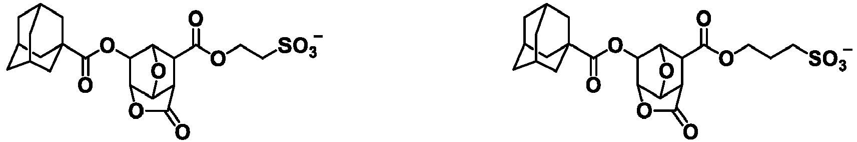

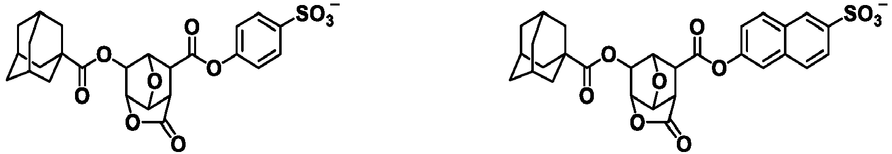

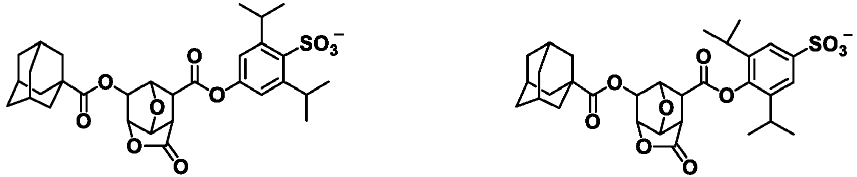

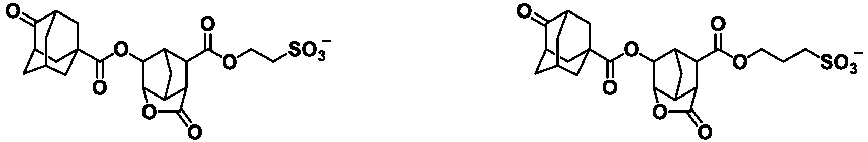

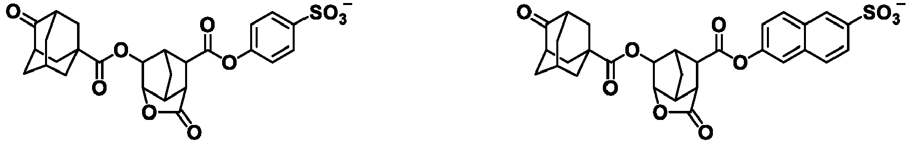

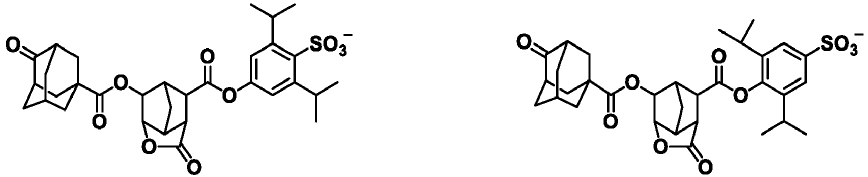

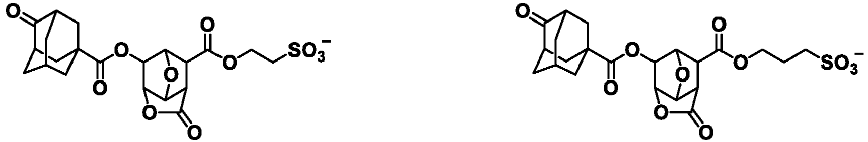

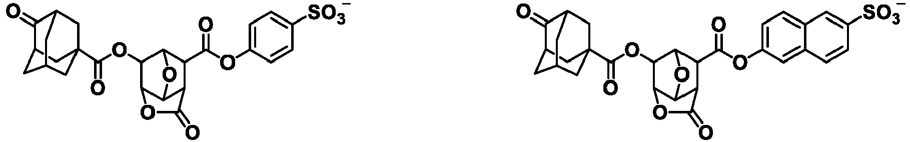

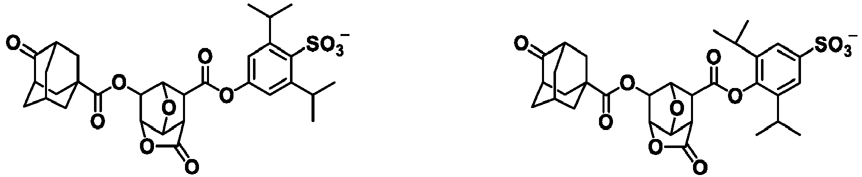

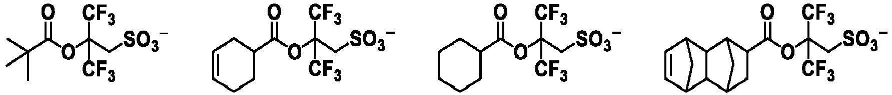

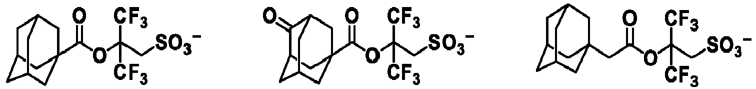

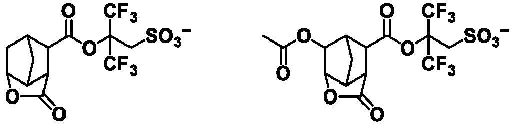

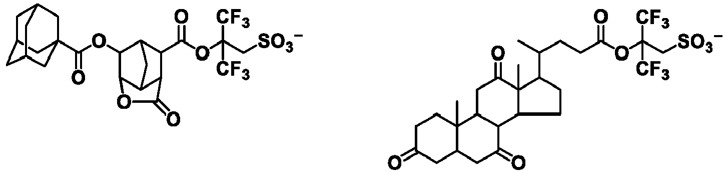

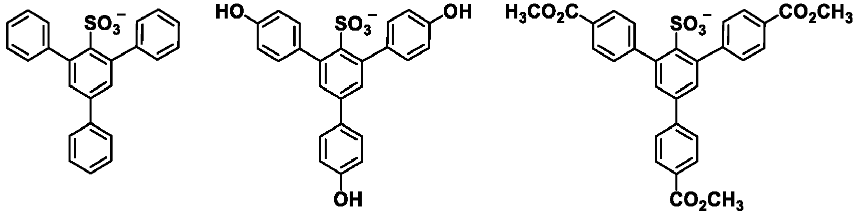

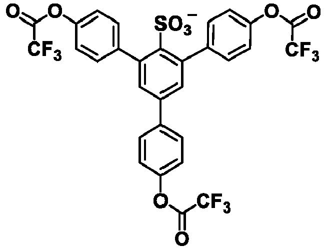

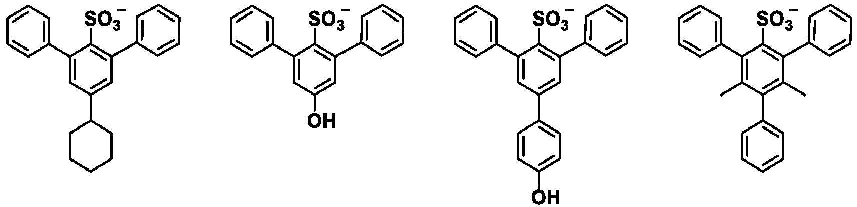

The preferred PAG (B) is a salt compound containing an anion having the formula (B-1).

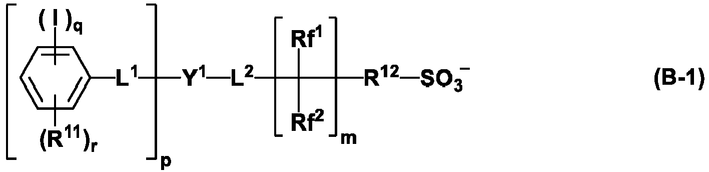

In formula (B-1), m is 0 or 1, p is an integer of 1 to 3, q is an integer of 1 to 5, and r is an integer of 0 to 3.

In formula (B-1), L¹ is a single bond, ether bond, ester bond, sulfonic ester bond, carbonate bond or carbamate bond.

In formula (B-1), L² is an ether bond, ester bond, sulfonic ester bond, carbonate bond or carbamate bond.

In formula (B-1), when p is 1, Y¹ is a single bond or a C₁-C₂₀ hydrocarbylene group. When p is 2 or 3, Y¹ is a C₁-C₂₀ (p+1)-valent hydrocarbon group. The hydrocarbylene group and (p+1)-valent hydrocarbon group may contain at least one moiety selected from ether bond, carbonyl moiety, ester bond, amide bond, sultone ring, lactam ring, carbonate bond, halogen, hydroxy moiety and carboxy moiety.

The C₁-C₂₀ hydrocarbylene group Y¹ may be saturated or unsaturated and straight, branched or cyclic. Examples thereof include C₁-C₂₀ alkanediyl groups such as methanediyl, ethane-1,1-diyl, ethane-1,2-diyl, propane-1,3-diyl, butane-1,4-diyl, pentane-1,5-diyl, hexane-1,6-diyl, heptane-1,7-diyl, octane-1,8-diyl, nonane-1,9-diyl, decane-1,10-diyl, undecane-1,11-diyl, dodecane-1,12-diyl; C₃-C₂₀ cyclic saturated hydrocarbylene groups such as cyclopentanediyl, cyclohexanediyl, norbornanediyl and adamantanediyl; C₂-C₂₀ unsaturated aliphatic hydrocarbylene groups such as vinylene and propene-1,3-diyl; C₆-C₂₀ arylene groups such as phenylene and naphthylene; and combinations thereof. The (p+1)-valent hydrocarbon group Y¹ may be saturated or unsaturated and straight, branched or cyclic. Examples thereof include those exemplified above for the C₁-C₂₀ hydrocarbylene group, with one or two hydrogen atoms being eliminated.

In formula (B-1), Rf¹ and Rf² are each independently hydrogen, fluorine or trifluoromethyl, at least one being fluorine or trifluoromethyl.

In formula (B-1), R¹¹ is hydroxy, carboxy, a C₁-C₆ saturated hydrocarbyl group, C₁-C₆ saturated hydrocarbyloxy group, C₂-C₆ saturated hydrocarbylcarbonyloxy group, fluorine, chlorine, bromine, amino, -N(R^{11A})-C(=O)-R^{11B} or -N(R^{11A})-C(=O)-O-R^{11B}. R^{11A} is hydrogen or a C₁-C₆ saturated hydrocarbyl group. R^{11B} is a C₁-C₆ saturated hydrocarbyl group or C₂-C₈ unsaturated aliphatic hydrocarbyl group.

The C₁-C₆ saturated hydrocarbyl group represented by R¹¹, R^{11A} and R^{11B} may be straight, branched or cyclic. Examples thereof include C₁-C₆ alkyl groups such as methyl, ethyl, n-propyl, isopropyl, n-butyl, isobutyl, sec-butyl, tert-butyl, n-pentyl, and n-hexyl; and C₃-C₆ cyclic saturated hydrocarbyl groups such as cyclopropyl, cyclobutyl, cyclopentyl, and cyclohexyl. Examples of the saturated hydrocarbyl moiety in the C₁-C₆ saturated hydrocarbyloxy group represented by R¹¹ are as exemplified above for the saturated hydrocarbyl group. Examples of the saturated hydrocarbyl moiety in the C₂-C₆ saturated hydrocarbylcarbonyloxy group represented by R¹¹ are as exemplified above for the C₁-C₆ saturated hydrocarbyl group, but of 1 to 5 carbon atoms.

The C₂-C₈ unsaturated aliphatic hydrocarbyl group represented by R^{11B} may be straight, branched or cyclic and examples thereof include C₂-C₈ alkenyl groups such as vinyl, propenyl, butenyl, and hexenyl; C₂-C₈ alkynyl groups such as ethynyl, propynyl, and butynyl; and C₃-C₈ cyclic unsaturated hydrocarbyl groups such as cyclohexenyl and norbornenyl.

In formula (B-1), R¹² is a C₁-C₂₀ saturated hydrocarbylene group or C₆-C₁₄ arylene group. Some or all of the hydrogen atoms in the saturated hydrocarbylene group may be substituted by halogen other than fluorine. Some or all of the hydrogen atoms in the arylene group may be substituted by a substituent selected from C₁-C₂₀ saturated hydrocarbyl groups, C₁-C₂₀ saturated hydrocarbyloxy groups, C₆-C₁₄ aryl groups, halogen, and hydroxy.

The C₁-C₂₀ saturated hydrocarbylene group represented by R¹² may be straight, branched or cyclic. Examples thereof include C₁-C₂₀ alkanediyl groups such as methanediyl, ethane-1,1-diyl, ethane-1,2-diyl, propane-1,3-diyl, butane-1,4-diyl, pentane-1,5-diyl, hexane-1,6-diyl, heptane-1,7-diyl, octane-1,8-diyl, nonane-1,9-diyl, decane-1,10-diyl, undecane-1,11-diyl, and dodecane-1,12-diyl; C₃-C₂₀ cyclic saturated hydrocarbylene groups such as cyclopentanediyl, cyclohexanediyl, norbornanediyl and adamantanediyl; and combinations thereof.

Examples of the C₆-C₁₄ arylene group represented by R¹² include phenylene, naphthylene, phenanthrenediyl, and anthracenediyl. The C₁-C₂₀ saturated hydrocarbyl moiety and hydrocarbyl moiety in the C₁-C₂₀ hydrocarbyloxy moiety, which are substituents on the arylene group, may be straight, branched or cyclic and examples thereof include C₁-C₂₀ alkyl groups such as methyl, ethyl, n-propyl, isopropyl, n-butyl, isobutyl, sec-butyl, tert-butyl, n-pentyl, n-hexyl, n-octyl, n-nonyl, n-decyl, undecyl, dodecyl, tridecyl, tetradecyl, pentadecyl, heptadecyl, octadecyl, nonadecyl, and icosyl; and C₃-C₂₀ cyclic saturated hydrocarbyl groups such as cyclopropyl, cyclopentyl, cyclohexyl, cyclopropylmethyl, 4-methylcyclohexyl, cyclohexylmethyl, norbornyl and adamantyl. Examples of the C₆-C₁₄ arylene moiety which is a substituent on the arylene group include phenylene, naphthylene, phenanthrenediyl and anthracenediyl.

More preferably, the anion has the formula (B-2).

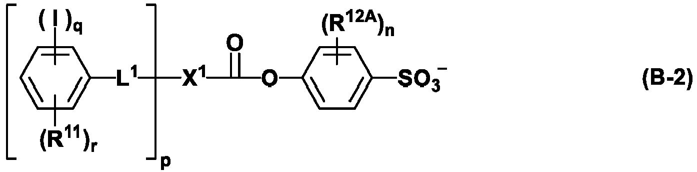

In formula (B-2), p, q, r, L¹, Y¹ and R¹¹ are as defined above. The subscript n is an integer of 1 to 4. R^{12A} is a C₁-C₂₀ saturated hydrocarbyl group, C₁-C₂₀ saturated hydrocarbyloxy group, C₆-C₁₄ aryl group, halogen or hydroxy group. When n is 2, 3 or 4, a plurality of R^{12A} may be identical or different.

Examples of the anion having formula (B-1) are shown below, but not limited thereto.

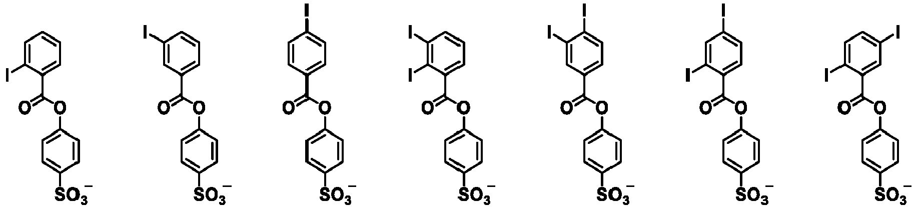

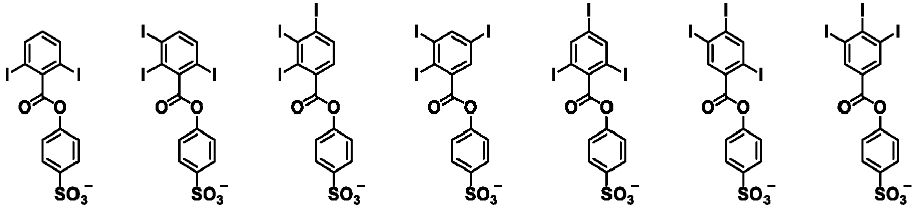

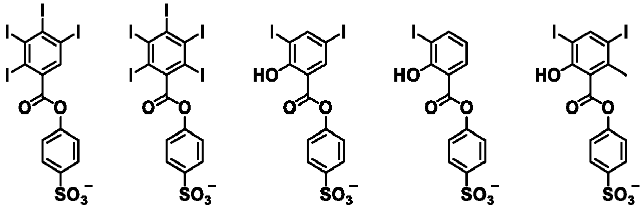

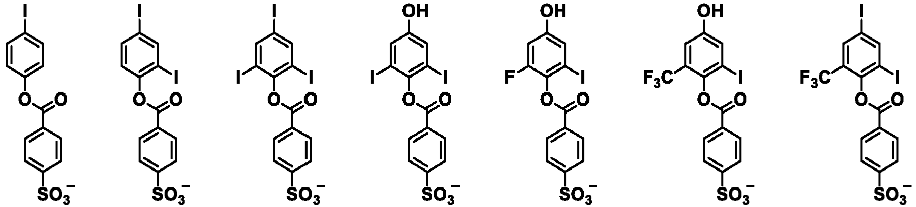

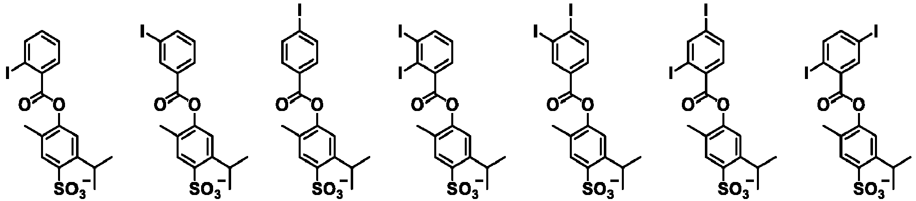

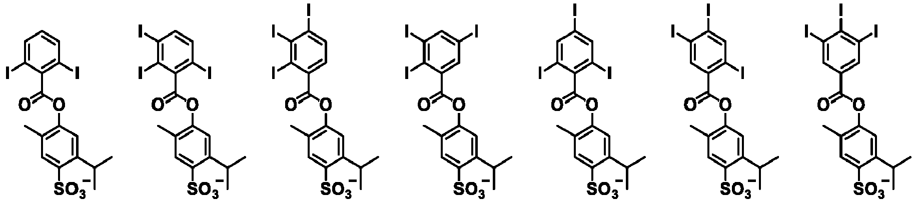

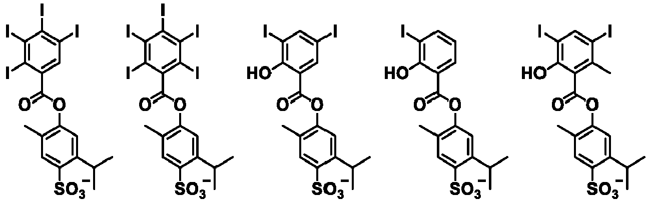

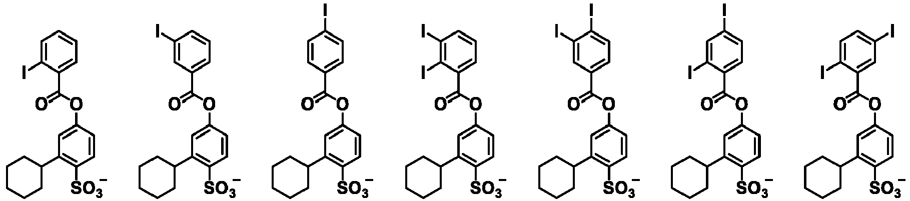

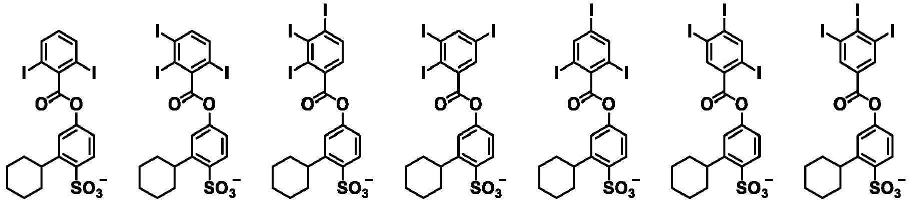

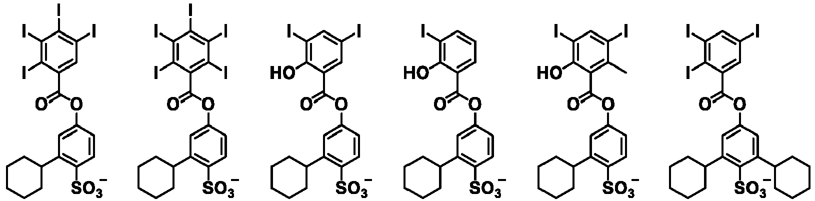

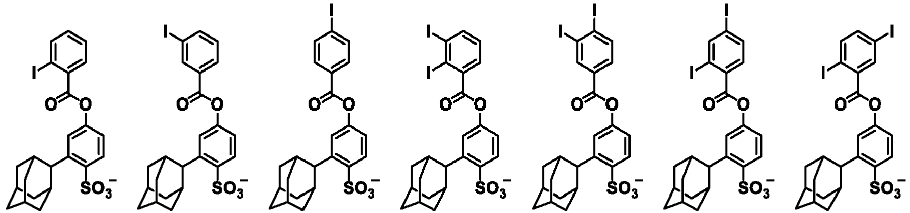

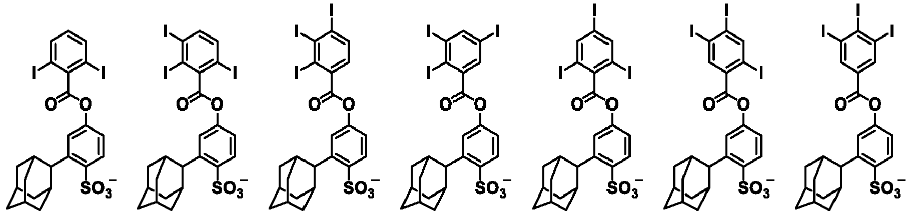

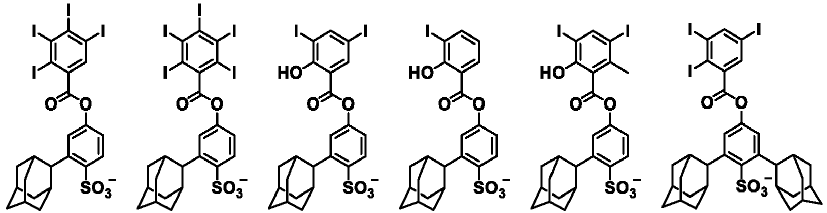

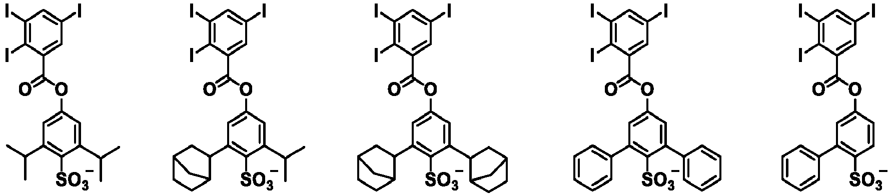

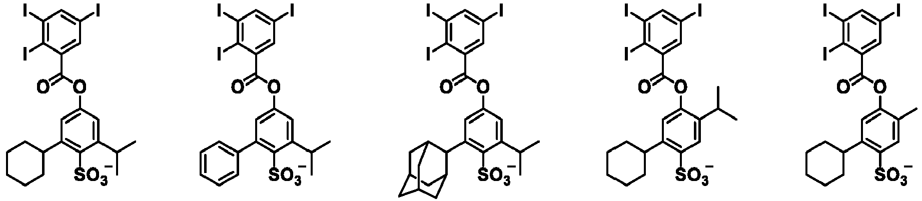

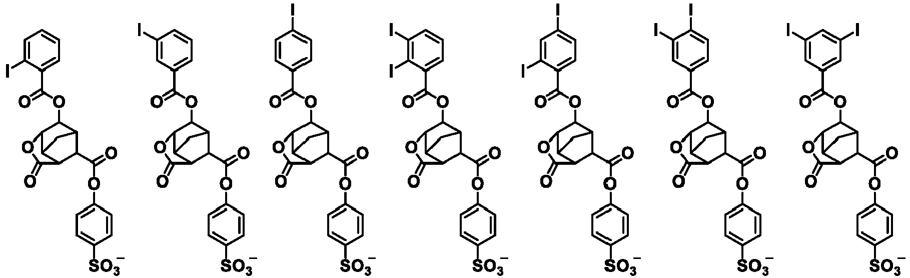

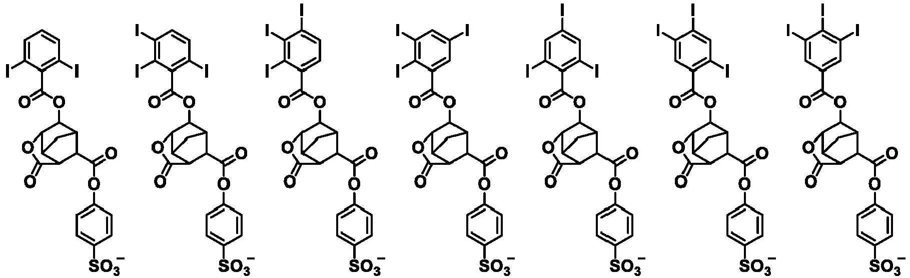

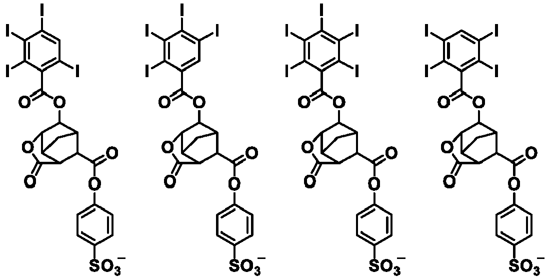

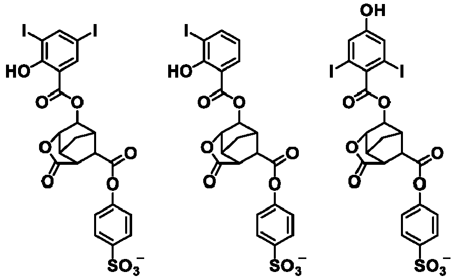

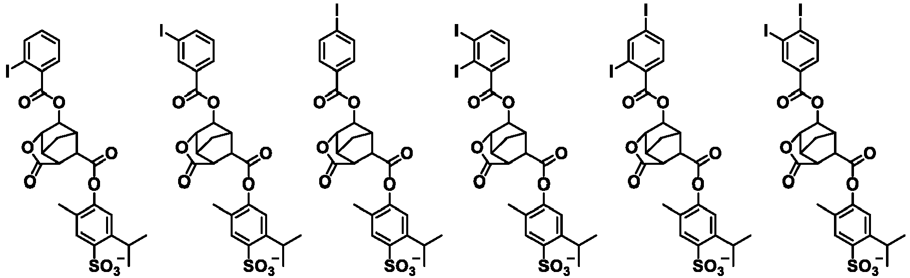

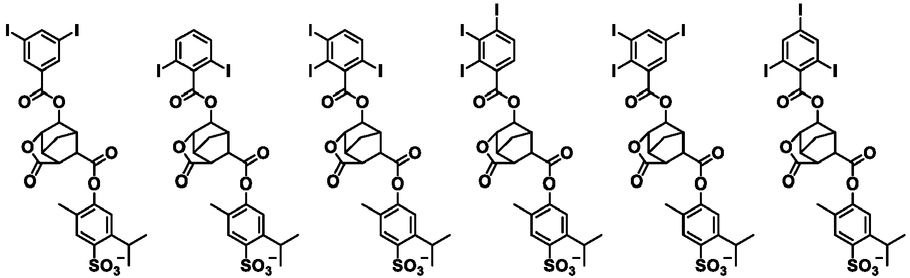

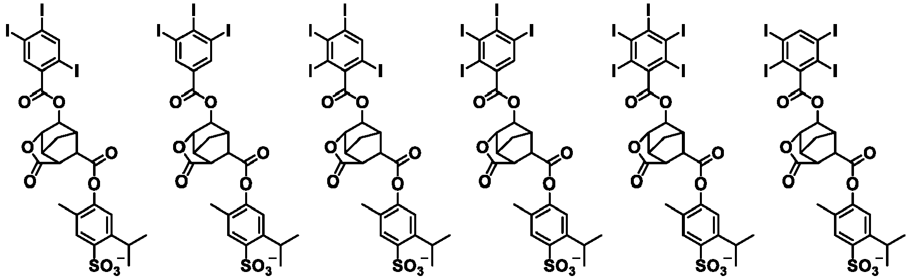

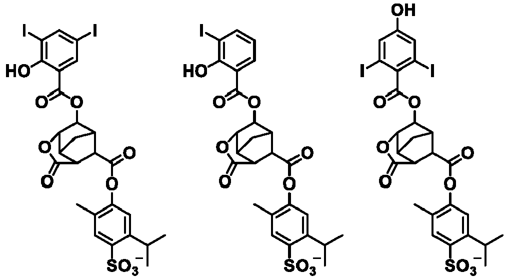

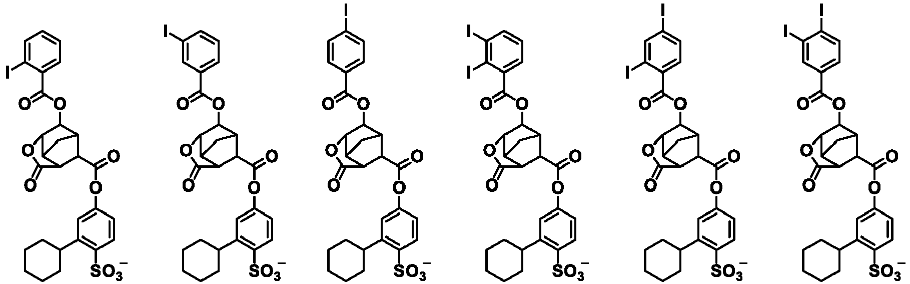

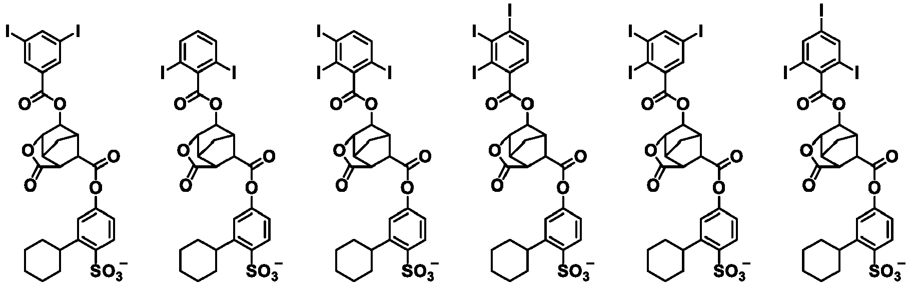

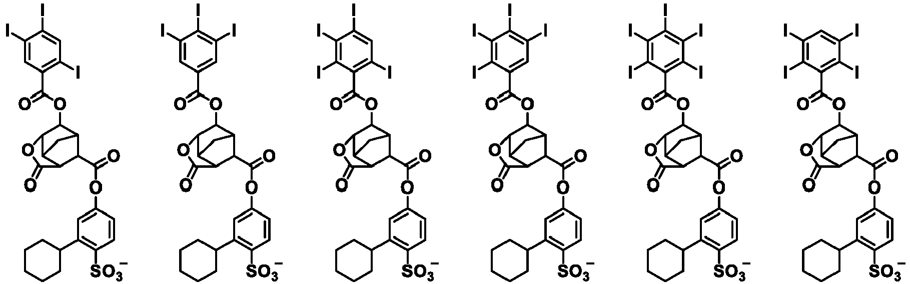

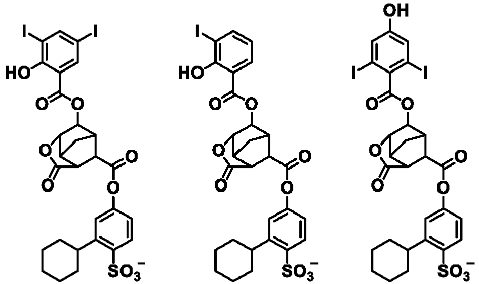

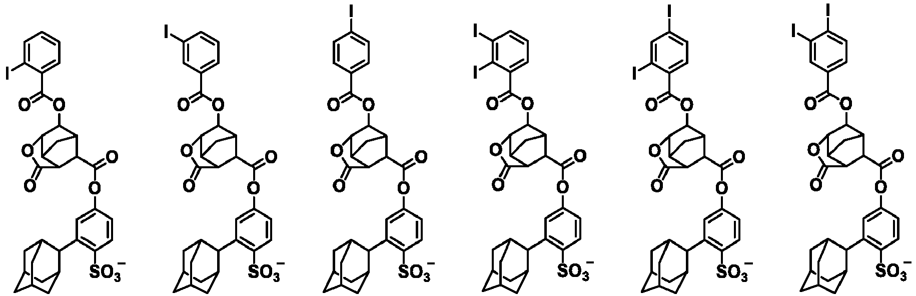

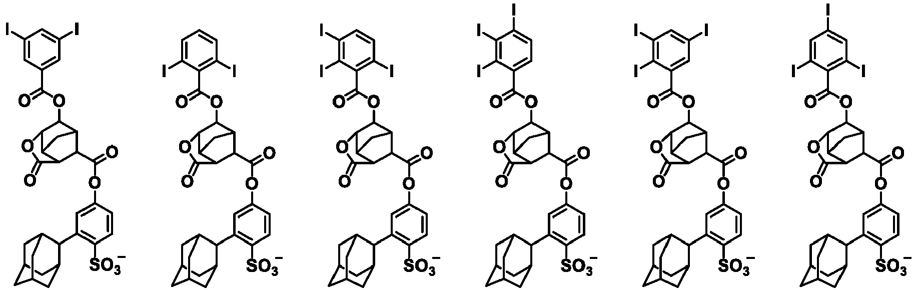

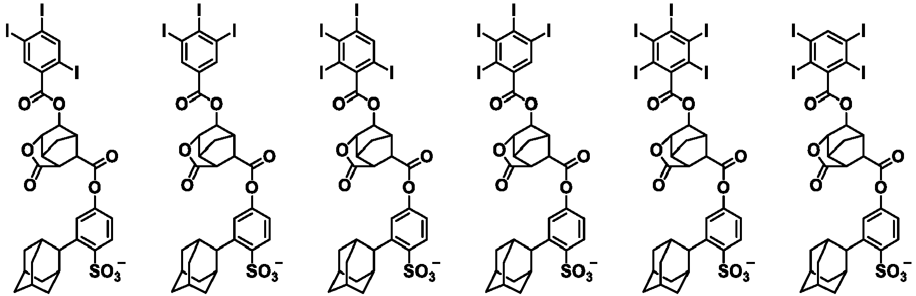

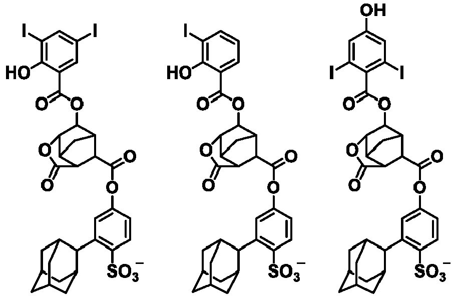

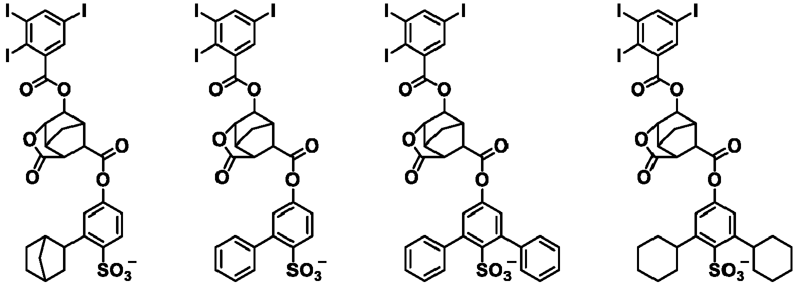

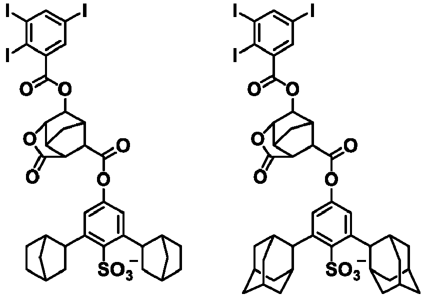

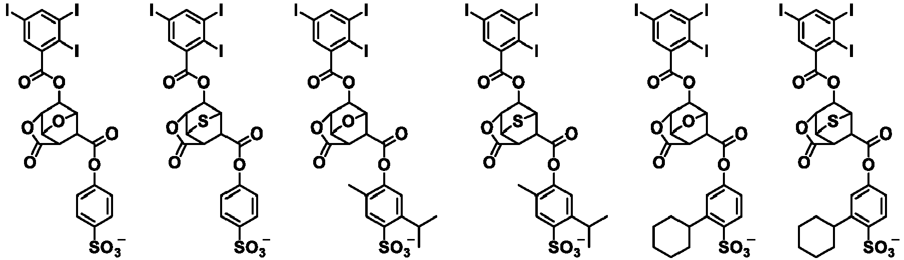

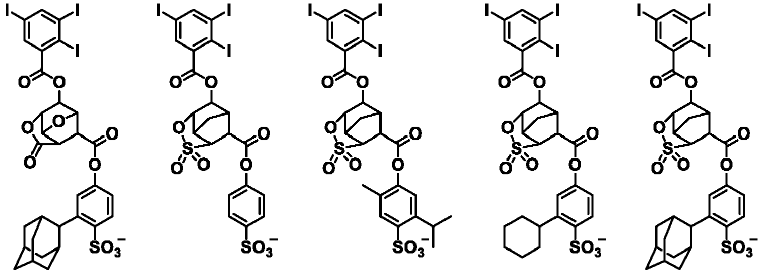

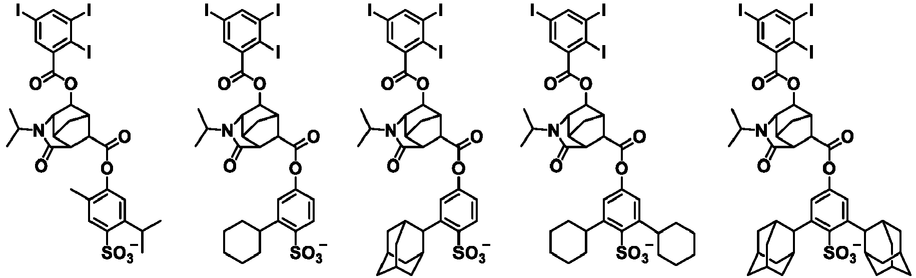

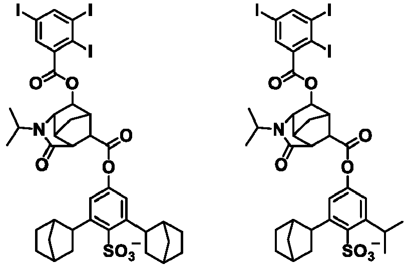

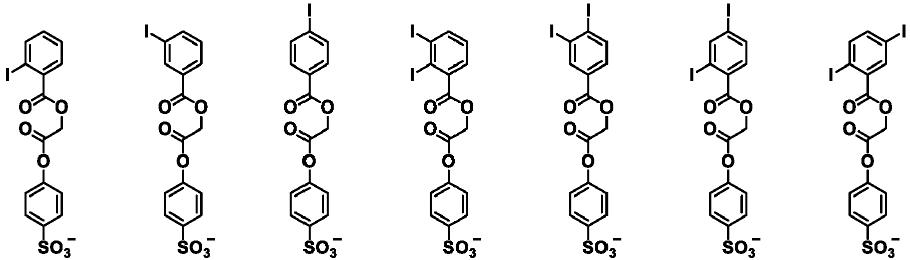

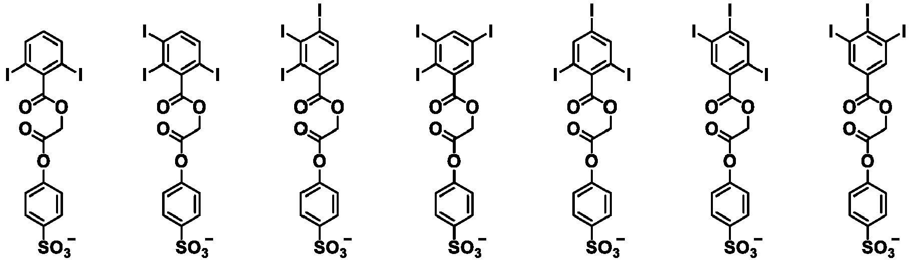

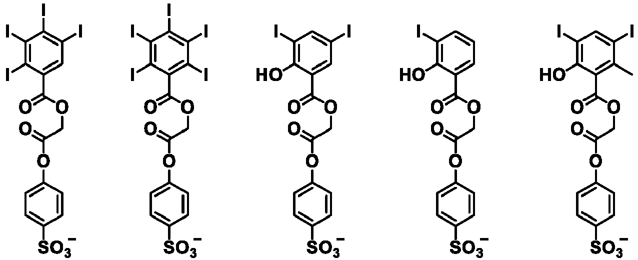

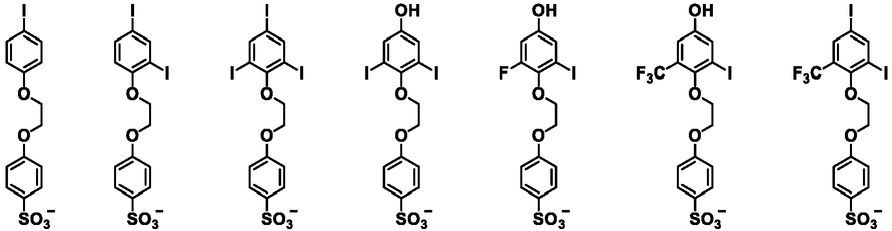

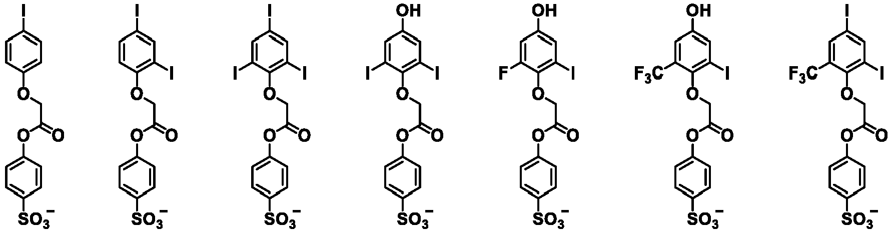

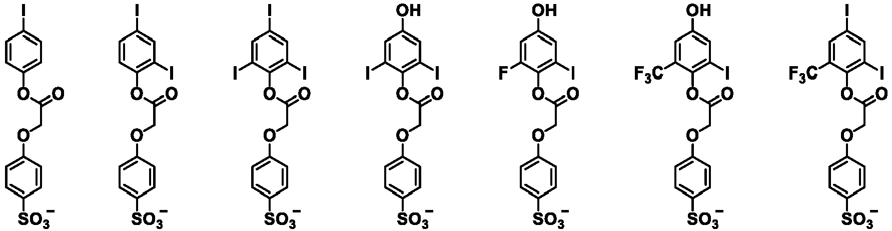

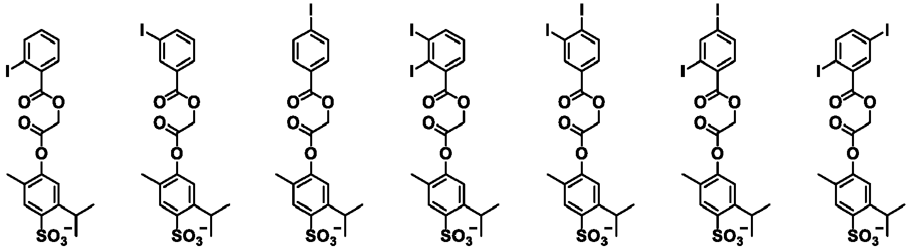

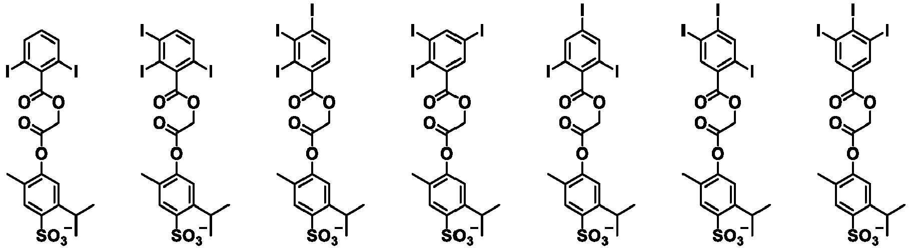

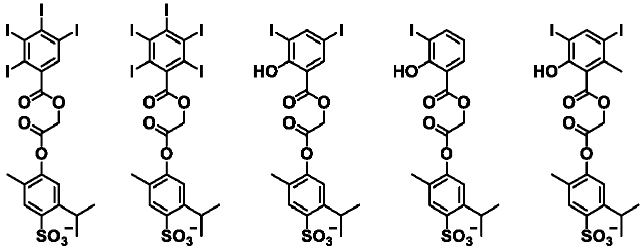

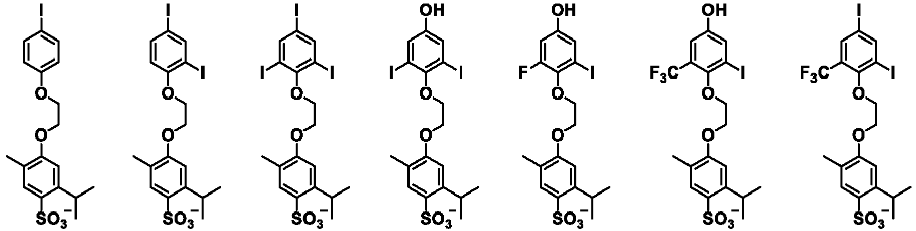

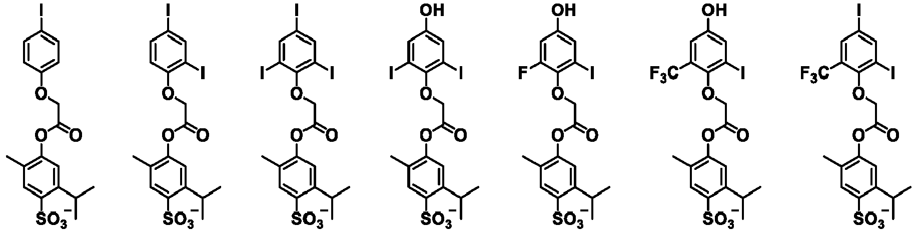

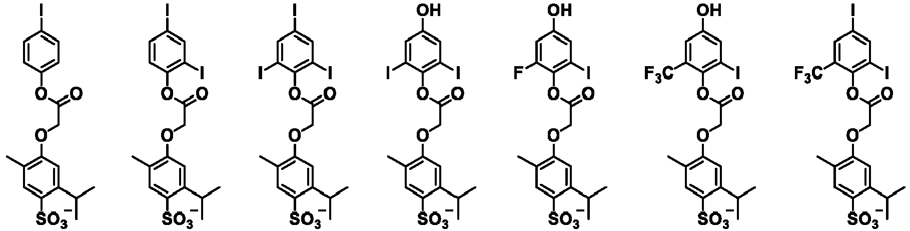

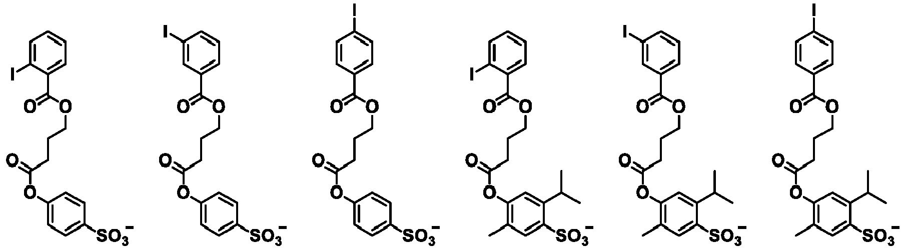

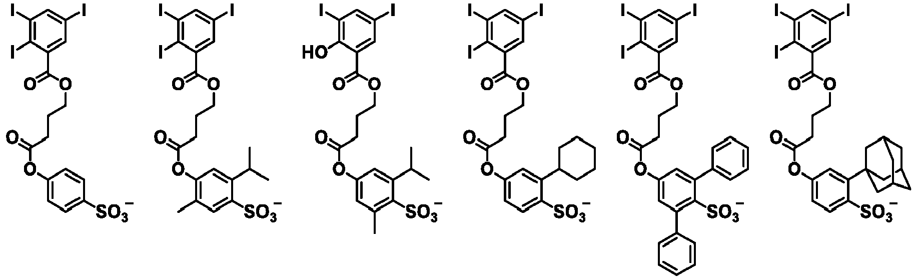

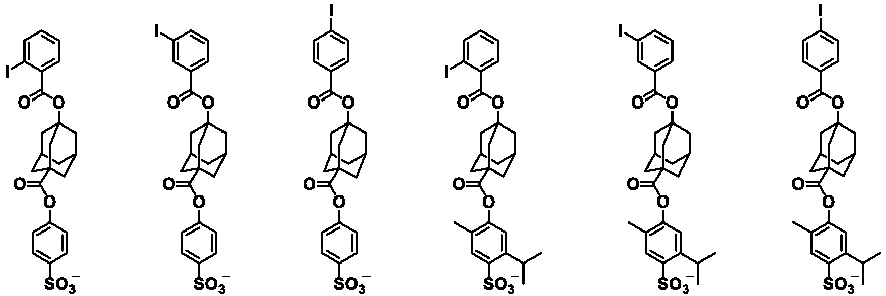

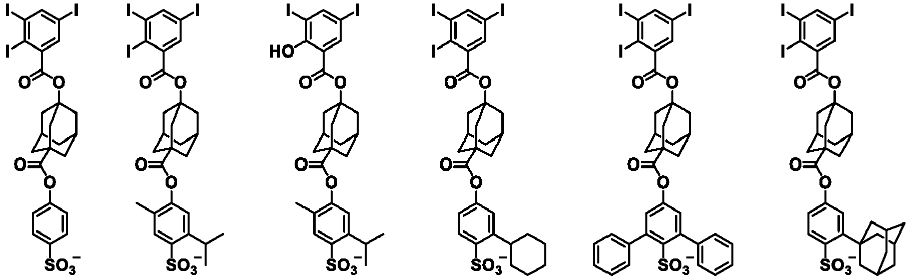

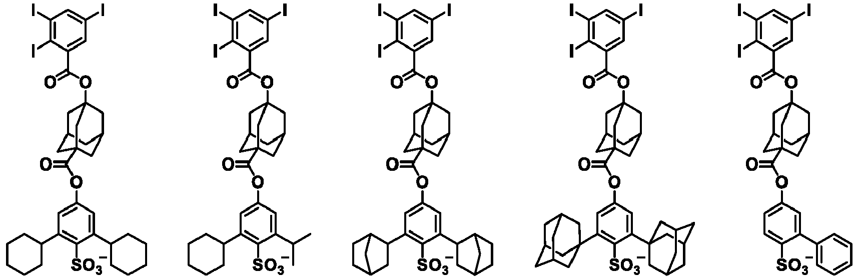

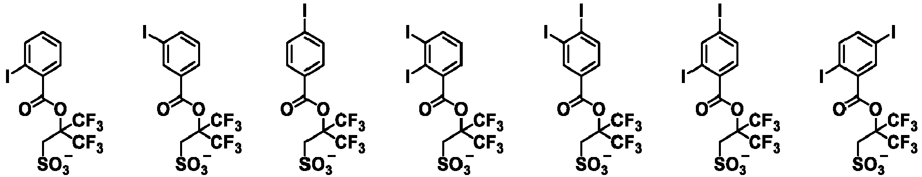

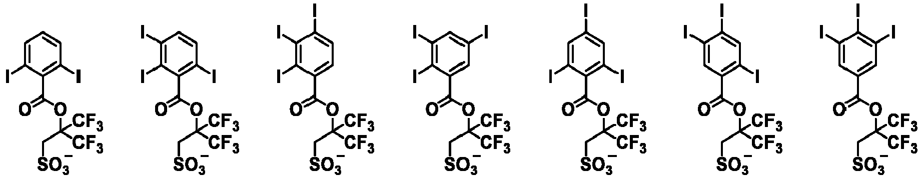

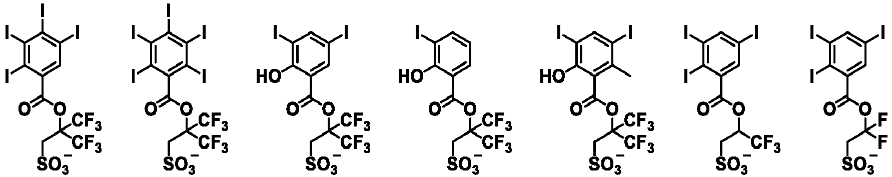

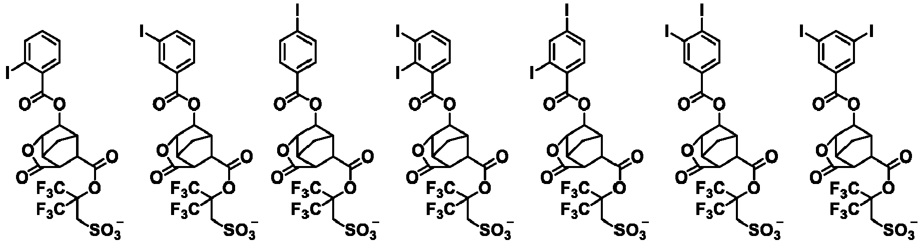

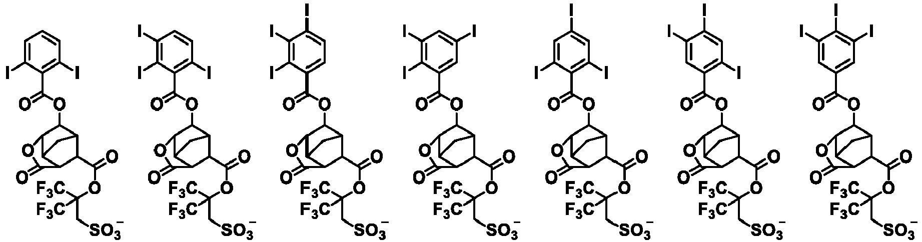

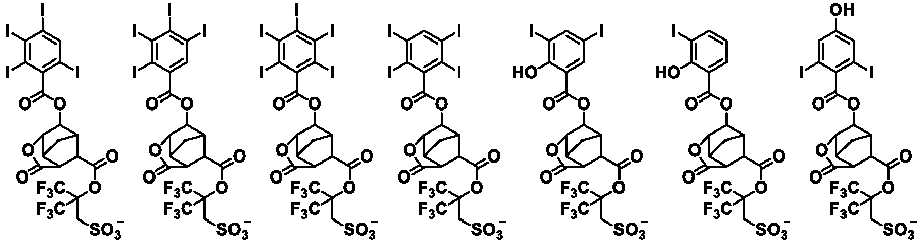

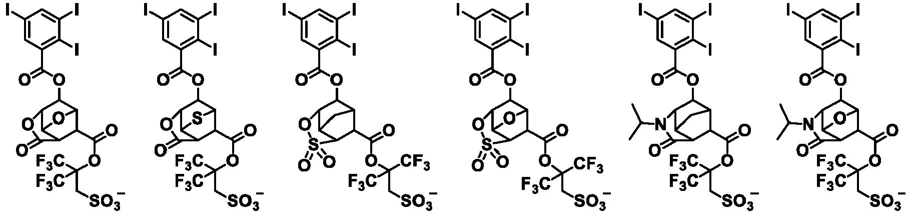

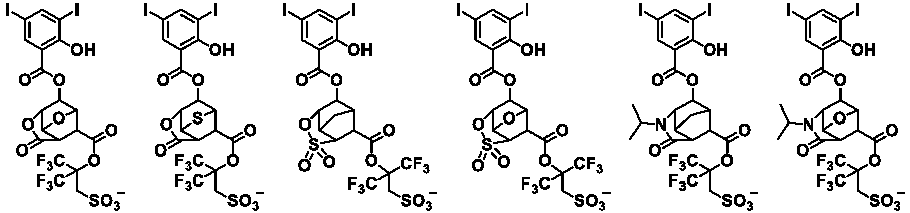

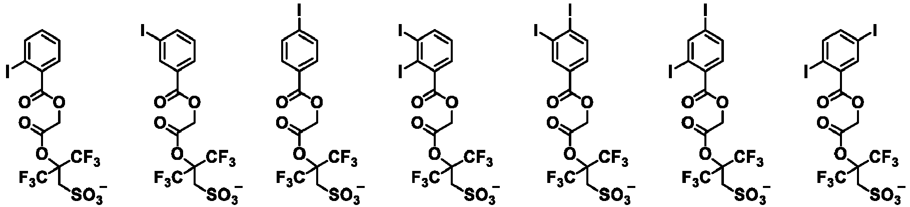

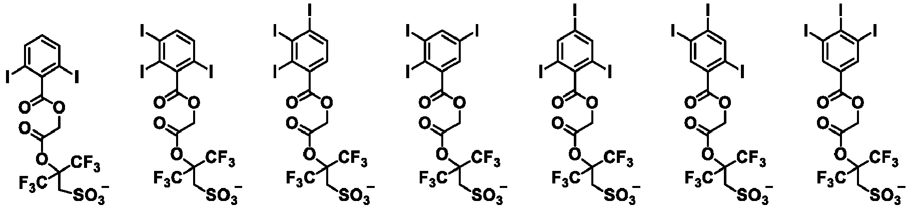

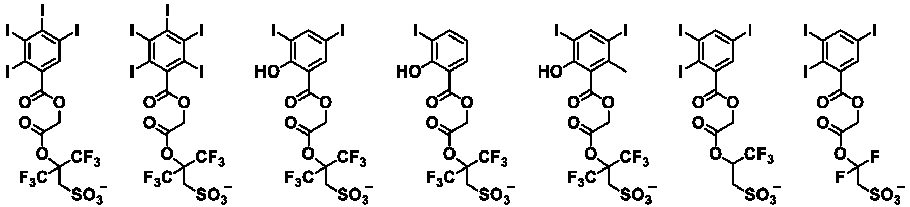

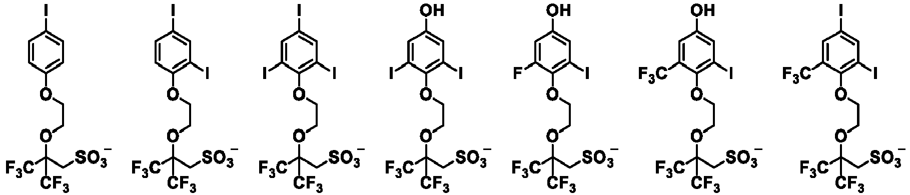

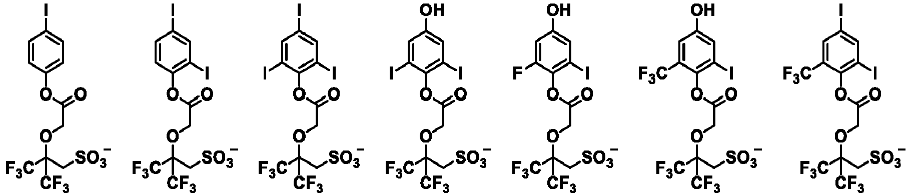

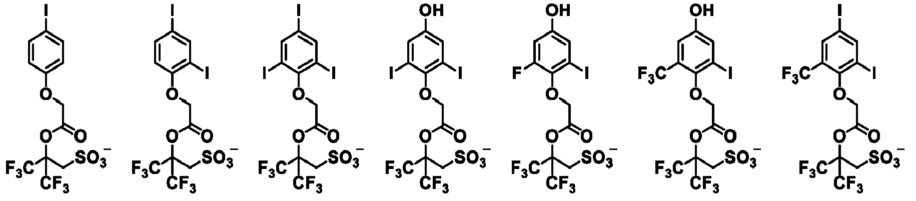

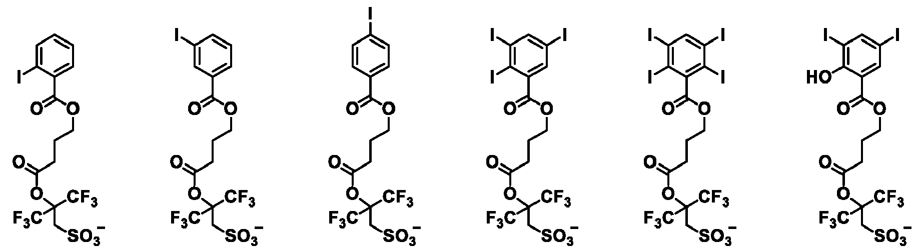

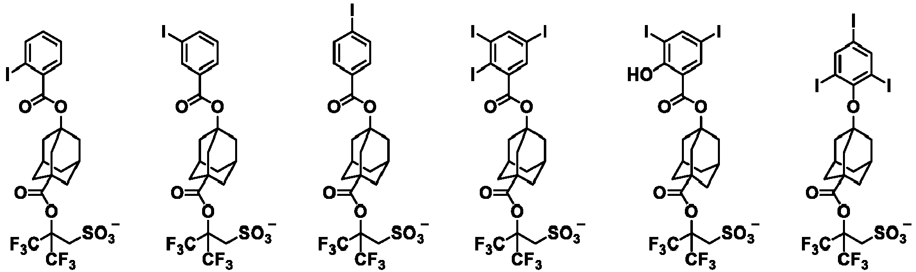

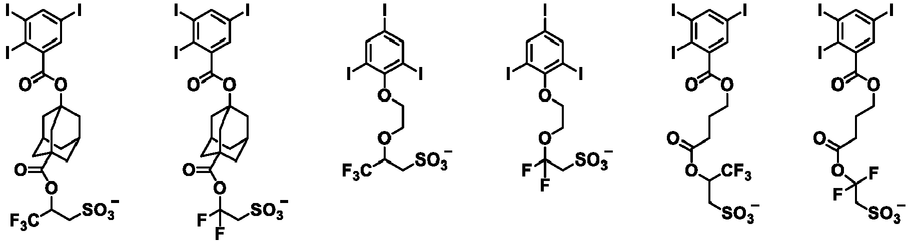

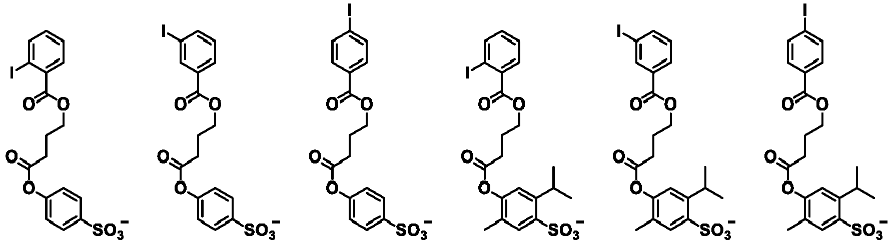

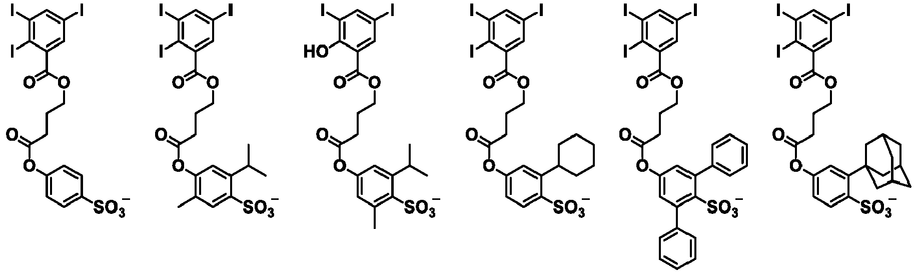

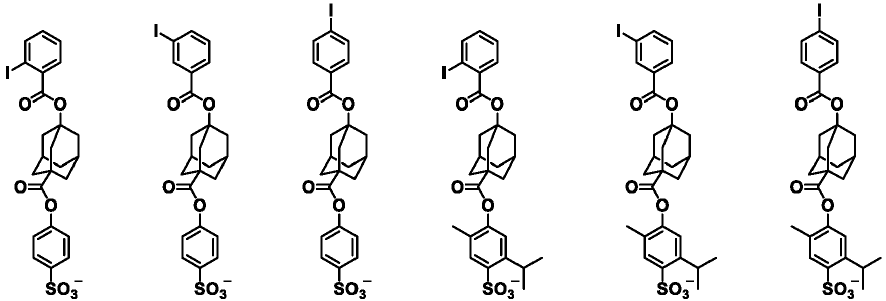

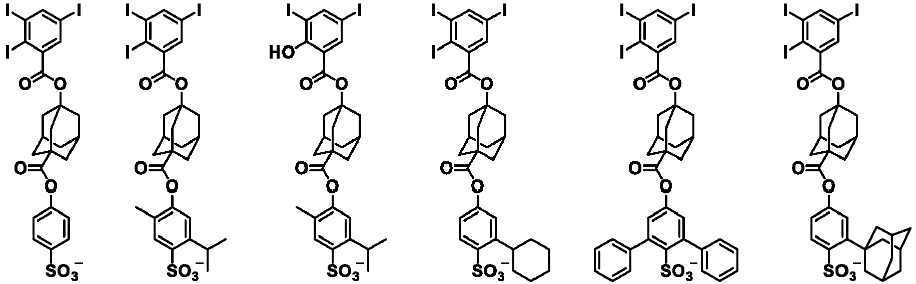

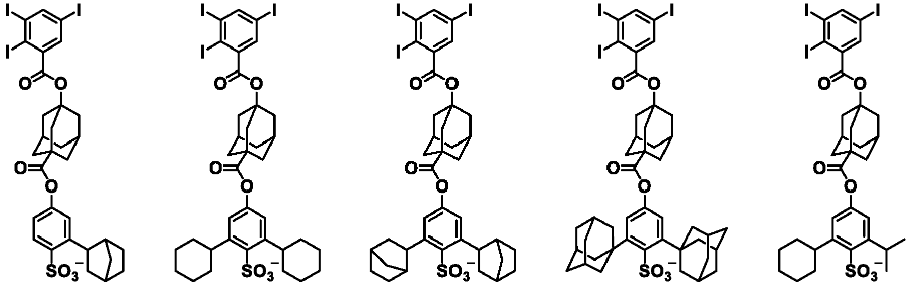

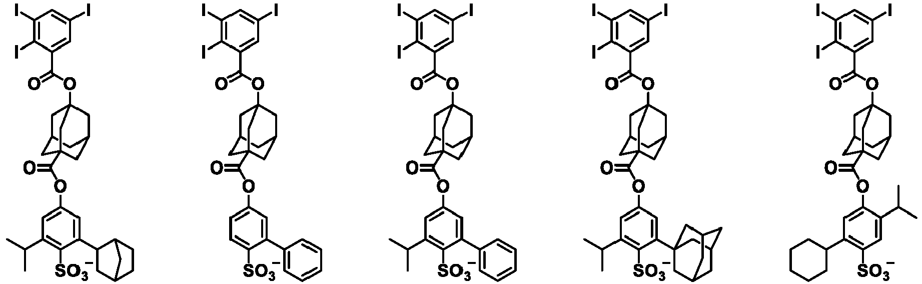

Preferred examples of the cation that pairs with the anion include sulfonium cations having the formula (B-3) and iodonium cations having the formula (B-4).

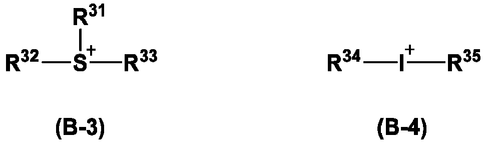

In formulae (B-3) and (B-4), R³¹ to R³⁵ are each independently halogen or a C₁-C₂₀ hydrocarbyl group which may contain a heteroatom.

Suitable halogen atoms include fluorine, chlorine, bromine and iodine.

The C₁-C₂₀ hydrocarbyl group may be saturated or unsaturated and straight, branched or cyclic. Examples thereof include C₁-C₂₀ alkyl groups such as methyl, ethyl, n-propyl, isopropyl, n-butyl, isobutyl, sec-butyl, tert-butyl, tert-pentyl, n-pentyl, n-hexyl, n-octyl, 2-ethylhexyl, n-nonyl and n-decyl; C₃-C₂₀ cyclic saturated hydrocarbyl groups such as cyclopentyl, cyclohexyl, cyclopentylmethyl, cyclopentylethyl, cyclopentylbutyl, cyclohexylmethyl, cyclohexylethyl, cyclohexylbutyl, norbornyl, tricyclo[5.2.1.0^{2,6}]decanyl, adamantyl, and adamantylmethyl; and C₆-C₂₀ aryl groups such as phenyl, naphthyl and anthracenyl. In the hydrocarbyl groups, some or all of the hydrogen atoms may be substituted by a moiety containing a heteroatom such as oxygen, sulfur, nitrogen or halogen, and a moiety containing a heteroatom such as oxygen, sulfur or nitrogen may intervene in a carbon-carbon bond, so that the group may contain a hydroxy, fluorine, chlorine, bromine, iodine, cyano, carbonyl, ether bond, ester bond, sulfonic ester bond, carbonate bond, lactone ring, sultone ring, carboxylic anhydride (-C(=O)-O-C(=O)-) or haloalkyl moiety.

Also, R³¹ and R³² may bond together to form a ring with the sulfur atom to which they are attached. Examples of the ring are shown below. 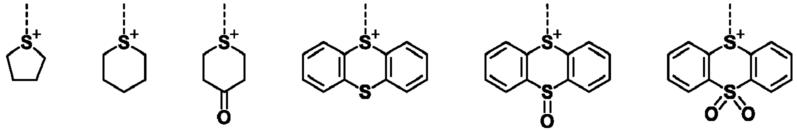 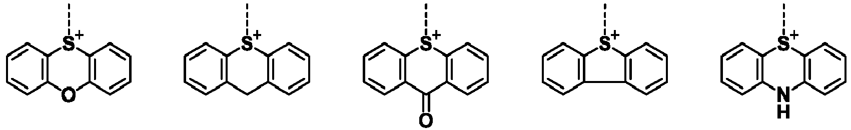 Herein, the broken line designates a point of attachment to R³³.

Exemplary structures of the sulfonium cation having formula (B-3) are shown below, but not limited thereto.

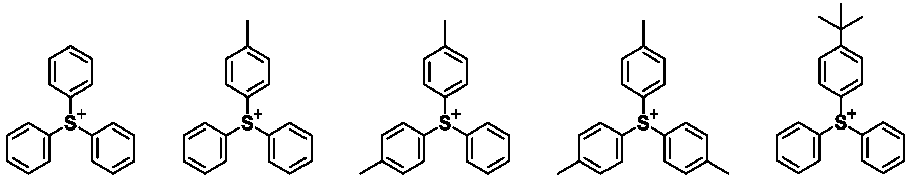

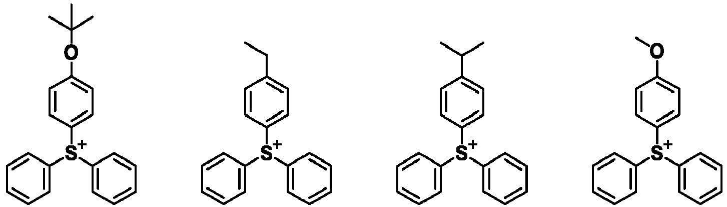

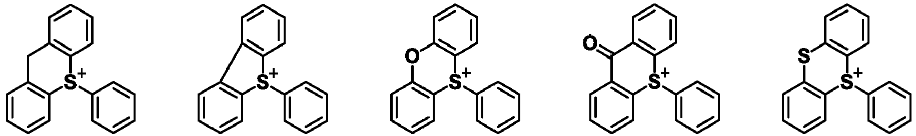

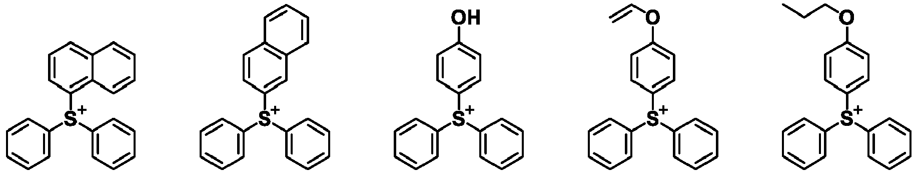

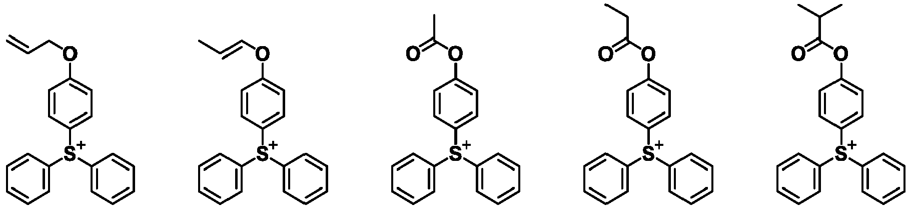

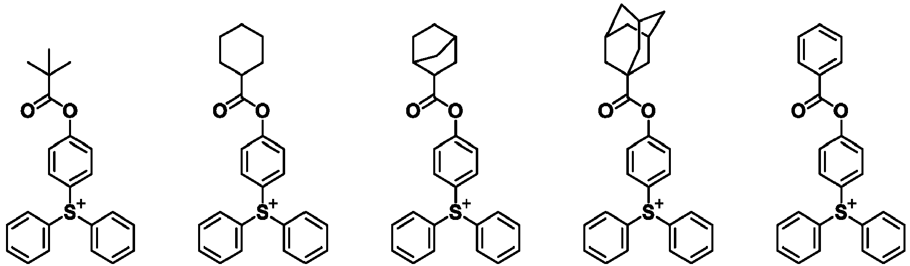

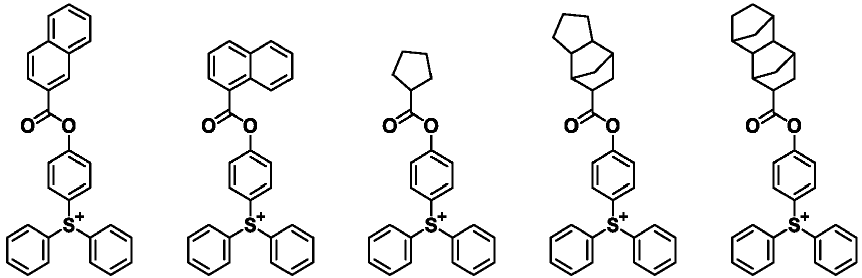

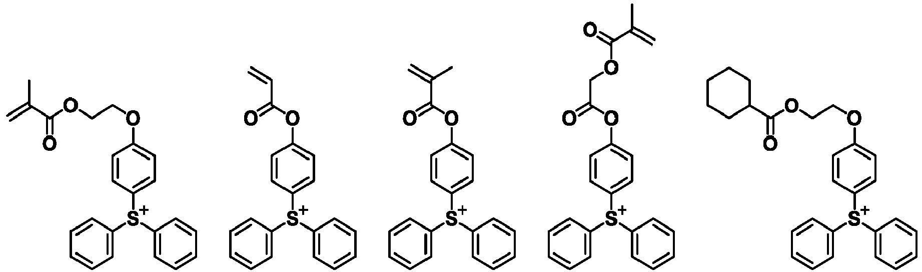

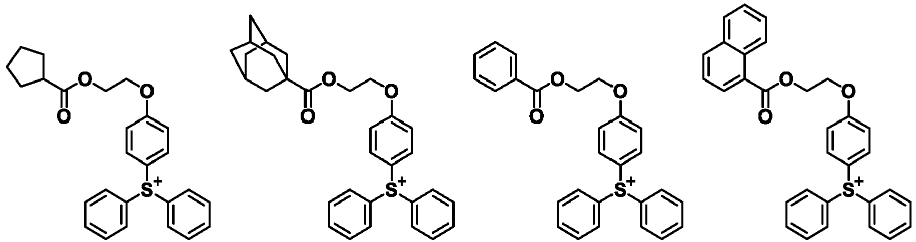

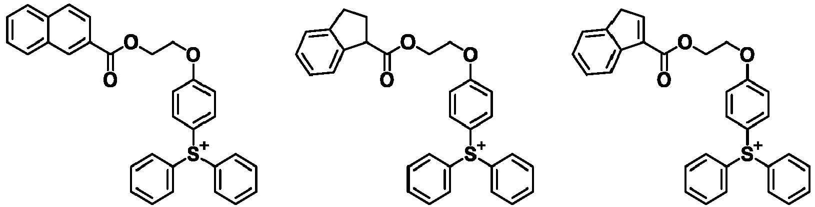

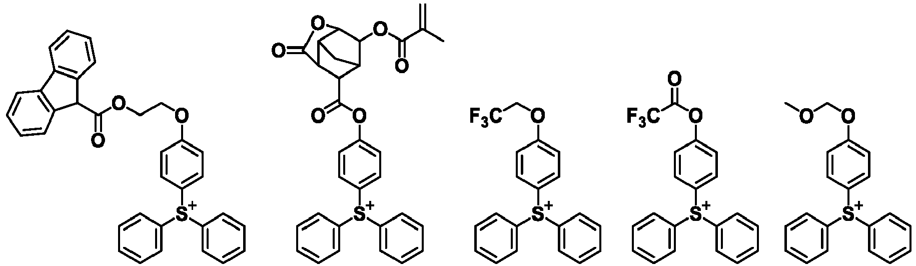

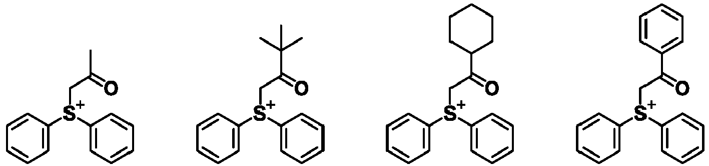

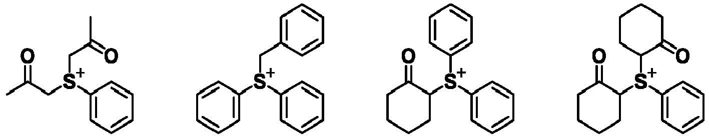

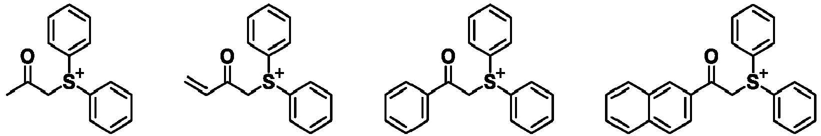

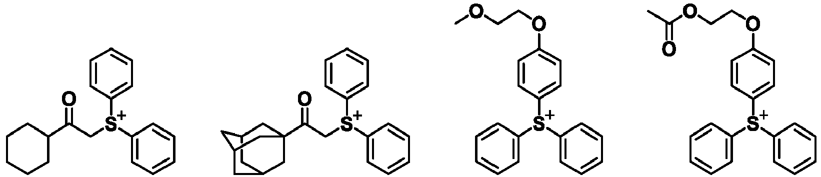

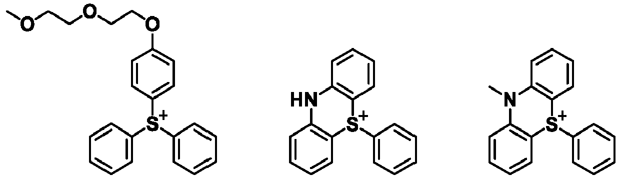

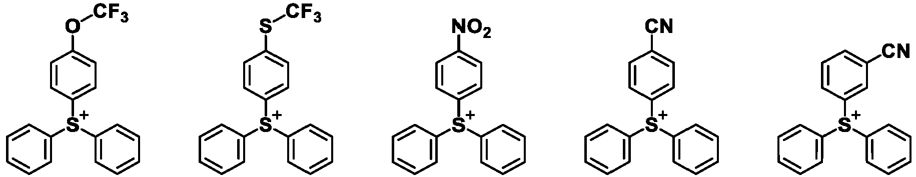

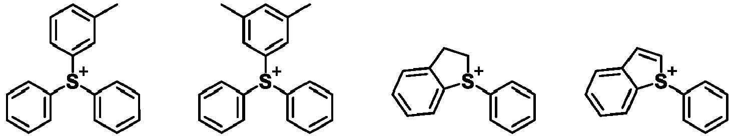

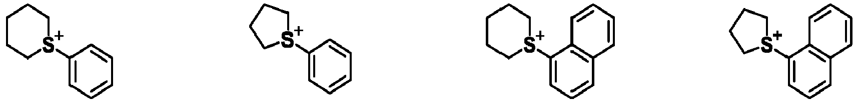

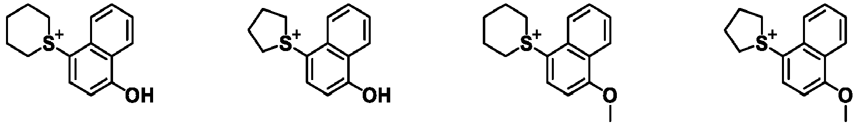

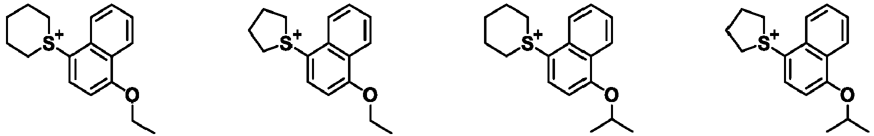

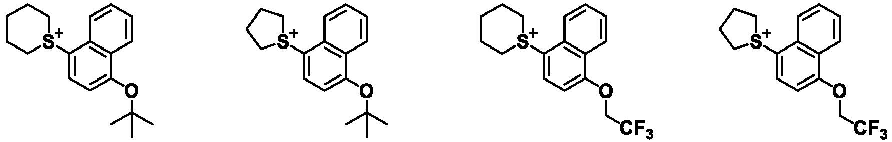

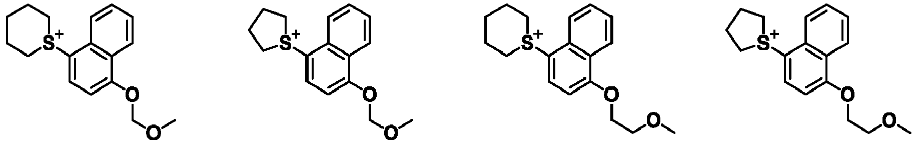

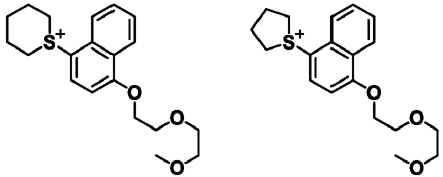

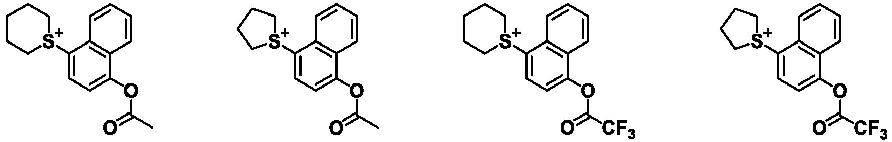

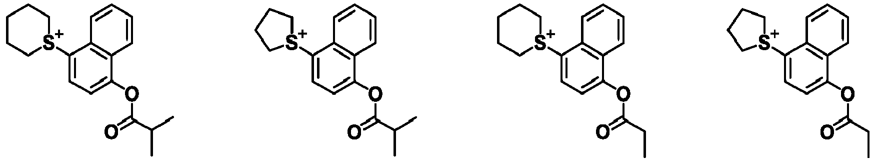

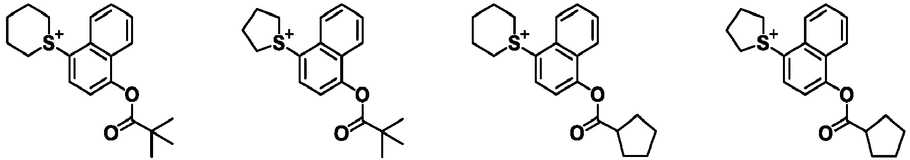

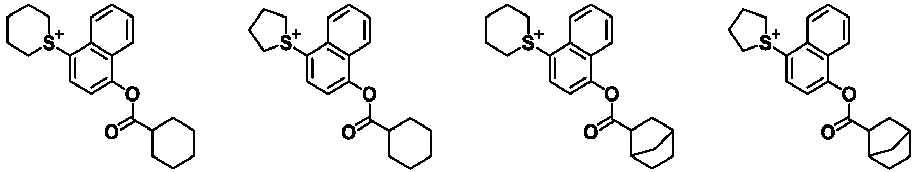

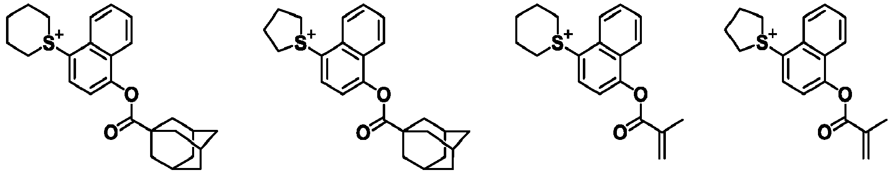

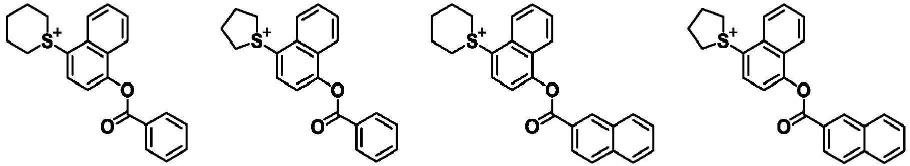

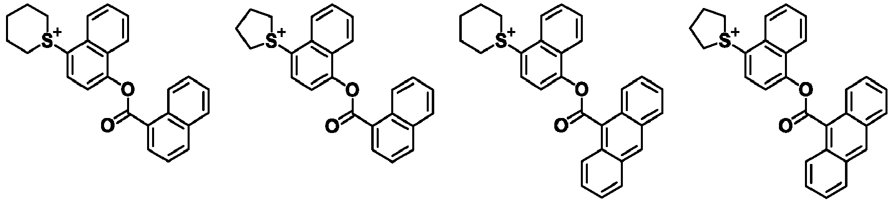

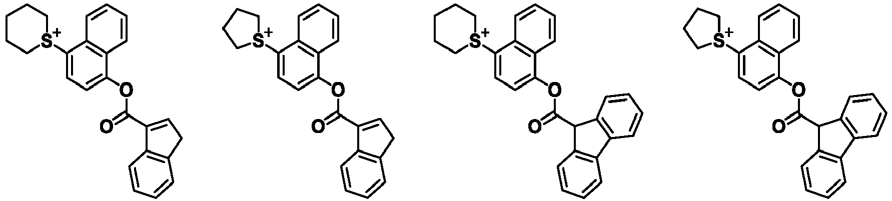

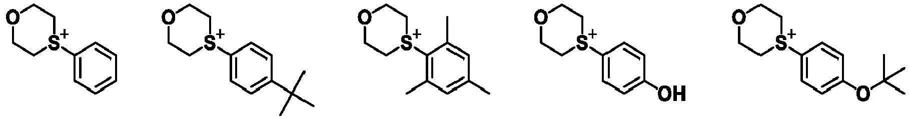

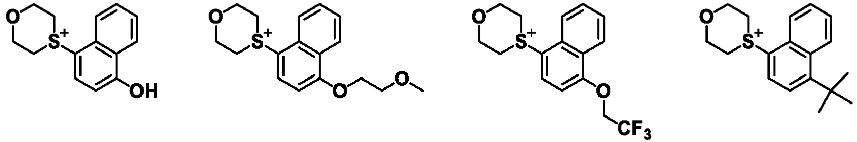

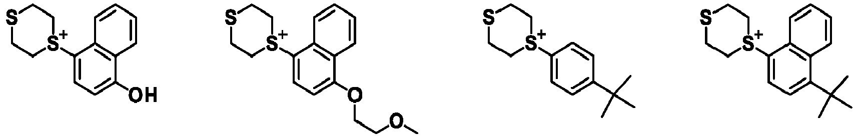

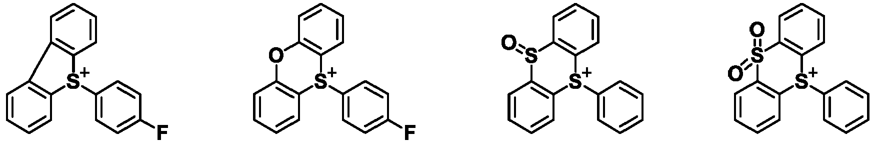

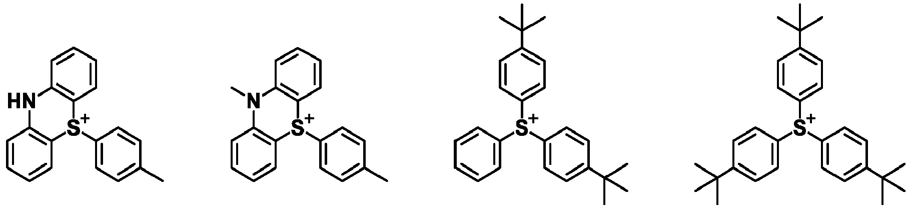

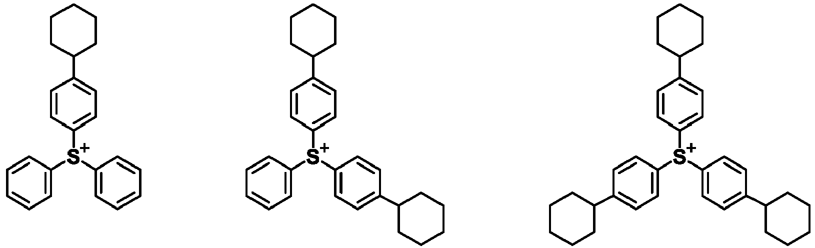

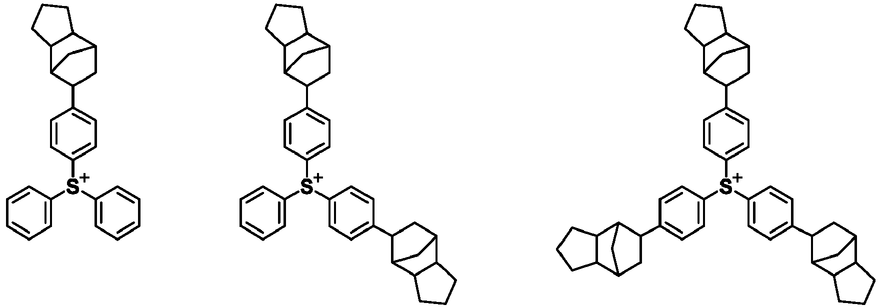

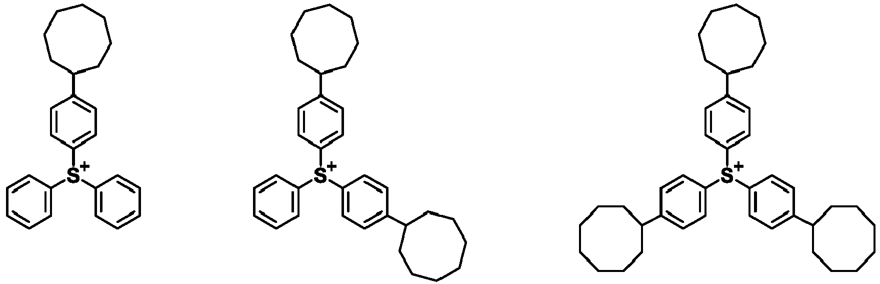

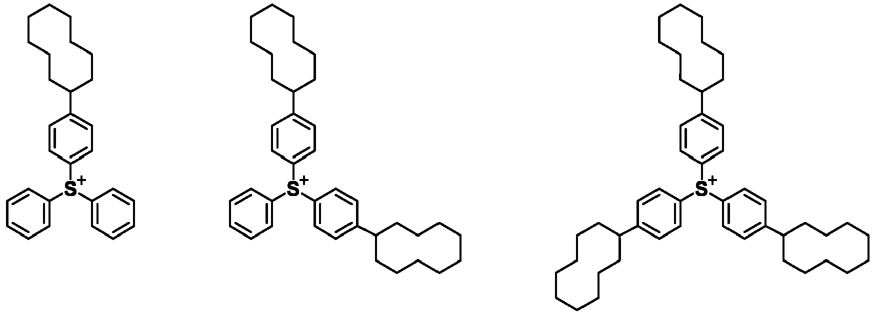

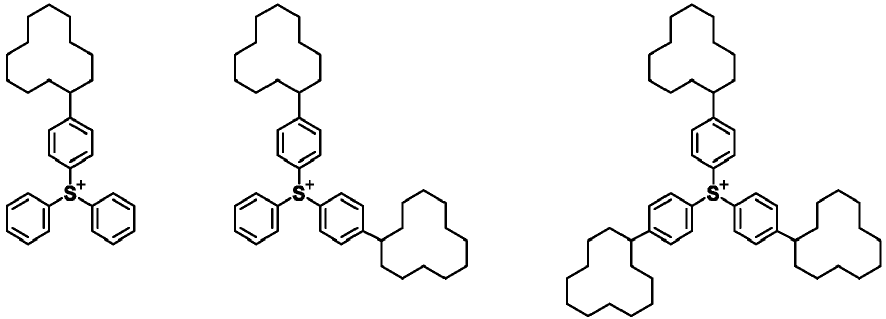

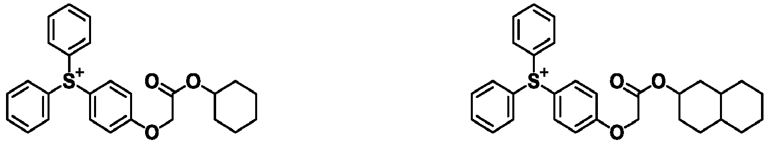

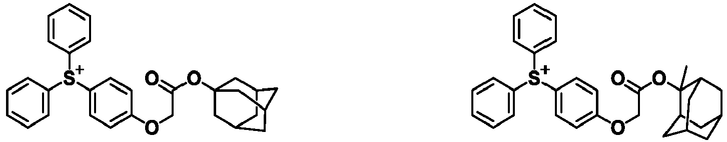

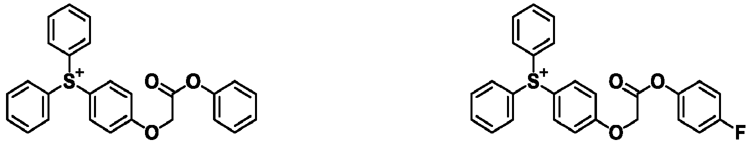

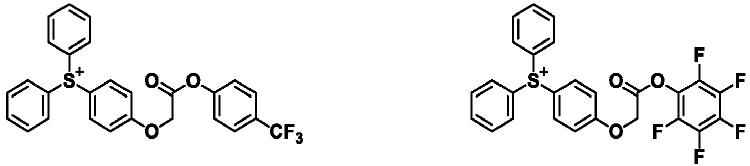

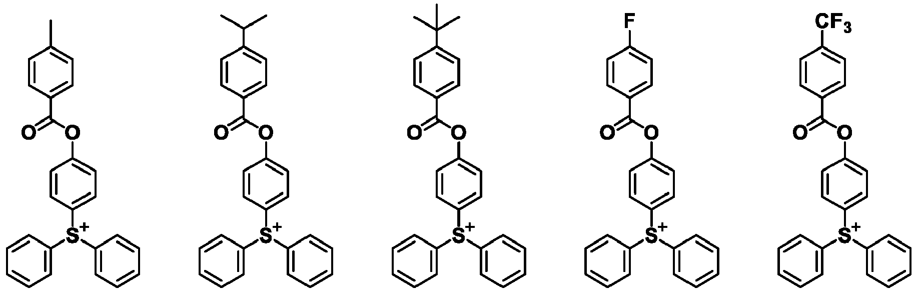

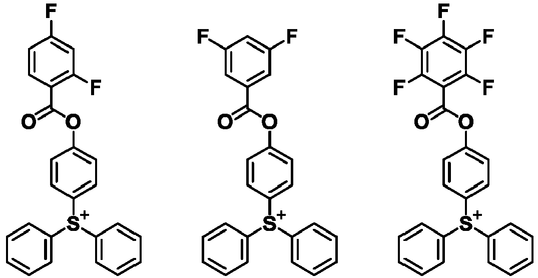

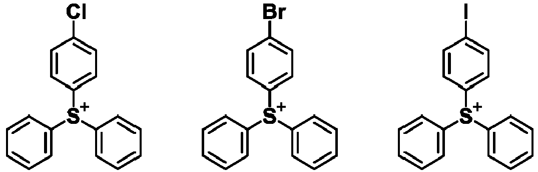

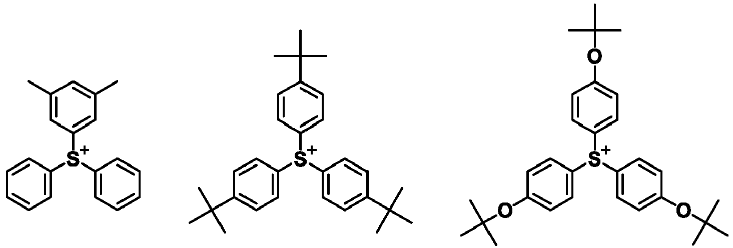

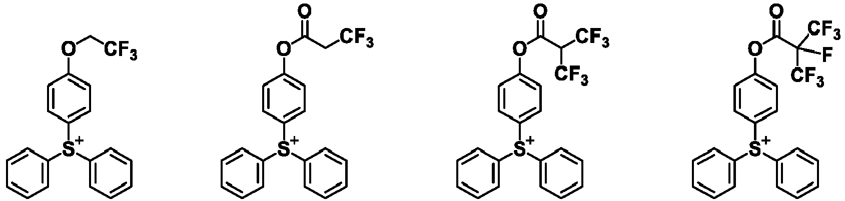

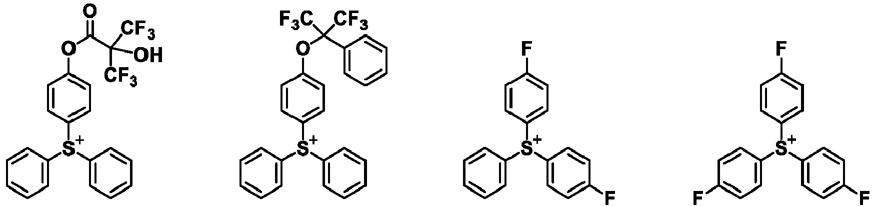

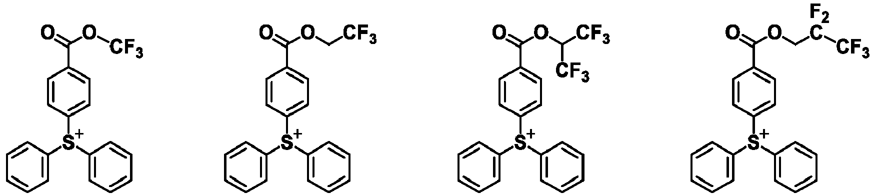

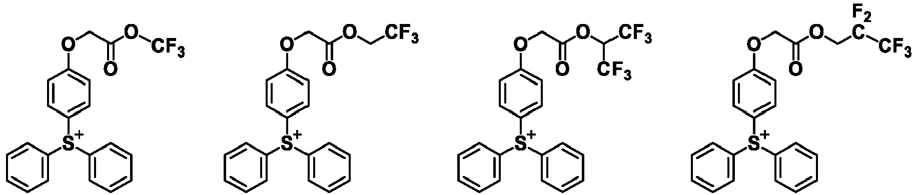

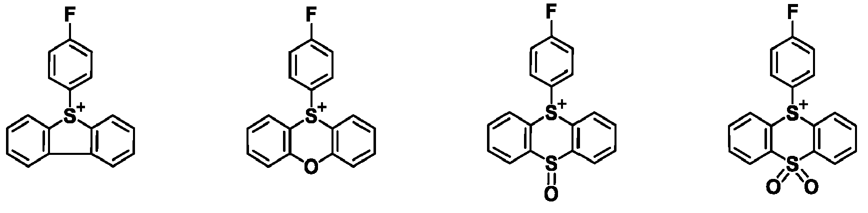

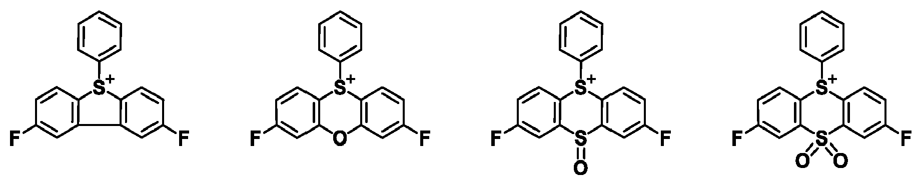

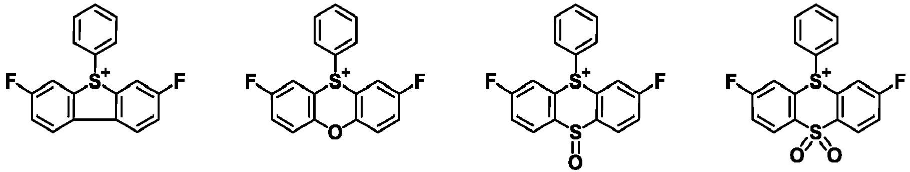

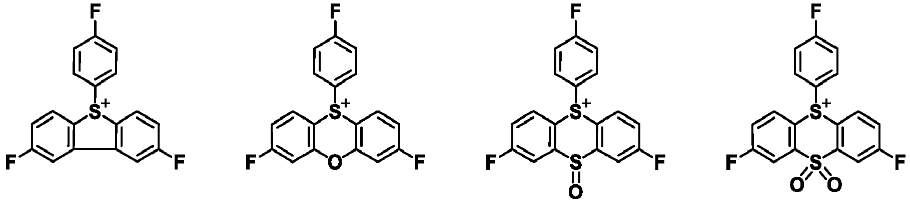

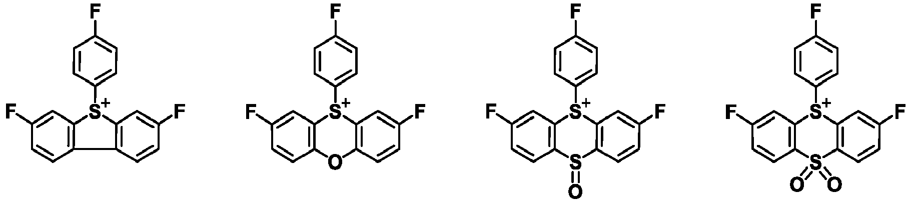

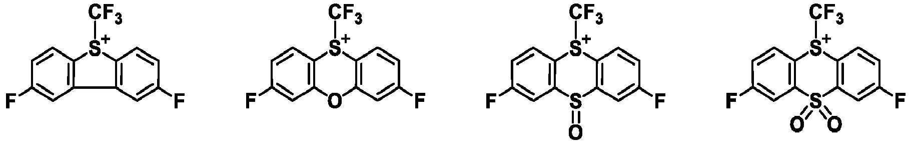

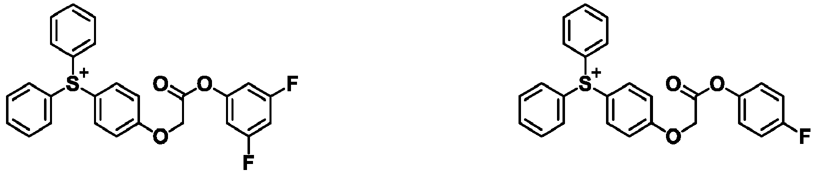

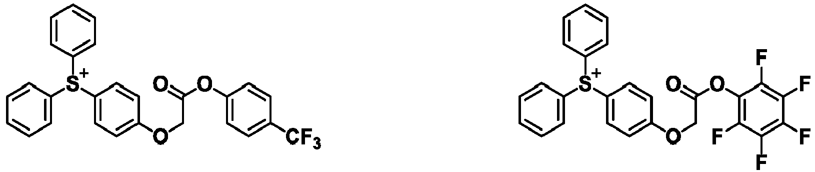

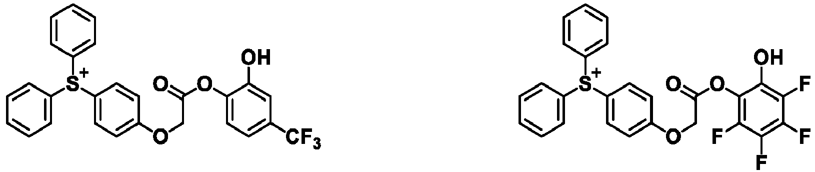

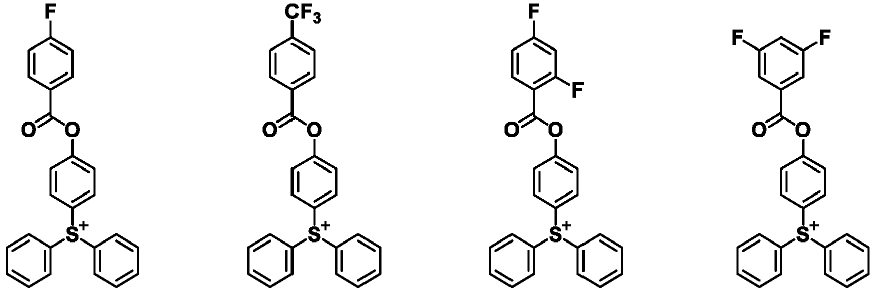

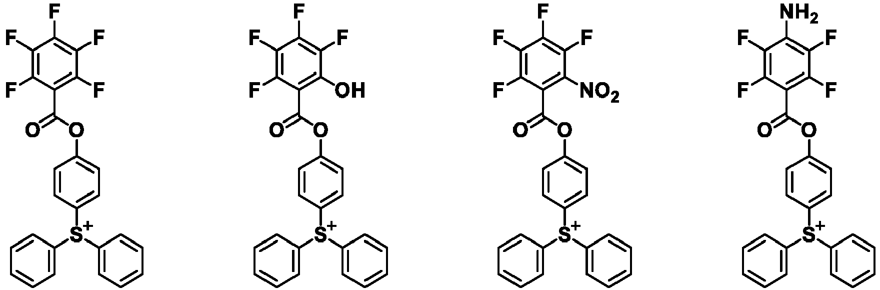

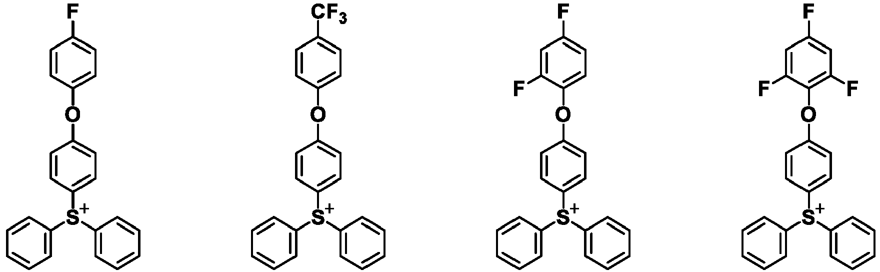

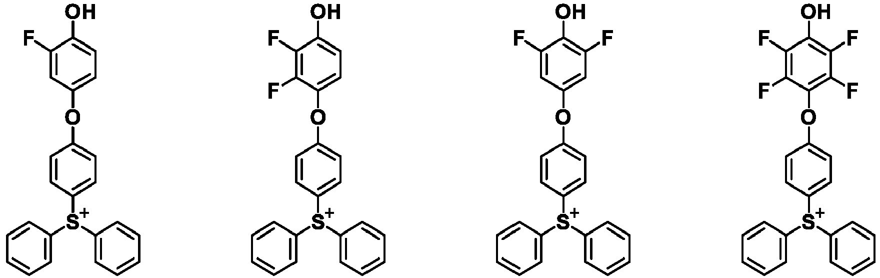

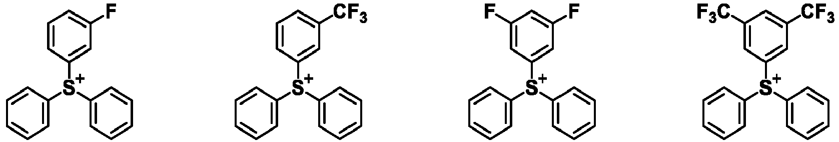

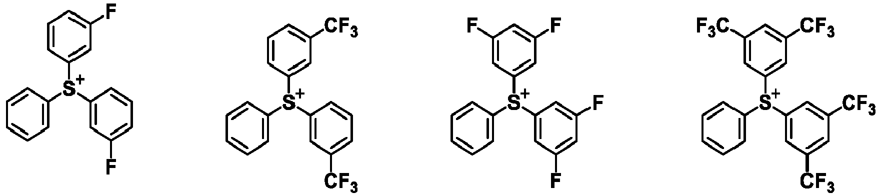

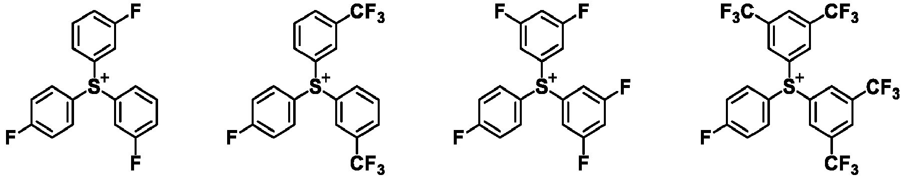

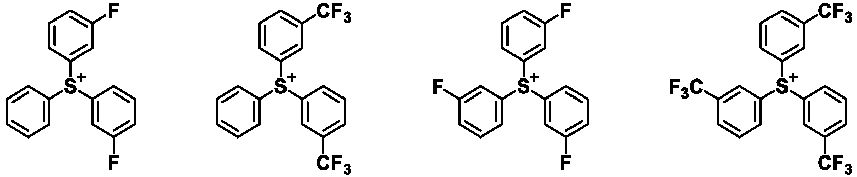

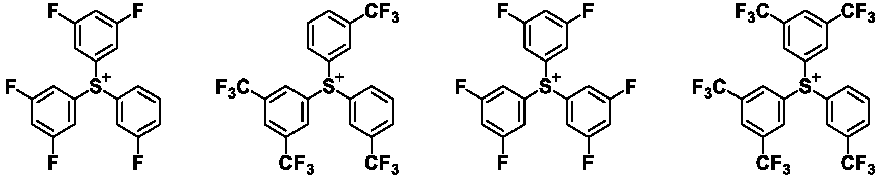

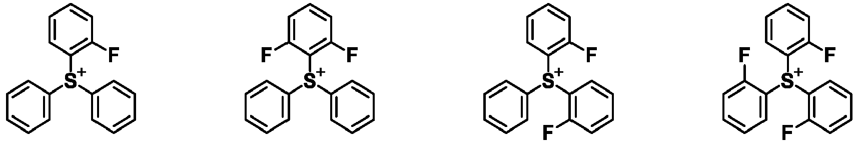

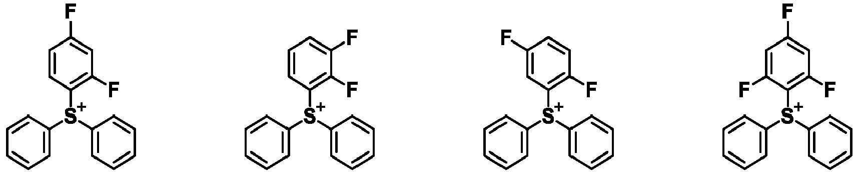

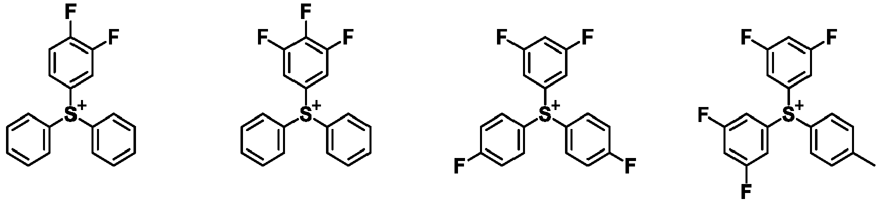

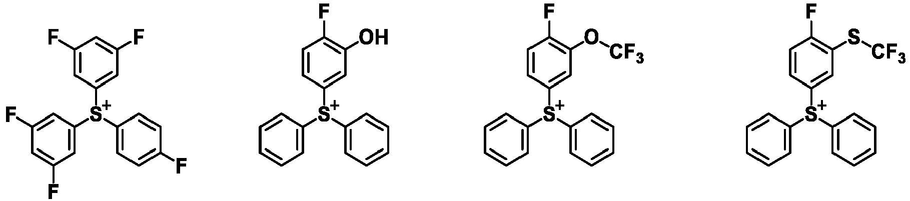

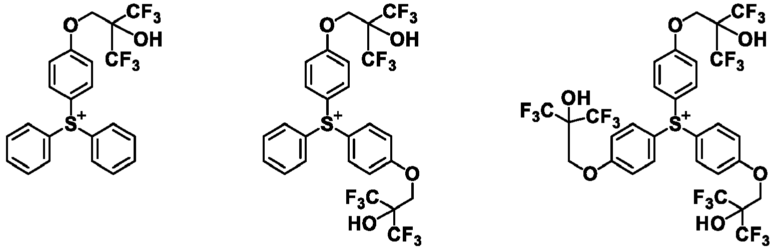

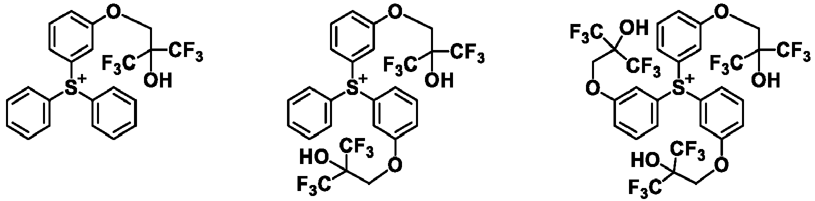

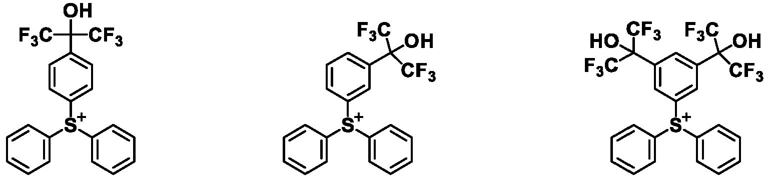

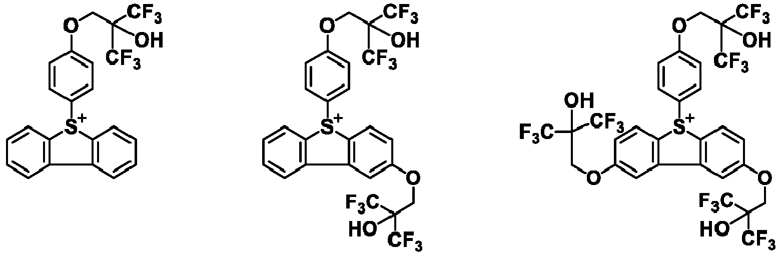

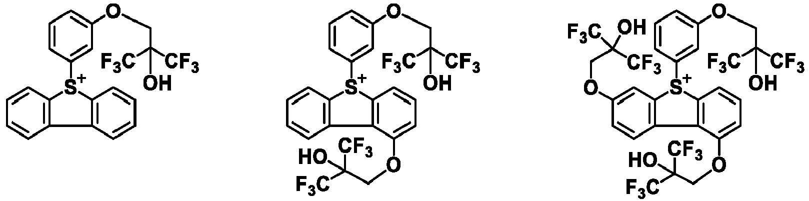

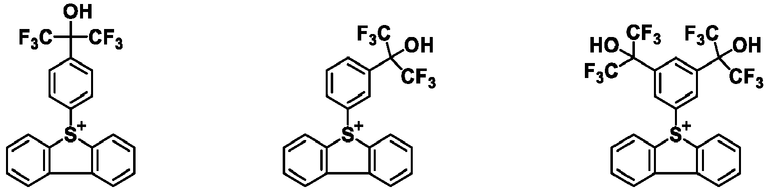

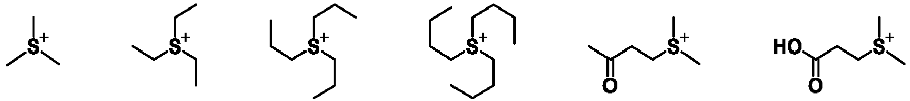

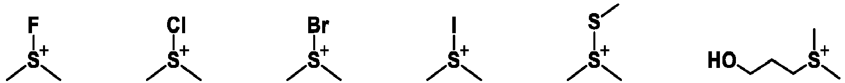

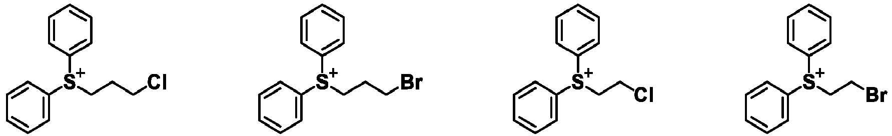

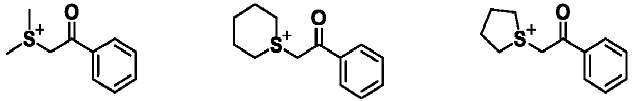

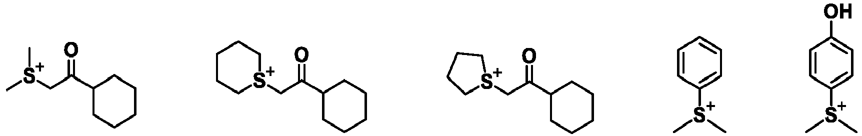

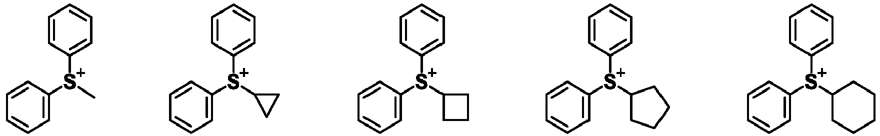

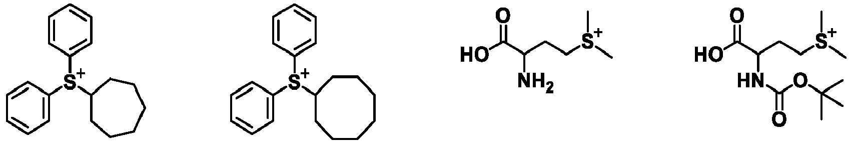

Exemplary structures of the iodonium cation having formula (B-4) are shown below, but not limited thereto.

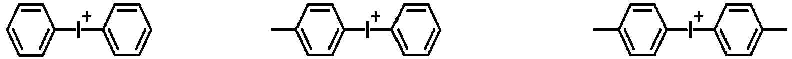

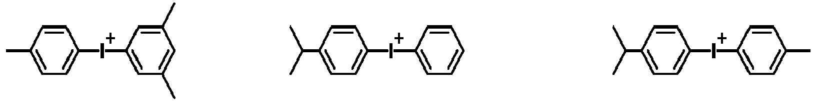

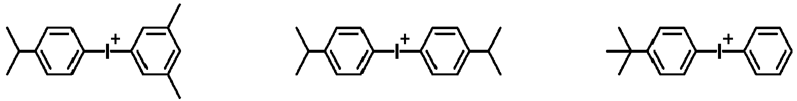

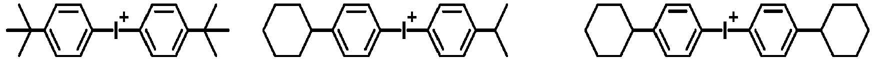

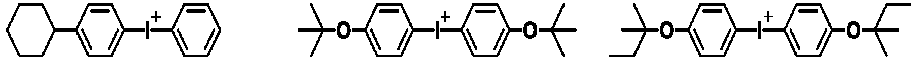

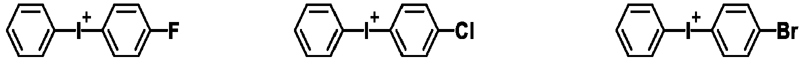

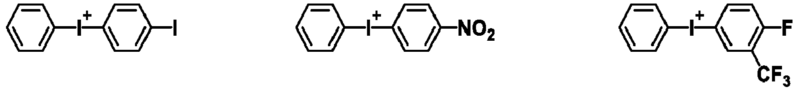

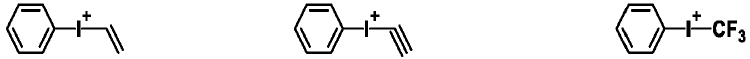

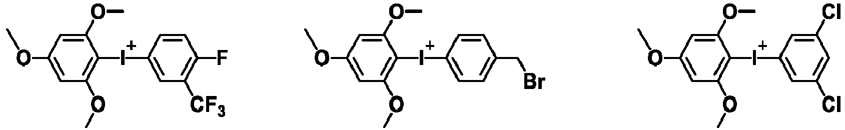

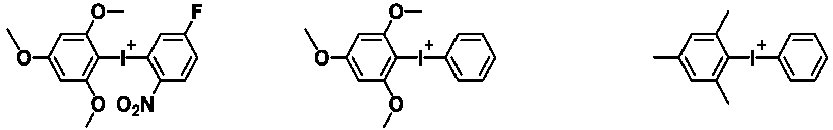

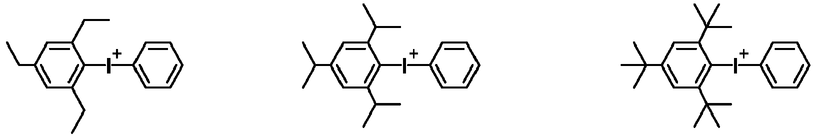

The PAG generates an acid having a pKa value of preferably -2.0 or more, more preferably -1.0 or more. The upper limit of pKa is preferably 2.0. Notably, the pKa value is computed using pKa DB in software ACD/Chemsketch ver: 9.04 of Advanced Chemistry Development Inc.

An appropriate amount of the PAG used is 1 to 30 parts, more preferably 2 to 20 parts by weight per 80 parts by weight of the base polymer (A). The PAG may be used alone or in admixture.

### (C) Quencher

The chemically amplified positive resist composition contains a quencher (or acid diffusion inhibitor). The quencher is typically selected from conventional basic compounds. Conventional basic compounds include primary, secondary, and tertiary aliphatic amines, mixed amines, aromatic amines, heterocyclic amines, nitrogen-containing compounds with carboxy group, nitrogen-containing compounds with sulfonyl group, nitrogen-containing compounds with hydroxy group, nitrogen-containing compounds with hydroxyphenyl group, alcoholic nitrogen-containing compounds, amide derivatives, imide derivatives, and carbamate derivatives. Also included are primary, secondary, and tertiary amine compounds, specifically amine compounds having a hydroxy group, ether bond, ester bond, lactone ring, cyano group, or sulfonic ester bond as described in JP-A 2008-111103, paragraphs [0146]-[0164], and compounds having a carbamate group as described in JP 3790649. Inter alia, tris[2-(methoxymethoxy)ethyl]amine, tris[2-(methoxymethoxy)ethyl]amine-N-oxide, dibutylaminobenzoic acid, morpholine derivatives, and imidazole derivatives are preferred. Addition of a basic compound is effective for further suppressing the diffusion rate of acid in the resist film or correcting the pattern profile.

Onium salts such as sulfonium, iodonium and ammonium salts of carboxylic acids which are not fluorinated at α-position as described in USP 8,795,942 (JP-A 2008-158339) may also be used as the quencher. While an α-fluorinated sulfonic acid, imide acid, and methide acid are necessary to deprotect the acid labile group, an α-non-fluorinated carboxylic acid is released by salt exchange with an α-non-fluorinated onium salt. An α-non-fluorinated carboxylic acid functions as a quencher because it does not induce substantial deprotection reaction.

Examples of the onium salt of α-non-fluorinated carboxylic acid include compounds having the formula (C1).

**R⁴¹-CO₂⁻ Mq⁺** **(C1)**

In formula (C1), R⁴¹ is hydrogen or a C₁-C₄₀ hydrocarbyl group which may contain a heteroatom, exclusive of the hydrocarbyl group in which the hydrogen bonded to the carbon atom at α-position of the carboxy group is substituted by fluorine or fluoroalkyl.

The hydrocarbyl group R⁴¹ may be saturated or unsaturated and straight, branched or cyclic. Examples thereof include C₁-C₄₀ alkyl groups such as methyl, ethyl, n-propyl, isopropyl, n-butyl, isobutyl, sec-butyl, tert-butyl, n-pentyl, tert-pentyl, n-hexyl, n-octyl, 2-ethylhexyl, n-nonyl, n-decyl; C₃-C₄₀ cyclic saturated hydrocarbyl groups such as cyclopentyl, cyclohexyl, cyclopentylmethyl, cyclopentylethyl, cyclopentylbutyl, cyclohexylmethyl, cyclohexylethyl, cyclohexylbutyl, norbornyl, tricyclo[5.2.1.0^{2,6}]decanyl, adamantyl, and adamantylmethyl; C₂-C₄₀ alkenyl groups such as vinyl, allyl, propenyl, butenyl and hexenyl; C₃-C₄₀ cyclic unsaturated aliphatic hydrocarbyl groups such as cyclohexenyl; C₆-C₄₀ aryl groups such as phenyl, naphthyl, alkylphenyl groups (e.g., 2-methylphenyl, 3-methylphenyl, 4-methylphenyl, 4-ethylphenyl, 4-tert-butylphenyl, 4-n-butylphenyl), dialkylphenyl groups (e.g., 2,4-dimethylphenyl and 2,4,6-triisopropylphenyl), alkylnaphthyl groups (e.g., methylnaphthyl and ethylnaphthyl), dialkylnaphthyl groups (e.g., dimethylnaphthyl and diethylnaphthyl); and C₇-C₄₀ aralkyl groups such as benzyl, 1-phenylethyl and 2-phenylethyl.

In the hydrocarbyl groups, some or all hydrogen may be substituted by a moiety containing a heteroatom such as oxygen, sulfur, nitrogen or halogen, and some -CH₂- may be replaced by a moiety containing a heteroatom such as oxygen, sulfur or nitrogen, so that the group may contain a hydroxy moiety, cyano moiety, carbonyl moiety, ether bond, thioether bond, ester bond, sulfonic ester bond, carbonate bond, lactone ring, sultone ring, carboxylic anhydride (-C(=O)-O-C(=O)-), or haloalkyl moiety. Suitable heteroatom-containing hydrocarbyl groups include heteroaryl groups such as thienyl; alkoxyphenyl groups such as 4-hydroxyphenyl, 4-methoxyphenyl, 3-methoxyphenyl, 2-methoxyphenyl, 4-ethoxyphenyl, 4-tert-butoxyphenyl, 3-tert-butoxyphenyl; alkoxynaphthyl groups such as methoxynaphthyl, ethoxynaphthyl, n-propoxynaphthyl and n-butoxynaphthyl; dialkoxynaphthyl groups such as dimethoxynaphthyl and diethoxynaphthyl; and aryloxoalkyl groups, typically 2-aryl-2-oxoethyl groups such as 2-phenyl-2-oxoethyl, 2-(1-naphthyl)-2-oxoethyl and 2-(2-naphthyl)-2-oxoethyl.

In formula (C1), Mq⁺ is an onium cation. The onium cation is preferably selected from sulfonium, iodonium and ammonium cations, more preferably sulfonium and iodonium cations. Exemplary sulfonium cations are as exemplified above for the sulfonium cation having formula (B-3). Exemplary iodonium cations are as exemplified above for the iodonium cation having formula (B-4).

Examples of the anion of the onium salt having formula (C1) are shown below, but not limited thereto.

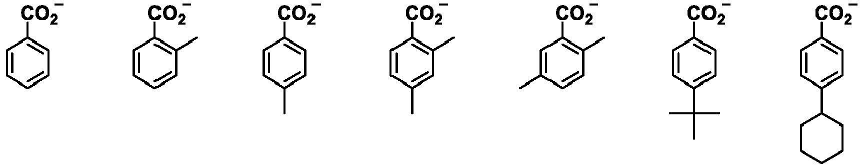

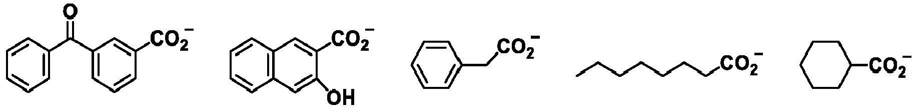

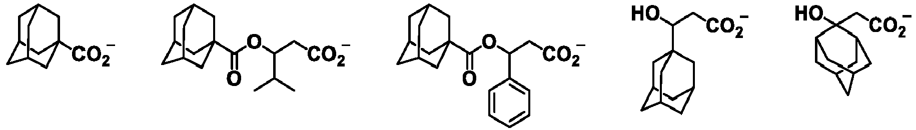

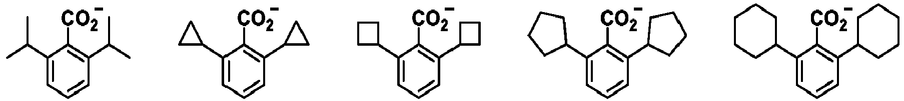

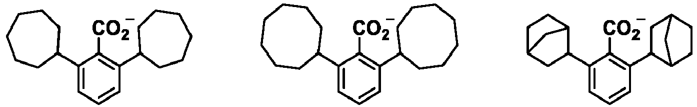

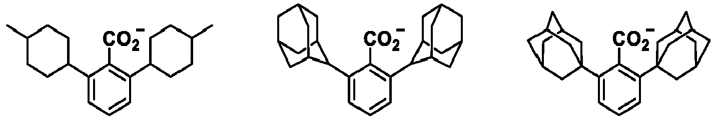

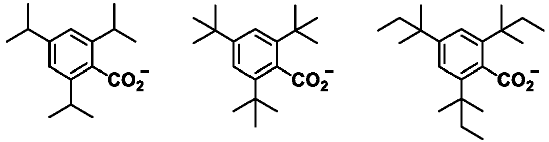

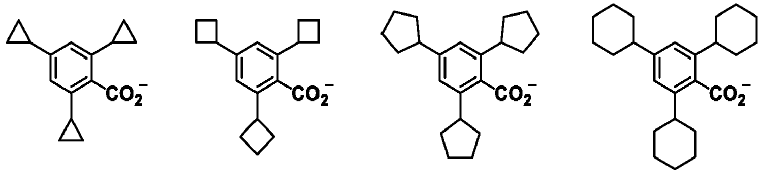

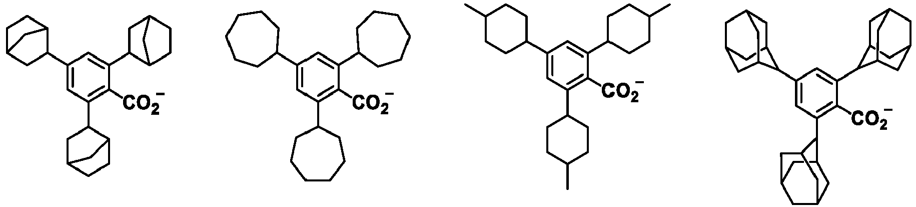

A sulfonium salt of iodized benzene ring-containing carboxylic acid having the formula (C2) is also useful as the quencher.

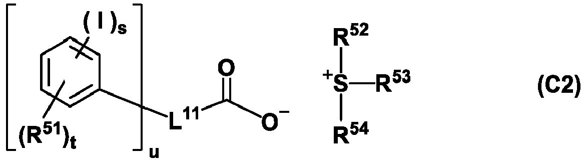

In formula (C2), s is an integer of 1 to 5, t is an integer of 0 to 3, and u is an integer of 1 to 3.

In formula (C2), R⁵¹ is hydroxy, fluorine, chlorine, bromine, amino, nitro, cyano, or a C₁-C₆ saturated hydrocarbyl, C₁-C₆ saturated hydrocarbyloxy, C₂-C₆ saturated hydrocarbylcarbonyloxy or C₁-C₄ saturated hydrocarbylsulfonyloxy group, in which some or all hydrogen may be substituted by halogen, or -N(R^{5A})-C(=O)-R^{51B}, or -N(R^{51A})-C(=O)-O-R^{51B}. R^{51A} is hydrogen or a C₁-C₆ saturated hydrocarbyl group. R^{51B} is a C₁-C₆ saturated hydrocarbyl or C₂-C₈ unsaturated aliphatic hydrocarbyl group. A plurality of R⁵¹ may be identical or different when t and/or u is 2 or 3.

In formula (C2), L¹¹ is a single bond, or a C₁-C₂₀ (u+1)-valent linking group which may contain at least one moiety selected from ether bond, carbonyl moiety, ester bond, amide bond, sultone ring, lactam ring, carbonate moiety, halogen, hydroxy moiety, and carboxy moiety. The saturated hydrocarbyl, saturated hydrocarbyloxy, saturated hydrocarbylcarbonyloxy, and saturated hydrocarbylsulfonyloxy groups may be straight, branched or cyclic.

In formula (C2), R⁵², R⁵³ and R⁵⁴ are each independently halogen, or a C₁-C₂₀ hydrocarbyl group which may contain a heteroatom. The hydrocarbyl group may be saturated or unsaturated and straight, branched or cyclic. Examples thereof include C₁-C₂₀ alkyl, C₂-C₂₀ alkenyl, C₆-C₂₀ aryl, and C₇-C₂₀ aralkyl groups. In the hydrocarbyl groups, some or all hydrogen may be substituted by hydroxy, carboxy, halogen, oxo, cyano, nitro, sultone ring, sulfo, or sulfonium salt-containing moiety, or some -CH₂- may be replaced by an ether bond, ester bond, carbonyl moiety, amide bond, carbonate bond or sulfonic ester bond. Also R⁵² and R⁵³ may bond together to form a ring with the sulfur atom to which they are attached.

Examples of the compound having formula (C2) include those described in USP 10,295,904 (JP-A 2017-219836). These compounds exert a sensitizing effect due to remarkable absorption and an acid diffusion controlling effect.

A nitrogen-containing carboxylic acid salt compound having the formula (C3) is also useful as the quencher.

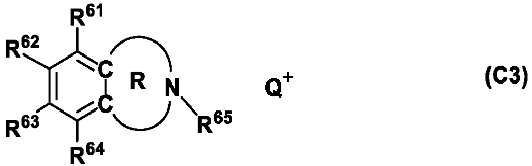

In formula (C3), R⁶¹ to R⁶⁴ are each independently hydrogen, -L¹²-CO_{2⁻}, or a C₁-C₂₀ hydrocarbyl group which may contain a heteroatom. R⁶¹ and R⁶², R⁶² and R⁶³, or R⁶³ and R⁶⁴ may bond together to form a ring with the carbon atom to which they are attached. L¹² is a single bond or a C₁-C₂₀ hydrocarbylene group which may contain a heteroatom. R⁶⁵ is hydrogen or a C₁-C₂₀ hydrocarbyl group which may contain a heteroatom.

In formula (C3), the ring R is a C₂-C₆ ring containing the carbon and nitrogen atoms in the formula, in which some or all of the carbon-bonded hydrogen atoms may be substituted by a C₁-C₂₀ hydrocarbyl group or -L¹²-CO₂⁻ and in which some carbon may be replaced by sulfur, oxygen or nitrogen. The ring may be alicyclic or aromatic and is preferably a 5- or 6-membered ring. Suitable rings include pyridine, pyrrole, pyrrolidine, piperidine, pyrazole, imidazoline, pyridazine, pyrimidine, pyrazine, imidazoline, oxazole, thiazole, morpholine, thiazine, and triazole rings.

The carboxylic onium salt having formula (C3) has at least one -L¹²-CO₂⁻. That is, at least one of R⁶¹ to R⁶⁴ is -L¹²-CO₂⁻, and/or at least one of hydrogen atoms bonded to carbon atoms in the ring R is substituted by -L¹²-CO₂⁻.

In formula (C3), Q⁺ is a sulfonium, iodonium or ammonium cation, with the sulfonium cation being preferred. Examples of the sulfonium cation are as exemplified above for the cation having formula (B-3).

Examples of the anion in the compound having formula (C3) are shown below, but not limited thereto.

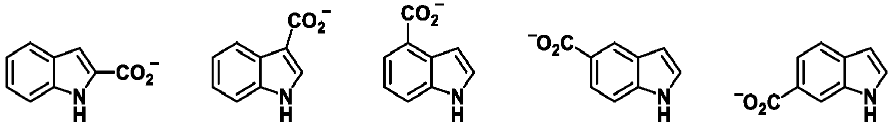

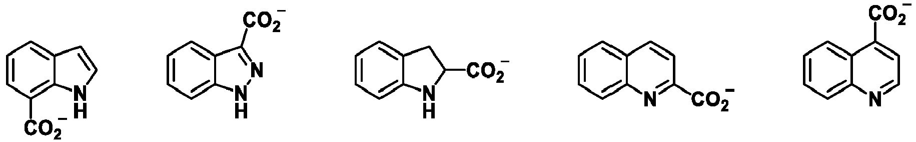

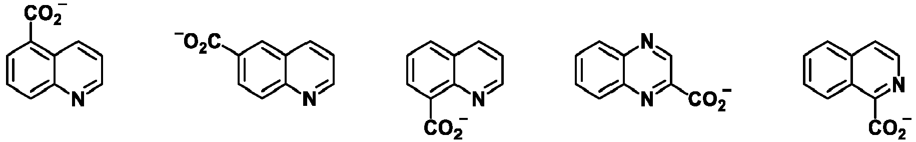

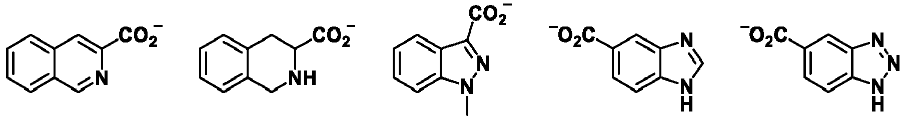

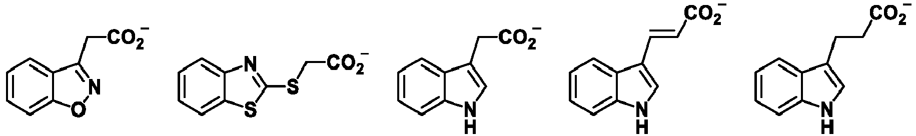

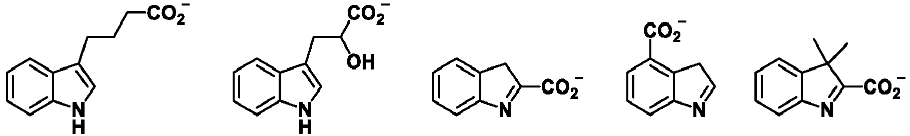

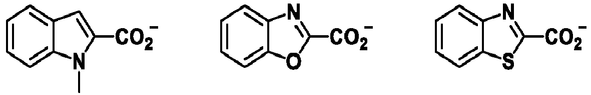

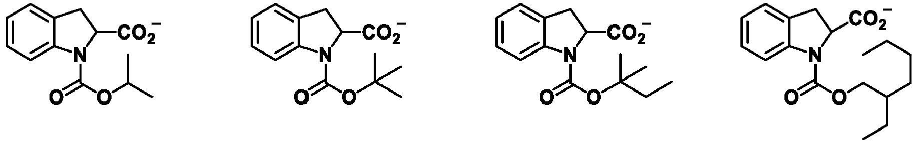

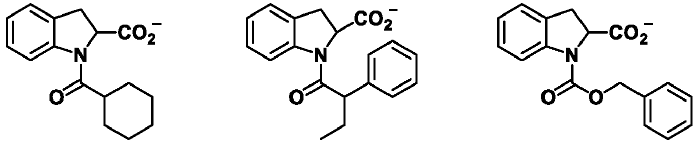

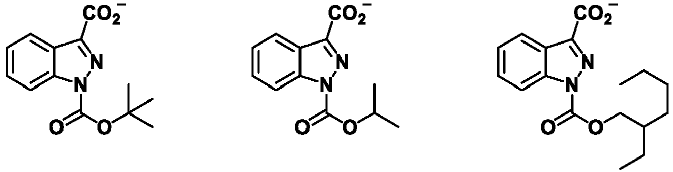

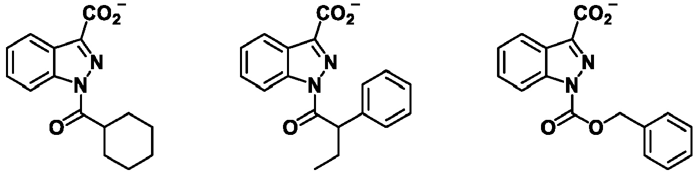

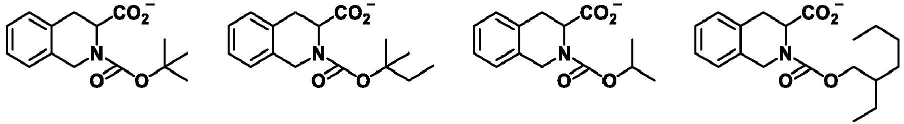

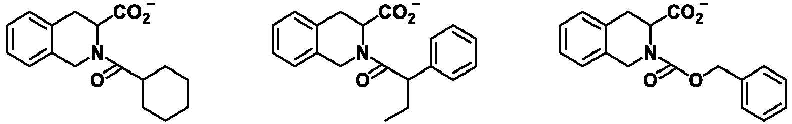

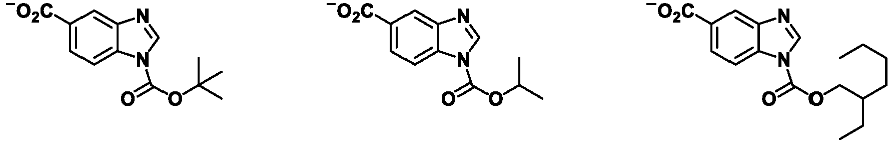

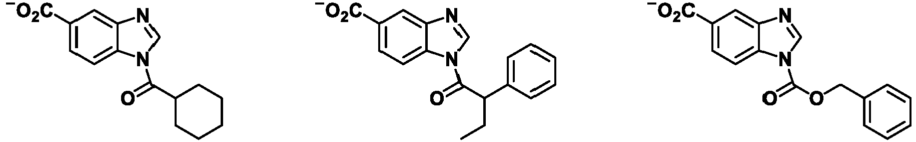

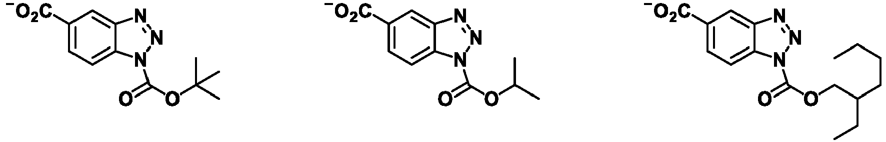

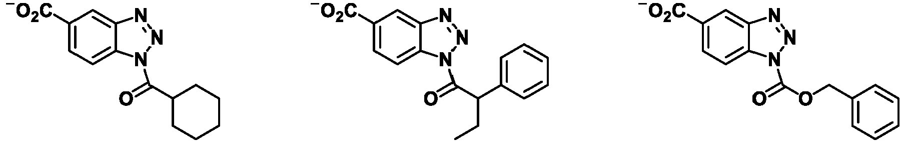

Weak acid betaine compounds are also useful as the quencher. Non-limiting examples thereof are shown below.

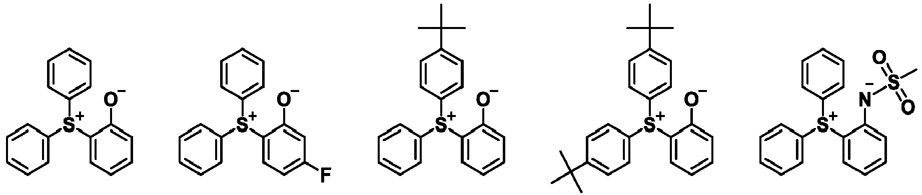

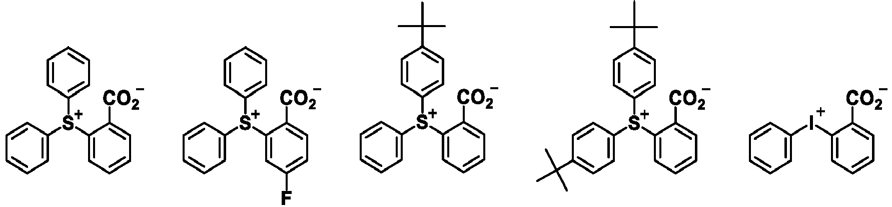

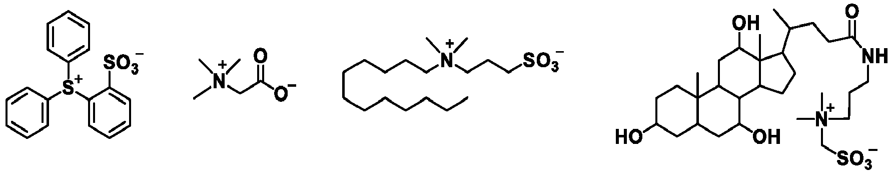

Also useful are quenchers of polymer type as described in USP 7,598,016 (JP-A 2008-239918). The polymeric quencher segregates at the surface of a resist film and thus enhances the rectangularity of resist pattern. When a protective film is applied as is often the case in the immersion lithography, the polymeric quencher is also effective for preventing a film thickness loss of resist pattern or rounding of pattern top.

The quencher is preferably added in an amount of 0.01 to 50 parts, more preferably 0.1 to 40 parts by weight per 80 parts by weight of the base polymer (A). The quencher may be used alone or in admixture.

In the resist composition, the PAG and the quencher are present in a weight ratio (B)/(C) of less than 3/1, preferably less than 2.5/1, more preferably less than 2/1. As long as the weight ratio of the PAG to the quencher is in the range, it is possible to fully suppress acid diffusion, leading to improved resolution and dimensional uniformity.

### (D) Fluorinated polymer

The positive resist composition may further comprise a fluorinated polymer which contains repeat units of at least one type selected from repeat units having the formula (D1), repeat units having the formula (D2), repeat units having the formula (D3), and repeat units having the formula (D4), and which may contain repeat units of at least one type selected from repeat units having the formula (D5) and repeat units having the formula (D6), for the purposes of enhancing contrast, preventing chemical flare of acid upon exposure to high-energy radiation, preventing mixing of acid from an anti-charging film in the step of coating an anti-charging film-forming material on a resist film, and suppressing unexpected unnecessary pattern degradation. It is noted that repeat units having formulae (D1), (D2), (D3), (D4), (D5), and (D6) are also referred to as repeat units D1, D2, D3, D4, D5, and D6, respectively, hereinafter. Since the fluorinated polymer also has a surface active function, it can prevent insoluble residues from re-depositing onto the substrate during the development step and is thus effective for preventing development defects.

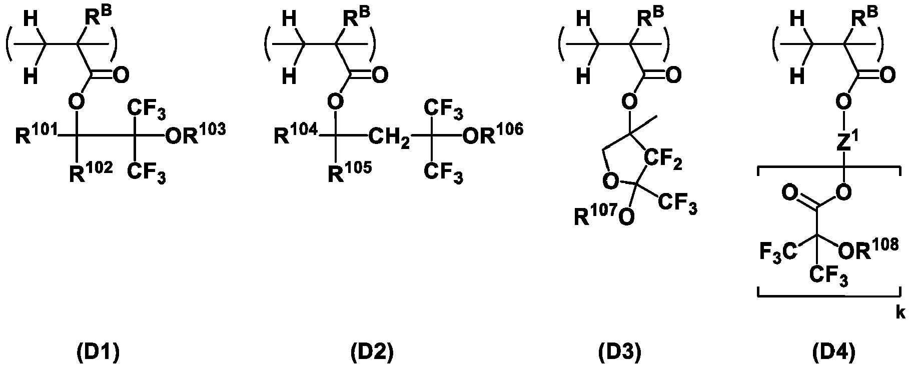

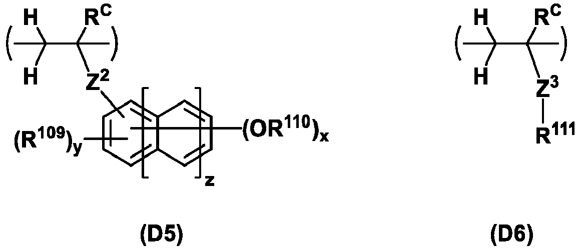

In formulae (D1) to (D6), R^{B} is each independently hydrogen, fluorine, methyl or trifluoromethyl. R^{C} is each independently hydrogen or methyl. R¹⁰¹, R¹⁰², R¹⁰⁴ and R¹⁰⁵ are each independently hydrogen or a C₁-C₁₀ saturated hydrocarbyl group. R¹⁰³, R¹⁰⁶, R¹⁰⁷ and R¹⁰⁸ are each independently hydrogen, a C₁-C₁₅ hydrocarbyl group or fluorinated hydrocarbyl group, or an acid labile group, with the proviso that an ether bond or carbonyl moiety may intervene in a carbon-carbon bond in the hydrocarbyl groups or fluorinated hydrocarbyl groups represented by R¹⁰³, R¹⁰⁶, R¹⁰⁷ and R¹⁰⁸. R¹⁰⁹ is hydrogen or a C₁-C₅ straight or branched hydrocarbyl group in which a heteroatom-containing moiety may intervene in a carbon-carbon bond. R¹¹⁰ is hydrogen or a C₁-C₅ straight or branched hydrocarbyl group in which a heteroatom-containing moiety may intervene in a carbon-carbon bond. R¹¹¹ is a C₁-C₂₀ saturated hydrocarbyl group in which at least one hydrogen is substituted by fluorine and some constituent -CH₂- may be replaced by an ester bond or ether bond. The subscript x is an integer of 1 to 3, y is an integer satisfying: 0 ≤ y ≤ 5+2z-x, z is 0 or 1, and k is an integer of 1 to 3. Z¹ is a C₁-C₂₀ (k+1)-valent hydrocarbon group or C₁-C₂₀ (k+1)-valent fluorinated hydrocarbon group. Z² is a single bond, *-C(=O)-O- or *-C(=O)-NH- wherein the asterisk (*) designates a point of attachment to the carbon atom in the backbone. Z³ is a single bond, -O-, ^{∗}-C(=O)-O-Z³¹-Z³²- or ^{∗}-C(=O)-NH-Z³¹-Z³²-, wherein Z³¹ is a single bond or a C₁-C₁₀ saturated hydrocarbylene group, Z³² is a single bond, ester bond, ether bond or sulfonamide bond, and the asterisk (*) designates a point of attachment to the carbon atom in the backbone.

In formulae (D1) and (D2), examples of the C₁-C₁₀ saturated hydrocarbyl group represented by R¹⁰¹, R¹⁰², R¹⁰⁴ and R¹⁰⁵ include C₁-C₁₀ alkyl groups such as methyl, ethyl, n-propyl, isopropyl, n-butyl, isobutyl, sec-butyl, tert-butyl, n-pentyl, n-hexyl, n-heptyl, n-octyl, n-nonyl, and n-decyl, and C₃-C₁₀ cyclic saturated hydrocarbyl groups such as cyclopropyl, cyclobutyl, cyclopentyl, cyclohexyl, adamantyl, and norbornyl. Inter alia, C₁-C₆ saturated hydrocarbyl groups are preferred.

In formulae (D1) to (D4), examples of the C₁-C₁₅ hydrocarbyl group represented by R¹⁰³, R¹⁰⁶, R¹⁰⁷ and R¹⁰⁸ include C₁-C₁₅ alkyl, C₂-C₁₅ alkenyl and C₂-C₁₅ alkynyl groups, with the alkyl groups being preferred. Suitable alkyl groups include methyl, ethyl, n-propyl, isopropyl, n-butyl, isobutyl, sec-butyl, n-pentyl, n-hexyl, n-heptyl, n-octyl, n-nonyl, n-decyl, n-undecyl, n-dodecyl, n-tridecyl, n-tetradecyl and n-pentadecyl. The fluorinated hydrocarbyl groups correspond to the foregoing hydrocarbyl groups in which some or all carbon-bonded hydrogen atoms are substituted by fluorine atoms.

In formula (D4), examples of the C₁-C₂₀ (k+1)-valent hydrocarbon group Z¹ include the foregoing C₁-C₂₀ alkyl groups and C₃-C₂₀ cyclic saturated hydrocarbyl groups, with k number of hydrogen atoms being eliminated. Examples of the C₁-C₂₀ (k+1)-valent fluorinated hydrocarbon group Z¹ include the foregoing (k+1)-valent hydrocarbon groups in which at least one hydrogen atom is substituted by fluorine.

Examples of the repeat units D1 to D4 are given below, but not limited thereto. Herein R^{B} is as defined above.

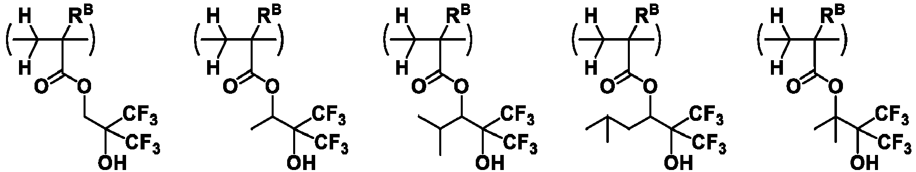

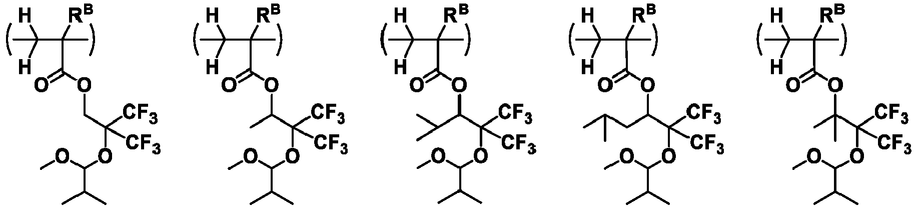

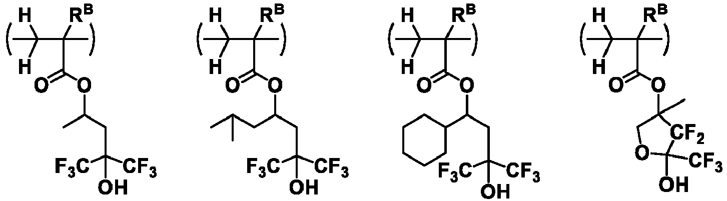

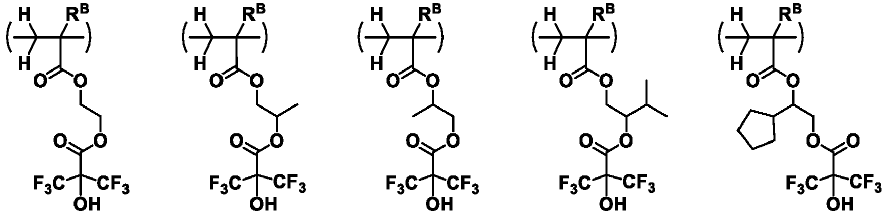

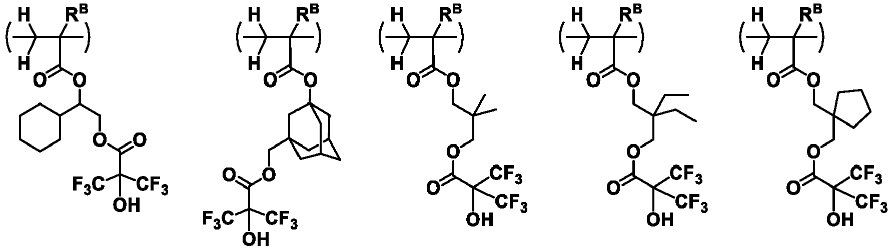

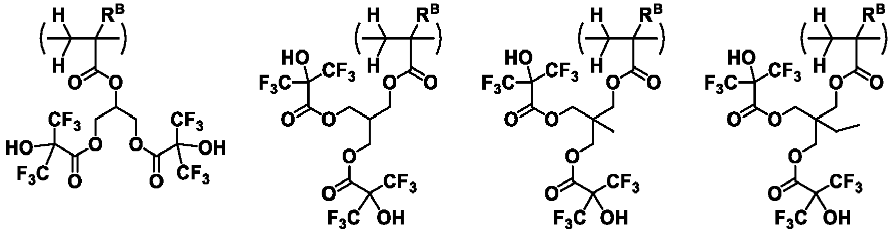

In formula (D5), examples of the C₁-C₅ hydrocarbyl groups R¹⁰⁹ and R¹¹⁰ include alkyl, alkenyl and alkynyl groups, with the alkyl groups being preferred. Suitable alkyl groups include methyl, ethyl, n-propyl, isopropyl, n-butyl, isobutyl, sec-butyl, and n-pentyl. In these groups, a moiety containing a heteroatom such as oxygen, sulfur or nitrogen may intervene in a carbon-carbon bond.

In formula (D5), -OR¹¹⁰ is preferably a hydrophilic group. In this case, R¹¹⁰ is preferably hydrogen or a C₁-C₅ alkyl group in which oxygen intervenes in a carbon-carbon bond.

In formula (D5), Z² is preferably *-C(=O)-O- or *-C(=O)-NH-. Also preferably R^{C} is methyl. The inclusion of carbonyl in Z² enhances the ability to trap the acid originating from the anti-charging film. A polymer wherein R^{C} is methyl is a robust polymer having a high glass transition temperature (Tg) which is effective for suppressing acid diffusion. As a result, the resist film is improved in stability with time, and neither resolution nor pattern profile is degraded.

Examples of the repeat unit D5 are given below, but not limited thereto. Herein R^{C} is as defined above.

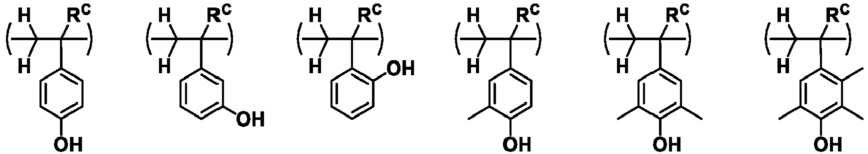

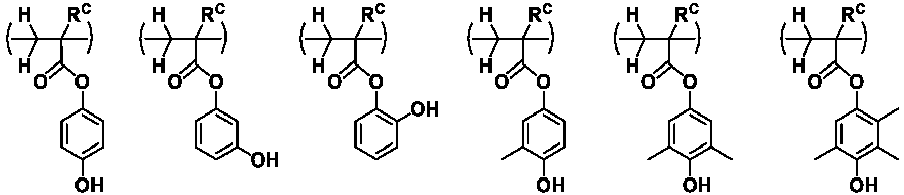

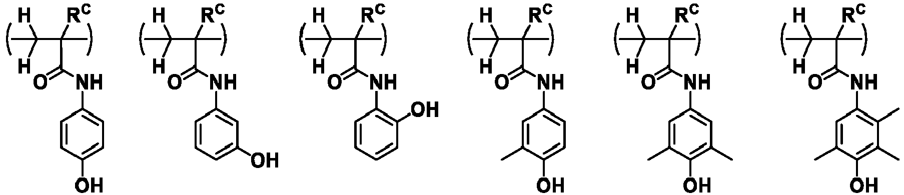

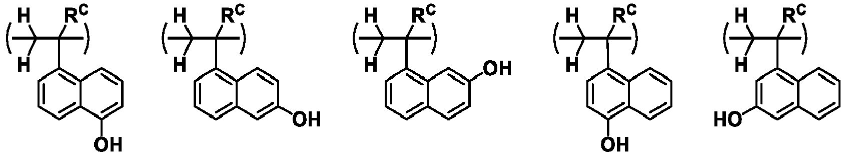

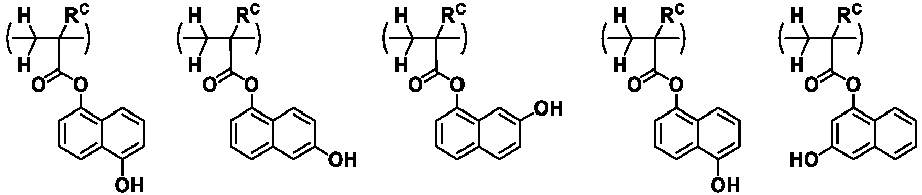

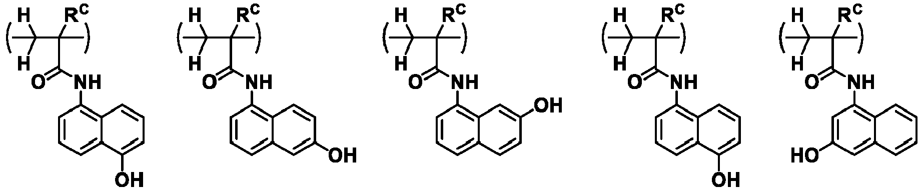

In formula (D6), the C₁-C₁₀ saturated hydrocarbylene group Z³ may be straight, branched or cyclic and examples thereof include methanediyl, ethane-1,1-diyl, ethane-1,2-diyl, propane-1,1-diyl, propane-1,2-diyl, propane-1,3-diyl, propane-2,2-diyl, butane-1,1-diyl, butane-1,2-diyl, butane-1,3-diyl, butane-2,3-diyl, butane-1,4-diyl, and 1,1-dimethylethane-1,2-diyl.

The C₁-C₂₀ saturated hydrocarbyl group having at least one hydrogen substituted by fluorine, represented by R¹¹¹, may be straight, branched or cyclic and examples thereof include C₁-C₂₀ alkyl groups and C₃-C₂₀ cyclic saturated hydrocarbyl groups in which at least one hydrogen is substituted by fluorine.

Examples of the repeat unit D6 are given below, but not limited thereto. Herein R^{C} is as defined above.

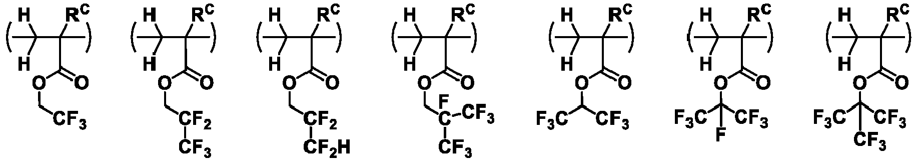

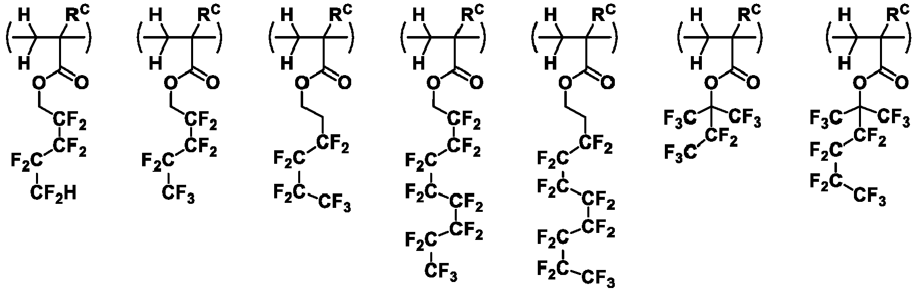

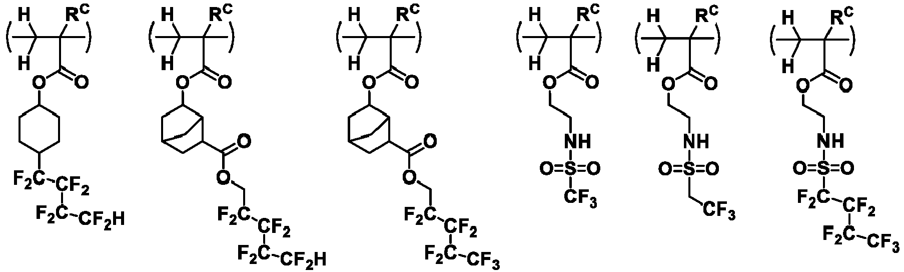

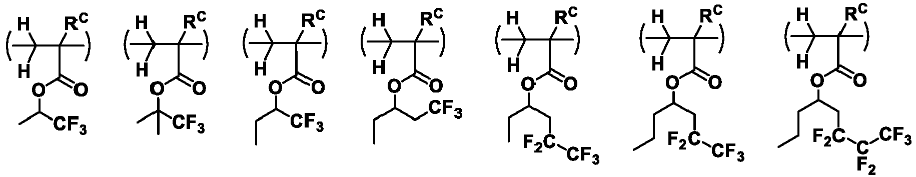

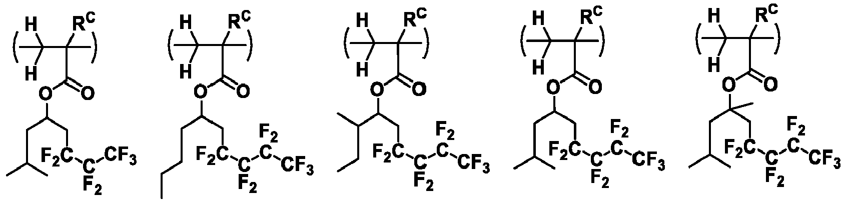

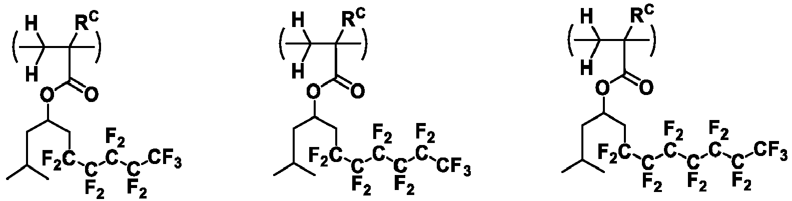

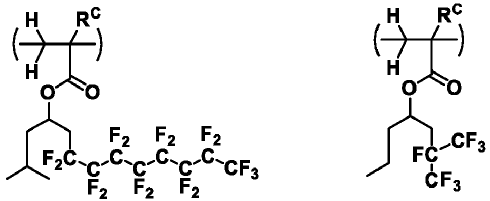

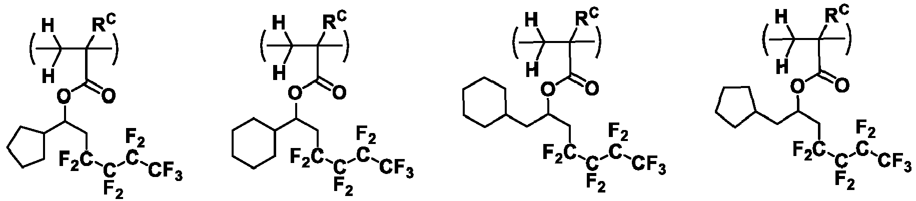

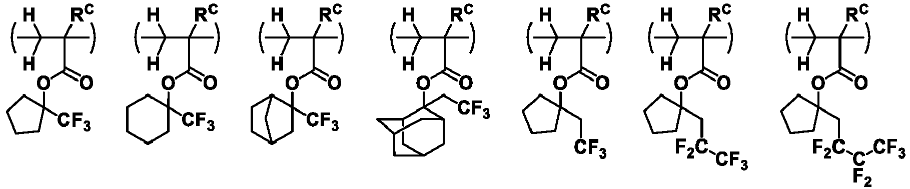

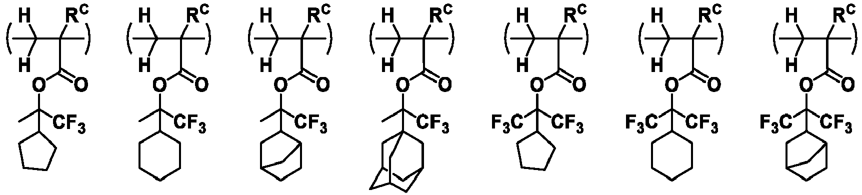

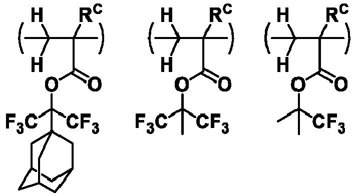

The repeat units D1 to D4 are preferably incorporated in an amount of 15 to 95 mol%, more preferably 20 to 85 mol% based on the overall repeat units of the fluorinated polymer. The repeat unit D5 and/or D6 is preferably incorporated in an amount of 5 to 85 mol%, more preferably 15 to 80 mol% based on the overall repeat units of the fluorinated polymer. Each of repeat units D1 to D6 may be used alone or in admixture.

The fluorinated polymer may comprise additional repeat units as well as the repeat units D1 to D6. Suitable additional repeat units include those described in USP 9,091,918 (JP-A 2014-177407, paragraphs [0046]-[0078]). When the fluorinated polymer comprises additional repeat units, their content is preferably up to 50 mol% based on the overall repeat units.

The fluorinated polymer may be synthesized by combining suitable monomers optionally protected with a protective group, copolymerizing them in the standard way, and effecting deprotection reaction if necessary. The copolymerization reaction is preferably radical or anionic polymerization though not limited thereto. For the polymerization reaction, reference may be made to JP-A 2004-115630.

The fluorinated polymer should preferably have a Mw of 2,000 to 50,000, and more preferably 3,000 to 20,000. A fluorinated polymer with a Mw of less than 2,000 helps acid diffusion, degrading resolution and detracting from age stability. A polymer with too high Mw has a reduced solubility in solvent, with a risk of leaving coating defects. The fluorinated polymer preferably has a dispersity (Mw/Mn) of 1.0 to 2.2, more preferably 1.0 to 1.7.

In the positive resist composition, the fluorinated polymer (D) is preferably used in an amount of 0.01 to 30 parts, more preferably 0.1 to 20 parts, even more preferably 0.5 to 10 parts by weight per 80 parts by weight of the base polymer (A). The fluorinated polymer may be used alone or in admixture.

### (E) Organic solvent

The chemically amplified positive resist composition may further comprise an organic solvent as component (E). The organic solvent used herein is not particularly limited as long as the components are soluble therein. Examples of the organic solvent are described in JP-A 2008-111103, paragraphs [0144] to [0145] (USP 7,537,880). Exemplary solvents include ketones such as cyclohexanone and methyl-2-n-pentyl ketone; alcohols such as 3-methoxybutanol, 3-methyl-3-methoxybutanol, 1-methoxy-2-propanol, 1-ethoxy-2-propanol, and diacetone alcohol; ethers such as propylene glycol monomethyl ether (PGME), ethylene glycol monomethyl ether, propylene glycol monoethyl ether, ethylene glycol monoethyl ether, propylene glycol dimethyl ether, and diethylene glycol dimethyl ether; esters such as propylene glycol monomethyl ether acetate (PGMEA), propylene glycol monoethyl ether acetate, ethyl lactate (EL), ethyl pyruvate, butyl acetate, methyl 3-methoxypropionate, ethyl 3-ethoxypropionate, t-butyl acetate, t-butyl propionate, and propylene glycol mono-t-butyl ether acetate; and lactones such as γ-butyrolactone (GBL), and mixtures thereof. Where an acid labile group of acetal form is used, a high boiling alcohol solvent such as diethylene glycol, propylene glycol, glycerol, 1,4-butanediol or 1,3-butanediol may be added to accelerate deprotection reaction of acetal.

Of the above organic solvents, it is recommended to use 1-ethoxy-2-propanol, PGMEA, PGME, cyclohexanone, EL, GBL, and mixtures thereof.

In the positive resist composition, the organic solvent (E) is preferably used in an amount of 200 to 10,000 parts, more preferably 400 to 5,000 parts by weight per 80 parts by weight of the base polymer (A). The organic solvent may be used alone or in admixture.

### (F) Surfactant

The positive resist composition may contain any conventional surfactants for facilitating to coat the composition to the substrate. A number of surfactants are known in the art as described in JP-A 2004-115630, and any suitable one may be chosen therefrom. The amount of the surfactant (F) added is preferably 0 to 5 parts by weight per 80 parts by weight of the base polymer (A). The surfactant may be used alone or in admixture. In the embodiment wherein the resist composition contains the fluorinated polymer, which also plays the role of surfactant, the surfactant may be omitted.

The positive resist composition may be prepared by dissolving components (A) to (C) and optionally components (D) and (F) in the organic solvent as component (E) simultaneously or in an arbitrary order to form a uniform resist solution. The resist solution is preferably filtered. By passing the resist solution through a filter of nylon or polyethylene (PE), gel components and particles are effectively removed from the resist solution. A filter having a pore size of up to 20 nm is preferably used to ensure the quality for the lithography of the advanced generation.

From the standpoint of improving the develop loading effect, the chemically amplified positive resist composition is preferably designed such that a resist film formed therefrom in an exposed region may have a dissolution rate in alkaline developer of at least 50 nm/sec, more preferably at least 80 nm/sec. As long as the dissolution rate is at least 50 nm/sec, the resist film is uniformly dissolved in alkaline developer independent of a pattern layout difference in the case of a grouped/isolated pattern, and the variation of line width can be minimized. It is noted that the dissolution rate of an exposed region is computed by spin coating the positive resist composition onto a 8-inch silicon wafer, baking at 110°C for 60 seconds to form a resist film of 90 nm thick, exposing the resist film to KrF excimer laser radiation in a sufficient energy dose to complete deprotection reaction on the polymer, baking at 110°C for 60 seconds, developing the film in a 2.38 wt% TMAH aqueous solution at 23°C, and measuring a loss of film thickness by means of a resist development analyzer.

Also preferably, the resist film formed from the positive resist composition in an unexposed region has a dissolution rate in alkaline developer of up to 10 nm/min, more preferably up to 9 nm/min, even more preferably up to 8 nm/min. Where the resist film is in the thin film range of up to 100 nm, the influence of pattern film thickness loss in alkaline developer becomes greater. If the dissolution rate in unexposed region is more than 10 nm/min, pattern collapse will occur, failing to form a small size pattern. The problem becomes outstanding in the fabrication of photomasks requiring to be defectless and having a tendency of strong development process. It is noted that the dissolution rate of an unexposed region is computed by spin coating the positive resist composition onto a 6-inch silicon wafer, baking at 110°C for 240 seconds to form a resist film of 80 nm thick, developing the film in a 2.38 wt% TMAH aqueous solution at 23°C for 80 seconds, and measuring a loss of film thickness.

### Process

Another embodiment of the invention is a resist pattern forming process comprising the steps of applying the chemically amplified positive resist composition defined above onto a substrate to form a resist film thereon, exposing the resist film patternwise to EB, and developing the exposed resist film in an alkaline developer to form a resist pattern.

The substrate used herein may be selected from, for example, substrates for IC fabrication, e.g., Si, SiO, SiO₂, SiN, SiON, TiN, WSi, BPSG, SOG, and organic antireflective coating, and substrates for mask circuit fabrication, e.g., Cr, CrO, CrON, MoSi₂, Si, SiO, SiO₂, SiON, SiONC, CoTa, NiTa, TaBN, and SnO₂.

First the resist composition is applied onto a substrate by a suitable coating technique such as spin coating. The coating is prebaked on a hotplate preferably at a temperature of 60 to 150°C for 1 to 20 minutes, more preferably at 80 to 140°C for 1 to 10 minutes to form a resist film of 0.03 to 2 µm thick.

Then the resist film is exposed to a pattern of EB. For the energy of EB, a pattern is preferably written in a dose of 50 to 400 µC/cm².

The exposure may be performed by conventional lithography whereas the immersion lithography of holding a liquid, typically water between the mask and the resist film may be employed if desired. In the immersion lithography, a protective film which is insoluble in water may be used.

The resist film is then baked (PEB) on a hotplate preferably at 60 to 150°C for 1 to 20 minutes, more preferably at 80 to 140°C for 1 to 10 minutes.

Thereafter, the resist film is developed with a developer in the form of an aqueous base solution, for example, 0.1 to 5 wt%, preferably 2 to 3 wt% aqueous solution of tetramethylammonium hydroxide (TMAH) preferably for 0.1 to 3 minutes, more preferably 0.5 to 2 minutes by conventional techniques such as dip, puddle and spray techniques. In this way, a desired resist pattern is formed on the substrate.

From the positive resist composition, a pattern with a satisfactory isolated-space resolution and reduced LER can be formed. The resist composition is effectively applicable to a substrate, specifically a substrate having a surface layer of material to which a resist film is less adherent and which is likely to invite pattern stripping or pattern collapse, and particularly a substrate having sputter deposited on its outermost surface metallic chromium or a chromium compound containing at least one light element selected from oxygen, nitrogen and carbon or a substrate having an outermost surface layer of SiO, SiOₓ, or a tantalum compound, molybdenum compound, cobalt compound, nickel compound, tungsten compound or tin compound. The substrate to which the positive resist composition is applied is most typically a photomask blank which may be either of transmission or reflection type.

The mask blank of transmission type is typically a photomask blank having a light-shielding film of chromium-based material. It may be either a photomask blank for binary masks or a photomask blank for phase shift masks. In the case of the binary mask-forming photomask blank, the light-shielding film may include an antireflection layer of chromium-based material and a light-shielding layer. In one example, the antireflection layer on the surface layer side is entirely composed of a chromium-based material. In an alternative example, only a surface side portion of the antireflection layer on the surface layer side is composed of a chromium-based material and the remaining portion is composed of a silicon compound-based material which may contain a transition metal. In the case of the phase shift mask-forming photomask blank, it may include a phase shift film and a chromium-based light-shielding film thereon.

Photomask blanks having an outermost layer of chromium base material are well known as described in JP-A 2008-026500 and JP-A 2007-302873 and the references cited therein. Although the detail description is omitted herein, the following layer construction may be employed when a light-shielding film including an antireflective layer and a light-shielding layer is composed of chromium base materials.

In the example where a light-shielding film including an antireflective layer and a light-shielding layer is composed of chromium base materials, layers may be stacked in the order of an antireflective layer and a light-shielding layer from the outer surface side, or layers may be stacked in the order of an antireflective layer, a light-shielding layer, and an antireflective layer from the outer surface side. Each of the antireflective layer and the light-shielding layer may be composed of multiple sub-layers. When the sub-layers have different compositions, the composition may be graded discontinuously or continuously from sub-layer to sub-layer. The chromium base material used herein may be metallic chromium or a material consisting of metallic chromium and a light element such as oxygen, nitrogen or carbon. Examples used herein include metallic chromium, chromium oxide, chromium nitride, chromium carbide, chromium oxynitride, chromium oxycarbide, chromium nitride carbide, and chromium oxide nitride carbide.

The mask blank of reflection type includes a substrate, a multilayer reflective film formed on one major surface (front surface) of the substrate, for example, a multilayer reflective film of reflecting exposure radiation such as EUV radiation, and an absorber film formed on the multilayer reflective film, for example, an absorber film of absorbing exposure radiation such as EUV radiation to reduce reflectivity. From the reflection type mask blank (reflection type mask blank for EUV lithography), a reflection type mask (reflection type mask for EUV lithography) having an absorber pattern (patterned absorber film) formed by patterning the absorber film is produced. The EUV radiation used in the EUV lithography has a wavelength of 13 to 14 nm, typically about 13.5 nm.

The multilayer reflective film is preferably formed contiguous to one major surface of a substrate. An underlay film may be disposed between the substrate and the multilayer reflective film as long as the benefits of the invention are not lost. The absorber film may be formed contiguous to the multilayer reflective film while a protective film (protective film for the multilayer reflective film) may be disposed between the multilayer reflective film and the absorber film, preferably contiguous to the multilayer reflective film, more preferably contiguous to the multilayer reflective film and the absorber film. The protective film is used for protecting the multilayer reflective film in a cleaning, tailoring or otherwise processing step. Also preferably, the protective film has an additional function of protecting the multilayer reflective film or preventing the multilayer reflective film from oxidation during the step of patterning the absorber film by etching. Besides, an electroconductive film, which is used for electrostatic chucking of the reflection type mask to an exposure tool, may be disposed below the other major surface (back side surface) which is opposed to the one major surface of the substrate, preferably contiguous to the other major surface. It is provided herein that a substrate has one major surface which is a front or upper side surface and another major surface which is a back or lower side surface. The terms "front and back" sides or "upper and lower" sides are used for the sake of convenience. One or another major surface may be either of the two major surfaces (film-bearing surfaces) of a substrate, and in this sense, front and back or upper and lower are exchangeable. Specifically, the multilayer reflective film may be formed by any of the methods of JP-A 2021-139970 and the references cited therein.

The resist pattern forming process is successful in forming patterns having a high resolution, suppressed influences of develop loading and residue defects, and a small size difference independent of pattern density (grouped and isolated patterns), even on a substrate (typically mask blank of transmission or reflection type) whose outermost surface is made of a material tending to affect resist pattern profile such as a chromium, silicon or tantalum-containing material.

### EXAMPLES

Examples of the invention are given below by way of illustration and not by way of limitation. The abbreviation "pbw" is parts by weight. For copolymers, the compositional ratio is a molar ratio and Mw is determined by GPC versus polystyrene standards.

### [1] Synthesis of polymer

### Synthesis Example

### Synthesis of Polymer P-1

In nitrogen atmosphere, a 100-ml flask was charged with 20 g of a polyhydroxystyrene-acenaphthylene copolymer and 46.7 g of tetrahydrofuran (THF) solvent. To the solution at ~25°C, 0.5 g of methanesulfonic acid was added and 4.4 g of 1-methoxy-2-methylpropene was then added dropwise. The solution was kept at room temperature for 4.5 hours for reaction. At the end of reaction, 1.0 g of triethylamine was added to the reaction solution, which was added dropwise to 500 g of hexane for precipitation. The copolymer precipitate was collected by filtration. The copolymer precipitate was washed twice with 120 g of hexane. The copolymer was dissolved in a mixture of 60 g of ethyl acetate and 20 g of water. The solution was transferred to a separatory funnel, to which 0.7 g of acetic acid was added, followed by separatory operation. After the lower layer was removed, 20 g of water and 0.9 g of pyridine were added to the organic layer, and separatory operation was performed. This was followed by the steps of removing the lower layer, adding 20 g of water to the organic layer, water washing and performing separatory operation. The cycle of water washing and separatory operation was repeated 5 times in total. After the separatory operation, the organic layer was concentrated and dissolved in 40 g of PGME. The solution was added dropwise to 600 g of water for crystallization. The crystal settlement was collected by filtration, washed with water and dried. There was obtained 20.3 g of Polymer P-1 as white polymer. The polymer was analyzed by ¹H-NMR, ¹³C-NMR and GPC, with the results shown below.

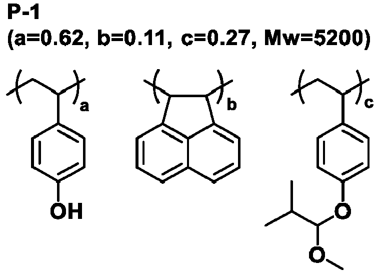

Polymers P-2 to P-17 and Comparative Polymers cP-1 to cP-6 and AP-1 to AP-6 were synthesized by the same procedure as the above Synthesis Example or any well-known method except that the type and amount (mol%) of monomers were changed.

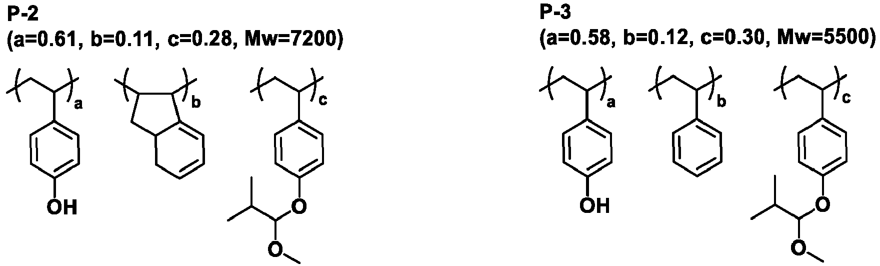

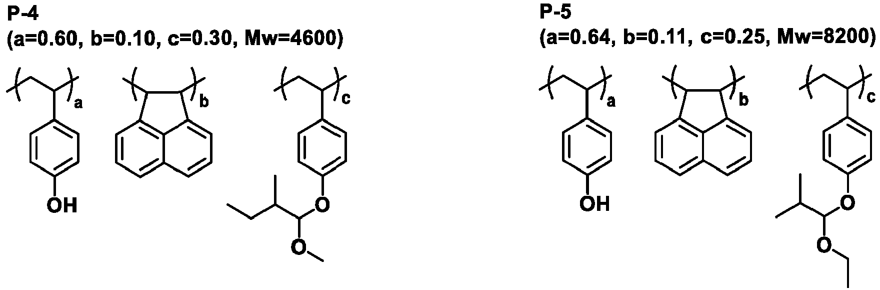

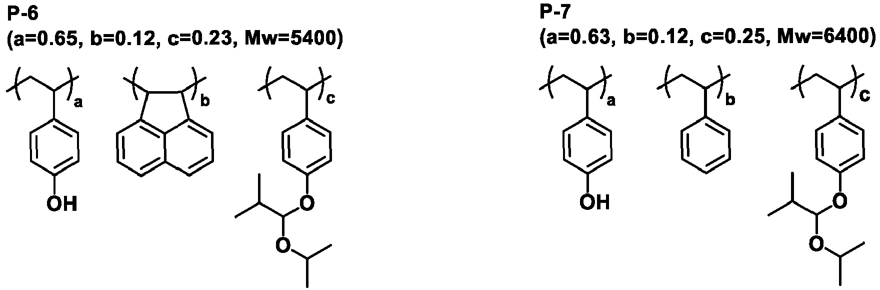

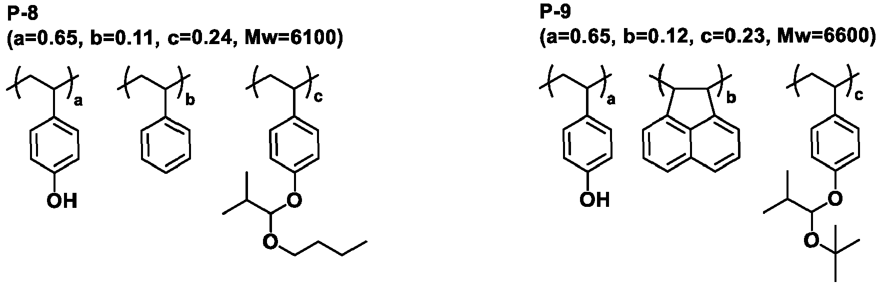

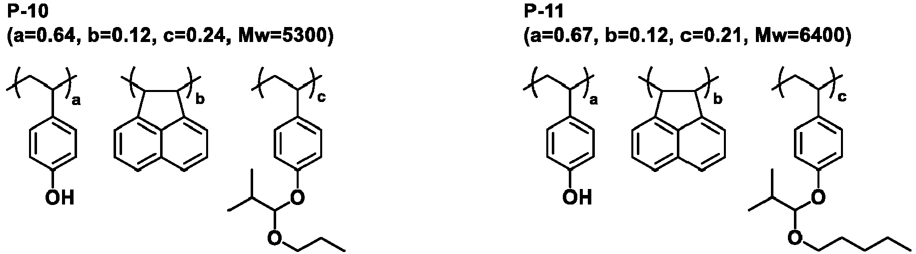

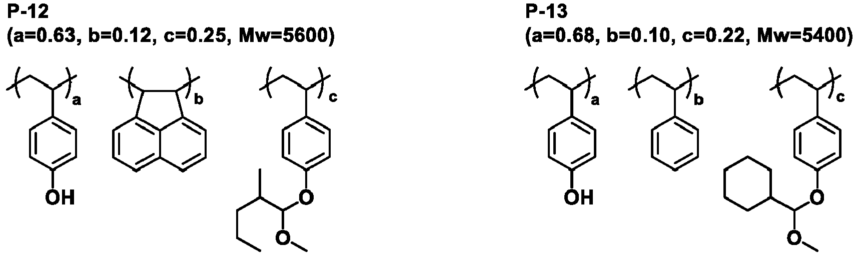

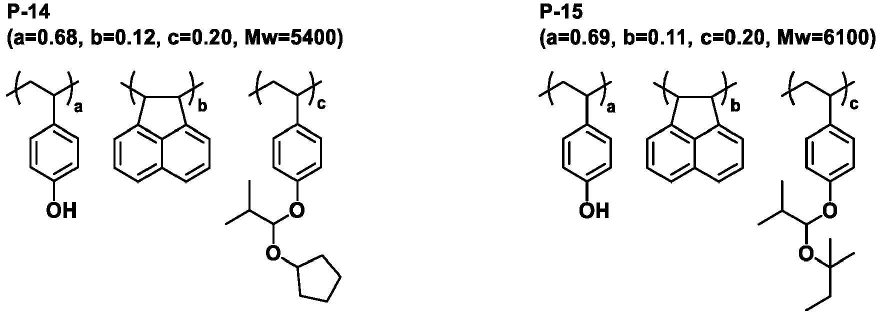

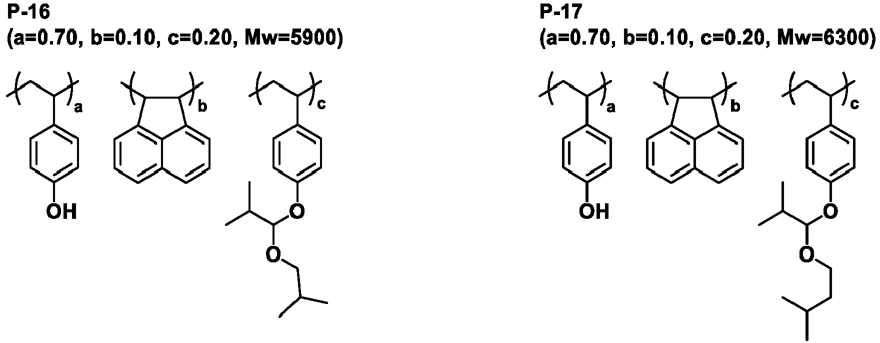

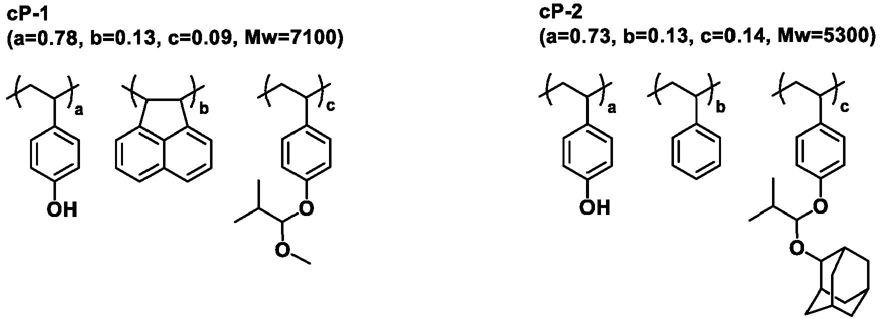

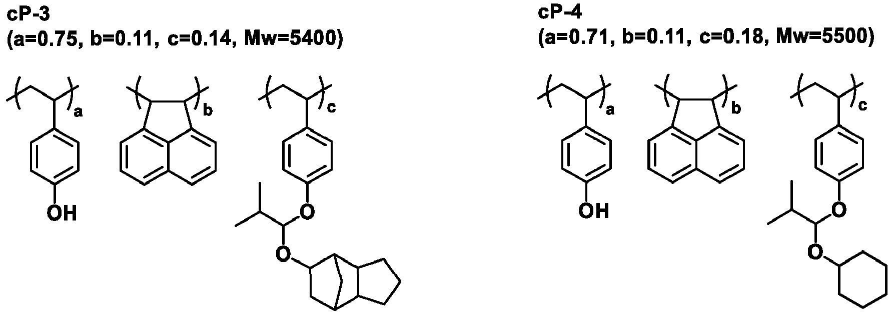

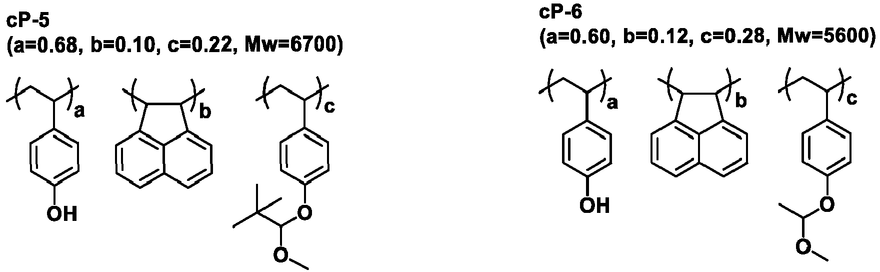

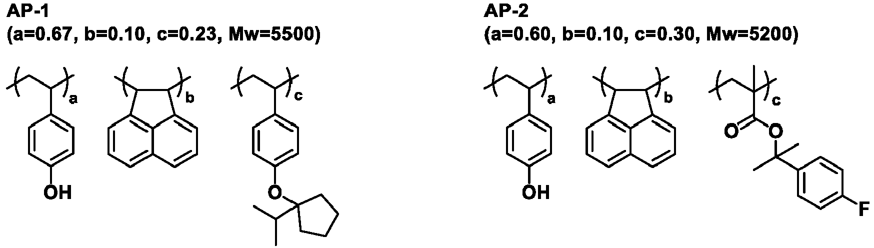

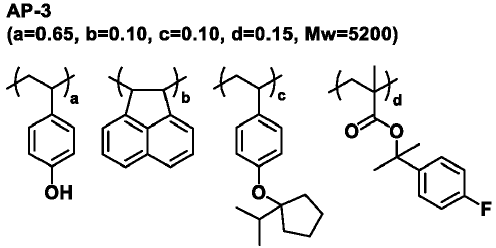

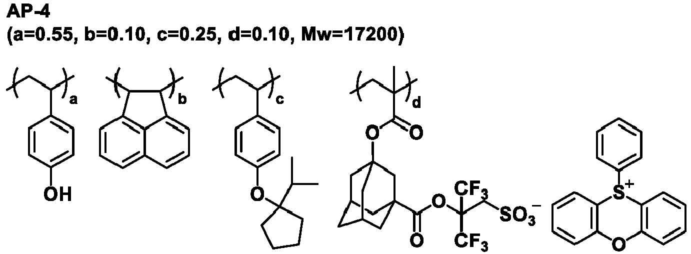

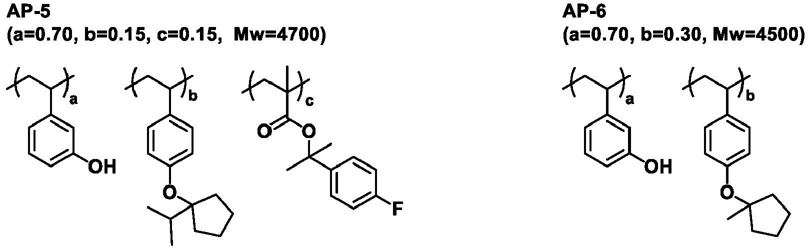

The dissolution rate of a polymer in alkaline developer was computed by spin coating a 16.7 wt% solution of the polymer in propylene glycol monomethyl ether acetate (PGMEA) solvent onto a 8-inch silicon wafer, baking at 100°C for 90 seconds to form a film of 1,000 nm thick, developing the film in a 2.38 wt% aqueous solution of tetramethylammonium hydroxide (TMAH) at 23°C for 100 seconds, and measuring a loss of film thickness. Polymers P-1 to P-17, AP-1 to AP-6, cP-2 to cP-6 showed a dissolution rate of up to 5 nm/min. Polymer cP-1 showed a dissolution rate of 14 nm/min.

### [2] Preparation of chemically amplified positive resist compositions

### Examples 1-1 to 1-37 and Comparative Examples 1-1 to 1-7

Positive resist compositions were prepared by dissolving selected components in an organic solvent in accordance with the formulation shown in Tables 1 to 3, and filtering the solution through a nylon filter with a pore size of 5 nm and a UPE filter with a pore size of 1 nm. The organic solvent was a mixture of 940 pbw of PGMEA, 1,870 pbw of EL, and 1,870 pbw of PGME.

The dissolution rate of the resist composition in alkaline developer was computed by spin coating the resist composition onto a 8-inch silicon wafer, baking at 110°C for 240 seconds to form a resist film of 80 nm thick, developing the film in a 2.38 wt% TMAH aqueous solution at 23°C for 80 seconds, and measuring a loss of film thickness. The resist films obtained from resist compositions R-1 to R-37, CR-1 and CR-3 to CR-7 showed a dissolution rate of up to 10 nm/min. The resist film obtained from resist composition CR-2 showed a dissolution rate of 17 nm/min.

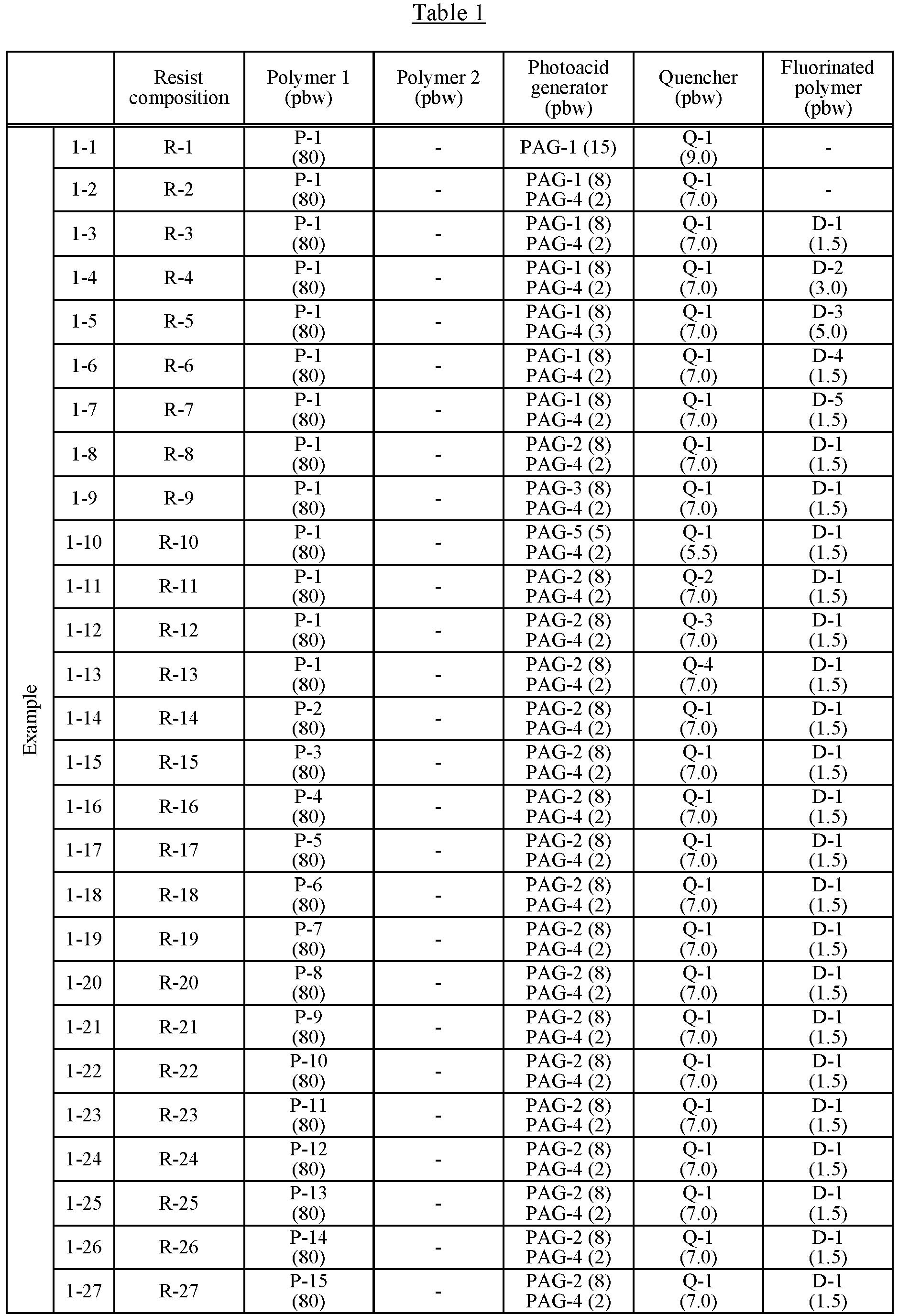

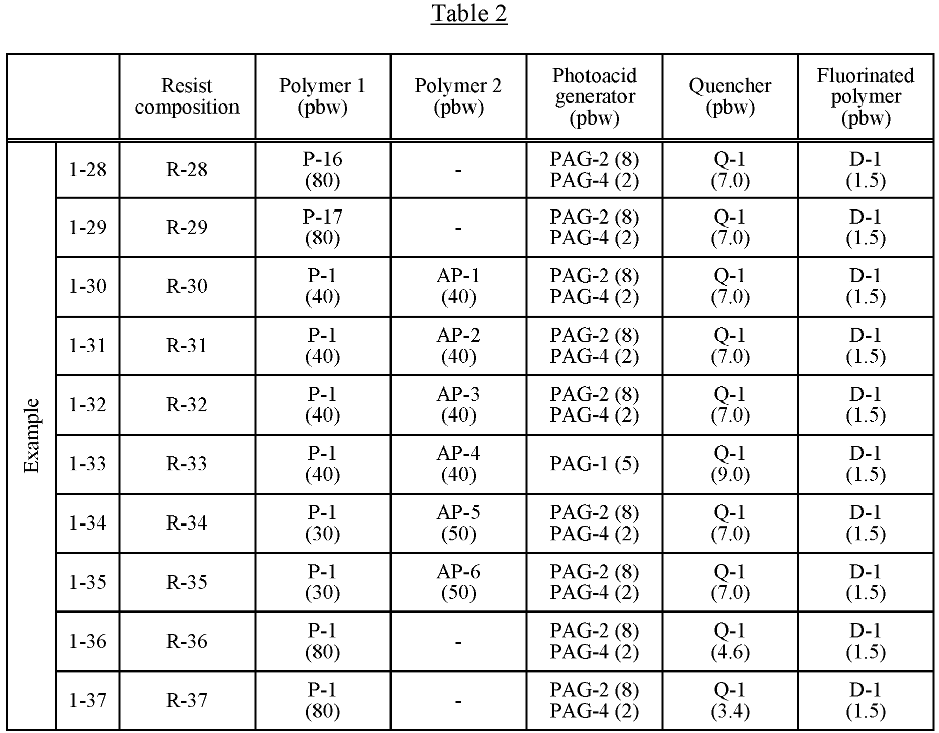

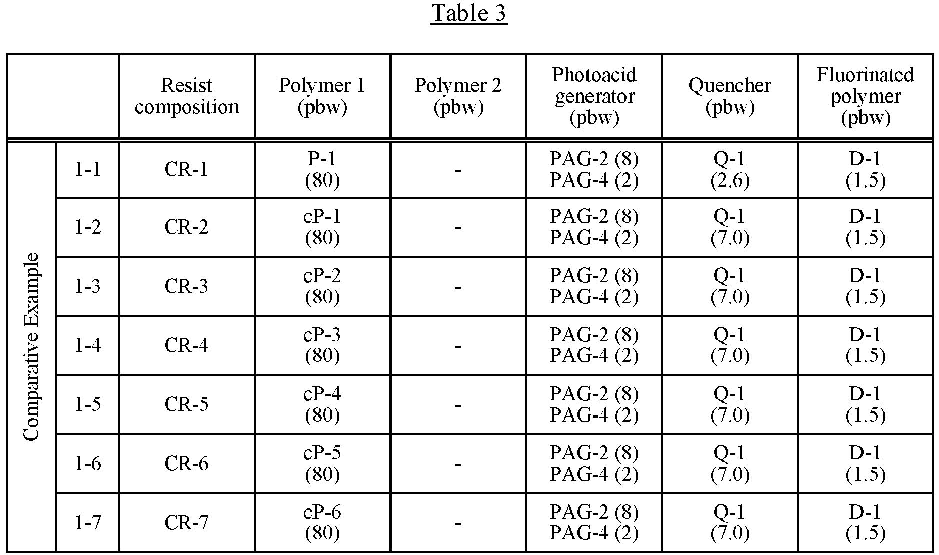

In Tables 1 to 3, photoacid generators PAG-1 to PAG-5, quenchers Q-1 to Q-4, and fluorinated polymers D-1 to D-5 have the structures shown below.

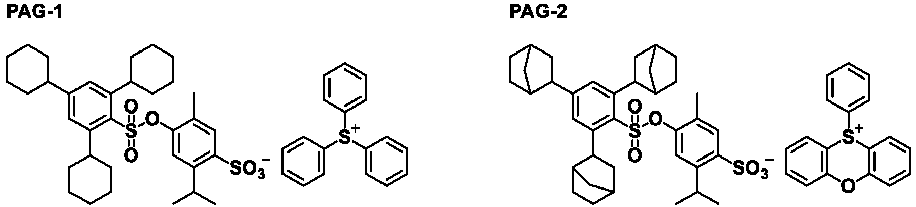

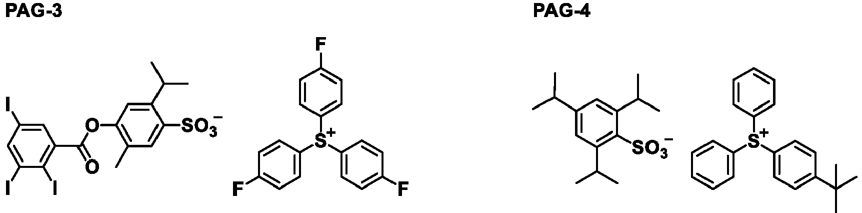

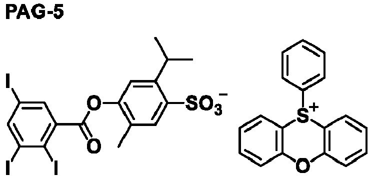

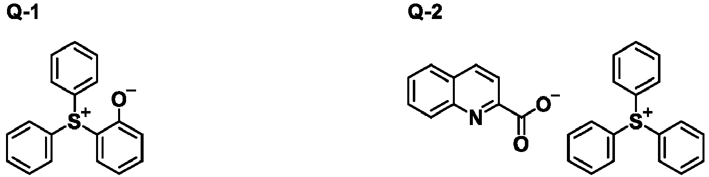

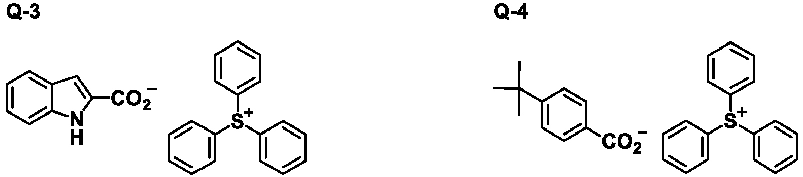

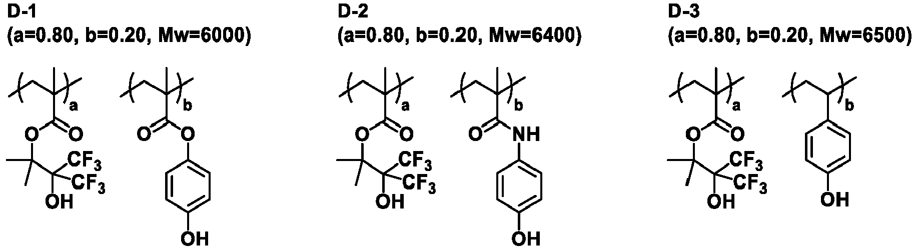

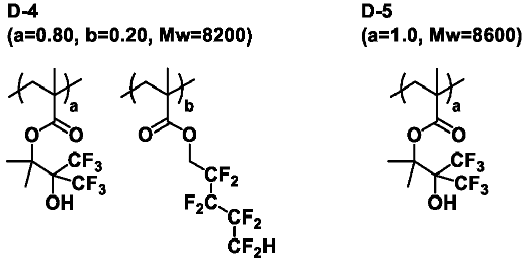

### [3] EB lithography test

### Examples 2-1 to 2-37 and Comparative Examples 2-1 to 2-7

Using a coater/developer system ACT-M (Tokyo Electron Ltd.), each of the resist compositions (R-1 to R-37, CR-1 to CR-7) was spin coated onto a photomask blank of reflection type for an EUV lithography mask (which was a low-coefficient-of-thermal-expansion glass substrate of 6 inches squares having deposited thereon a multilayer reflective film of 40 Mo/Si layers with a thickness of 284 nm, a Ru film of 3.5 nm thick as protective film, a TaN film of 70 nm thick as absorbing layer, and a CrN film of 6 nm thick as hard mask), and prebaked on a hotplate at 110°C for 600 seconds to form a resist film of 80 nm thick. The thickness of the resist film was measured by an optical film thickness measurement system Nanospec (Nanometrics Inc.). Measurement was made at 81 points in the plane of the blank substrate excluding a peripheral band extending 10 mm inward from the blank periphery, and an average film thickness and a film thickness range were computed therefrom.

The resist film was exposed to EB using an EB writer system EBM-5000Plus (NuFlare Technology Inc., accelerating voltage 50 kV), then baked (PEB) at 110°C for 600 seconds, and developed in a 2.38 wt% TMAH aqueous solution, thereby yielding a positive pattern.

The resist pattern was evaluated as follows. The patterned mask blank was observed under a top-down scanning electron microscope (TD-SEM). The optimum dose (Eop) was defined as the exposure dose (µC/cm²) which provided a 1:1 resolution at the top and bottom of a 200-nm 1:1 line-and-space (LS) pattern. The resolution (or maximum IS resolution) was defined as the minimum size at the dose which provided a 9:1 resolution for an isolated space (IS) of 200 nm. The edge roughness (LER) of a 200-nm LS pattern was measured under SEM. The develop loading was evaluated by forming a 200-nm LS pattern at the dose (µC/cm²) capable of resolving a 1:1 LS pattern of 200 nm design at a ratio 1:1 and a 200-nm LS pattern including dummy patterns having a density of 15%, 25%, 33%, 45%, 50%, 55%, 66%, 75%, 85%, and 95% arranged around the center pattern, measuring the size of spaces under SEM, and comparing the size difference among grouped and isolated patterns. Also, the pattern was visually observed to judge whether or not the profile was rectangular.

The dissolution rate of an exposed region is computed by spin coating the resist solution onto a 8-inch silicon wafer, baking at 110°C for 60 seconds to form a resist film of 90 nm thick, exposing the resist film to KrF excimer laser radiation in a dose (mJ/cm²) capable of resolving a 200-nm 1: 1 LS pattern at a ratio 1: 1, baking at 110°C for 60 seconds, developing the film in a 2.38 wt% TMAH aqueous solution at 23°C, and measuring a loss of film thickness by means of a resist development rate analyzer (RDA-800 by Litho Tech Japan Corp.). The results are shown in Tables 4 and 5.

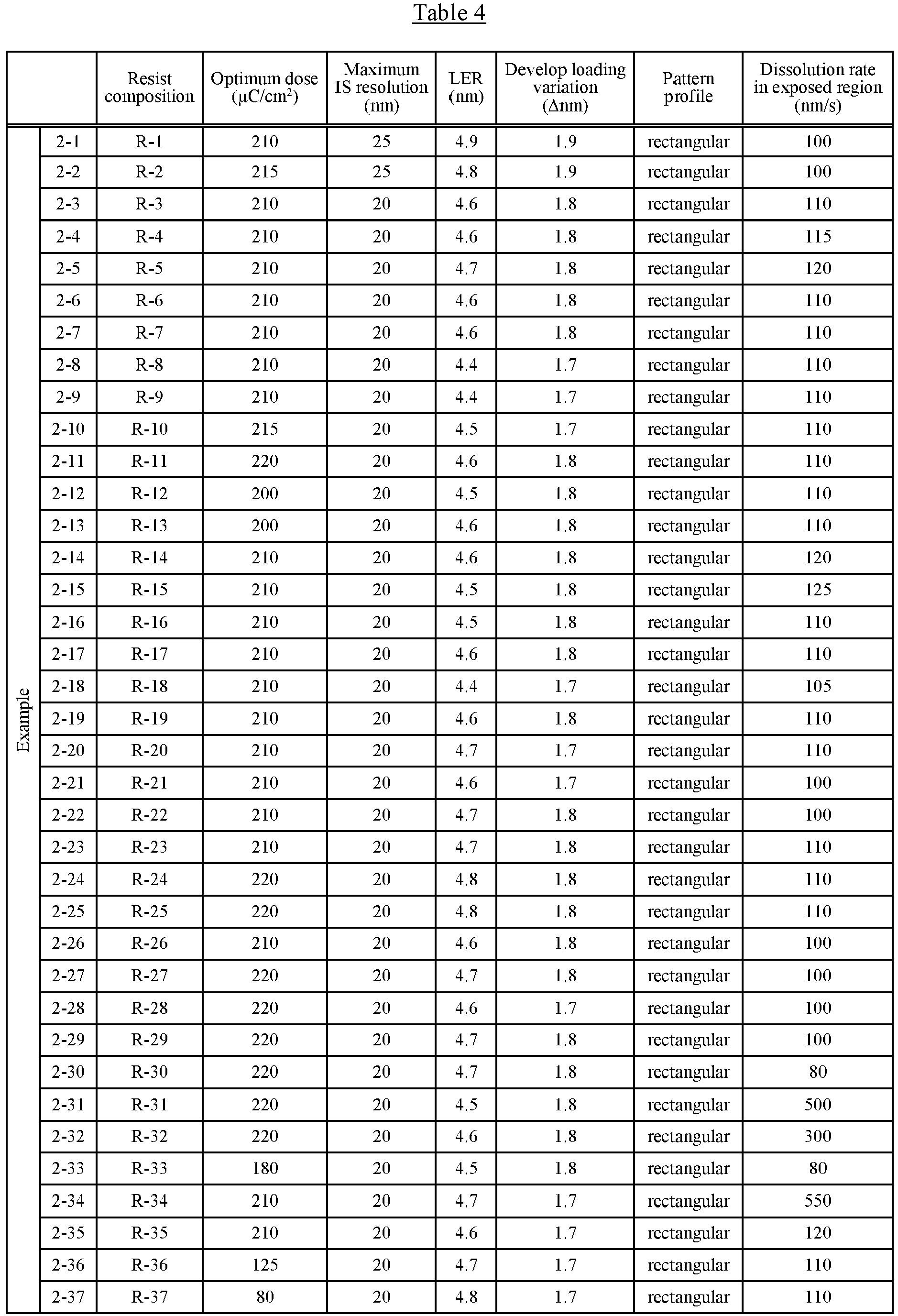

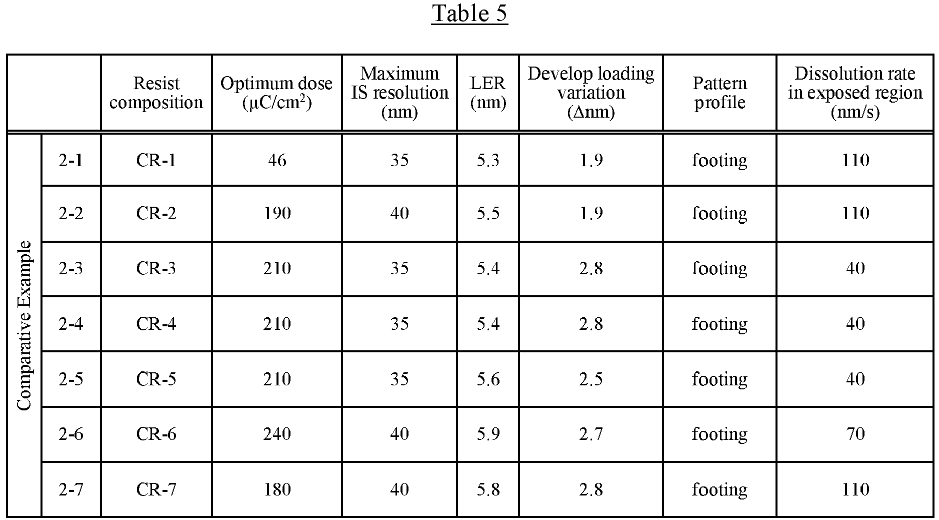

### [4] Evaluation of residue defects

### Examples 3-1 to 3-6 and Comparative Examples 3-1 to 3-5

As above, each of the resist compositions (R-8, R-21, R-26, R-29, R-31, R-33, CR-1, CR-3 to CR-6) was applied onto a photomask blank of reflection type for an EUV lithography mask to form a resist film of 80 nm thick. The resist film was exposed over its entire surface to EB in its optimum dose using an EB writer system EBM-5000Plus (NuFlare Technology Inc., accelerating voltage 50 kV), then baked (PEB) at 110°C for 600 seconds, and developed in a 2.38 wt% TMAH aqueous solution, thereby yielding a positive pattern. Using a mask defect inspection system M9650 (Laser Tech), development residues were evaluated. The total number of defects after development is shown in Table 6.

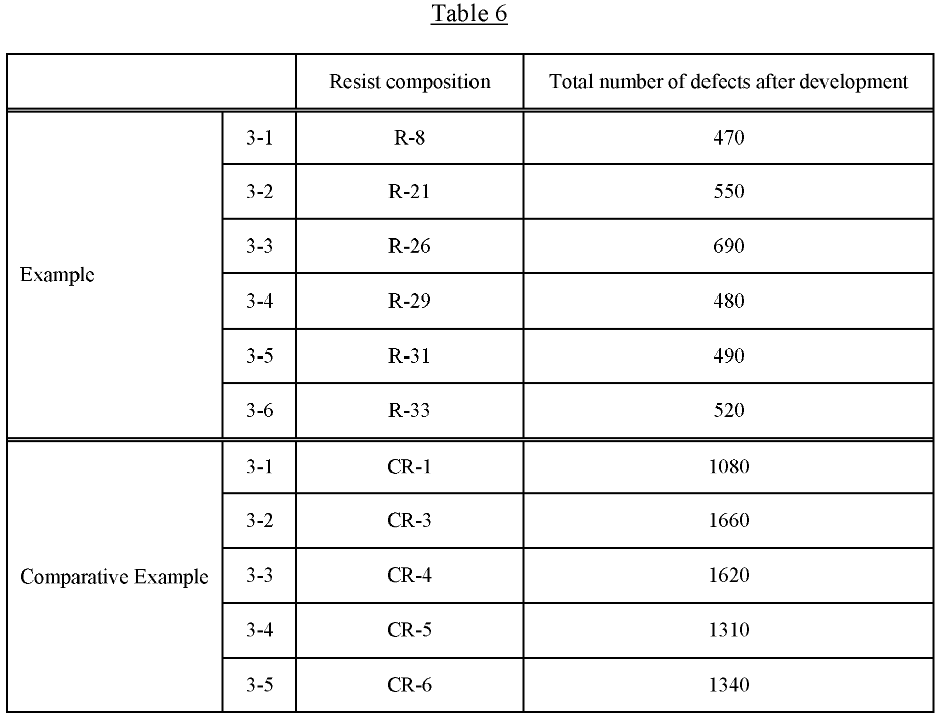

All the chemically amplified positive resist compositions (R-1 to R-37) within the scope of the invention show satisfactory isolated-space resolution, LER and pattern rectangularity and reduced values of develop loading. Of comparative resist compositions (CR-1 to CR-5), CR-1 formed a pattern of footing profile with degraded resolution because the energy amount was not optimum in a sensitivity region of up to 50 µC/cm². CR-2 formed a pattern of rounded head profile with degraded resolution because the dissolution rate in unexposed region of the polymer was high. CR-3 to CR-7 formed patterns having unsatisfactory isolated-space resolution, LER, and rectangularity because the design of base polymer was insufficient. With respect to the residue defect evaluation, CR-1 and CR-3 to CR-6 were insufficient.

Since the positive resist composition of the invention is designed such that the base polymer has a specific acetal type acid labile group and the PAG and the quencher are present in a controlled weight ratio, a pattern having satisfactory isolated-space resolution, profile, and LER and minimized influences of develop loading and residue defects can be formed even in high dose regions. The resist pattern forming process using the positive resist composition is effective in photolithography for the fabrication of semiconductor devices and the processing of photomask blanks of transmission and reflection types.

## Claims

1. A chemically amplified positive resist composition adapted for EB lithography comprising (A) a base polymer, (B) a photoacid generator, and (C) a quencher,
the base polymer (A) containing a polymer comprising phenolic hydroxy group-containing units having the formula (A1), aromatic ring-containing units having any one of the formulae (A2) to (A4), and units containing a phenolic hydroxy group protected with an acid labile group, having the formula (A5), all the repeat units of the polymer having an aromatic ring structure, 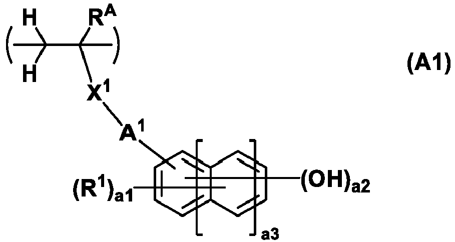 wherein a1 is an integer meeting 0 ≤ a1 ≤ 5+2a3-a2, a2 is an integer of 1 to 3, a3 is an integer of 0 to 2,
R^{A} is hydrogen, fluorine, methyl or trifluoromethyl,
X¹ is a single bond, *-C(=O)-O- or *-C(=O)-NH-, * designates a point of attachment to the carbon atom in the backbone,
A¹ is a single bond or a C₁-C₁₀ saturated hydrocarbylene group in which some -CH₂-may be replaced by -O-,
R¹ is halogen, optionally halogenated C₂-C₈ saturated hydrocarbylcarbonyloxy group, optionally halogenated C₁-C₆ saturated hydrocarbyl group or optionally halogenated C₁-C₆ saturated hydrocarbyloxy group, 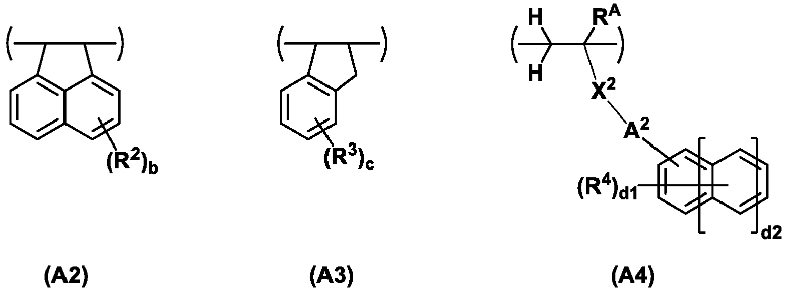 wherein R^{A} is as defined above,
b and c are each independently an integer of 0 to 4, d1 is an integer of 0 to 5, d2 is an integer of 0 to 2,
X² is a single bond, *-C(=O)-O- or *-C(=O)-NH-, * designates a point of attachment to the carbon atom in the backbone,
A² is a single bond or a C₁-C₁₀ saturated hydrocarbylene group in which some -CH₂-may be replaced by -O-,
R² and R³ are each independently hydroxy, halogen, optionally halogenated C₂-C₈ saturated hydrocarbylcarbonyloxy group, optionally halogenated C₁-C₈ saturated hydrocarbyl group or optionally halogenated C₁-C₈ saturated hydrocarbyloxy group,
R⁴ is an acetyl group, C₁-C₂₀ saturated hydrocarbyl group, C₁-C₂₀ saturated hydrocarbyloxy group, C₂-C₂₀ saturated hydrocarbylcarbonyloxy group, C₂-C₂₀ saturated hydrocarbyloxyhydrocarbyl group, C₂-C₂₀ saturated hydrocarbylthiohydrocarbyl group, halogen, nitro group, or cyano group, R⁴ may be hydroxy in case of d2=1 or 2, 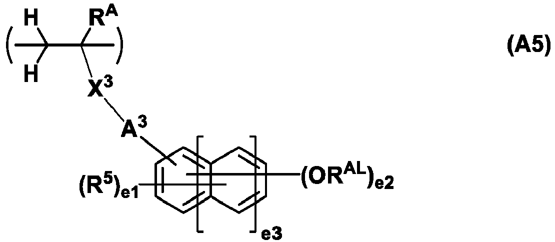 wherein R^{A} is as defined above,
e1 is an integer meeting 0 ≤ e1 ≤ 5+2e3-e2, e2 is an integer of 1 to 3, e3 is an integer of 0 to 2,
X³ is a single bond, *-C(=O)-O- or *-C(=O)-NH-, * designates a point of attachment to the carbon atom in the backbone,
A³ is a single bond or a C₁-C₁₀ saturated hydrocarbylene group in which some -CH₂-may be replaced by -O-,
R⁵ is halogen, optionally halogenated C₂-C₈ saturated hydrocarbylcarbonyloxy group, optionally halogenated C₁-C₆ saturated hydrocarbyl group or optionally halogenated C₁-C₆ saturated hydrocarbyloxy group,
in case of e2=1, R^{AL} is an acetal type acid labile group having the formula (A5-1): 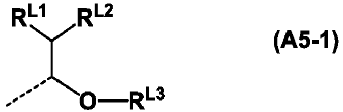 wherein R^{L1} and R^{L2} are each independently a C₁-C₃ saturated hydrocarbyl group, R^{L1} and R^{L2} may bond together to form a ring with the carbon atom to which they are attached, R^{L3} is a C₁-C₅ hydrocarbyl group, the broken line designates a point of attachment,
in case of e2 ≥ 2, R^{AL} is hydrogen or an acetal type acid labile group having formula (A5-1), at least one R^{AL} being an acetal type acid labile group having formula (A5-1),
the photoacid generator (B) and the quencher (C) being present in a weight ratio (B)/(C) of less than 3/1.

2. The resist composition of claim 1 wherein the phenolic hydroxy group-containing units have the formula (A1-1): 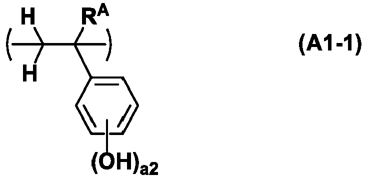 wherein R^{A} and a2 are as defined above.

3. The resist composition of claim 1 wherein the units containing a phenolic hydroxy group protected with an acid labile group have the formula (A5-2): 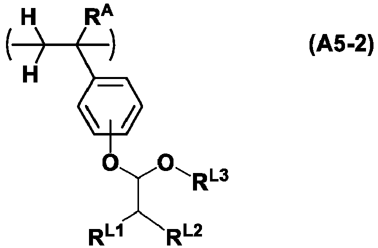 wherein R^{A}, R^{L1}, R^{L2} and R^{L3} are as defined above.

4. The resist composition of claim 1 wherein the photoacid generator (B) generates an acid having an acid strength (pKa) of -2.0 or more.

5. The resist composition of claim 4 wherein the photoacid generator (B) is a salt compound containing an anion having the formula (B-1): 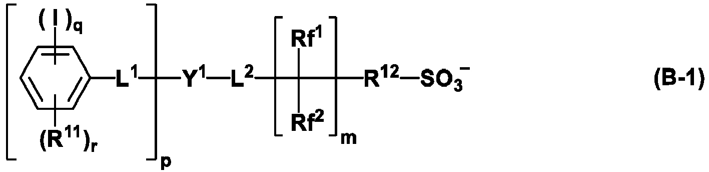
wherein m is 0 or 1, p is an integer of 1 to 3, q is an integer of 1 to 5, r is an integer of 0 to 3,
L¹ is a single bond, ether bond, ester bond, sulfonic ester bond, carbonate bond or carbamate bond,
L² is an ether bond, ester bond, sulfonic ester bond, carbonate bond or carbamate bond,
in case of p=1, Y¹ is a single bond or a C₁-C₂₀ hydrocarbylene group, in case of p=2 or 3, Y¹ is a C₁-C₂₀ (p+1)-valent hydrocarbon group, the hydrocarbylene group and (p+1)-valent hydrocarbon group may contain at least one moiety selected from ether bond, carbonyl moiety, ester bond, amide bond, sultone ring, lactam ring, carbonate bond, halogen, hydroxy moiety and carboxy moiety,
Rf¹ and Rf² are each independently hydrogen, fluorine or trifluoromethyl, at least one being fluorine or trifluoromethyl,
R¹¹ is hydroxy, carboxy, C₁-C₆ saturated hydrocarbyl group, C₁-C₆ saturated hydrocarbyloxy group, C₂-C₆ saturated hydrocarbylcarbonyloxy group, fluorine, chlorine, bromine, amino, -N(R^{11A})-C(=O)-R^{11B} or -N(R^{11A})-C(=O)-O-R^{11B}, R^{11A} is hydrogen or a C₁-C₆ saturated hydrocarbyl group, R^{11B} is a C₁-C₆ saturated hydrocarbyl group or C₂-C₈ unsaturated aliphatic hydrocarbyl group, and
R¹² is a C₁-C₂₀ saturated hydrocarbylene group or C₆-C₁₄ arylene group, some or all of the hydrogen atoms in the saturated hydrocarbylene group may be substituted by halogen other than fluorine, some or all of the hydrogen atoms in the arylene group may be substituted by a substituent selected from C₁-C₂₀ saturated hydrocarbyl groups, C₁-C₂₀ saturated hydrocarbyloxy groups, C₆-C₁₄ aryl groups, halogen, and hydroxy.

6. The positive resist composition of claim 1, further comprising (D) a fluorinated polymer comprising repeat units of at least one type selected from repeat units having the formula (D1), repeat units having the formula (D2), repeat units having the formula (D3) and repeat units having the formula (D4) and optionally repeat units of at least one type selected from repeat units having the formula (D5) and repeat units having the formula (D6): 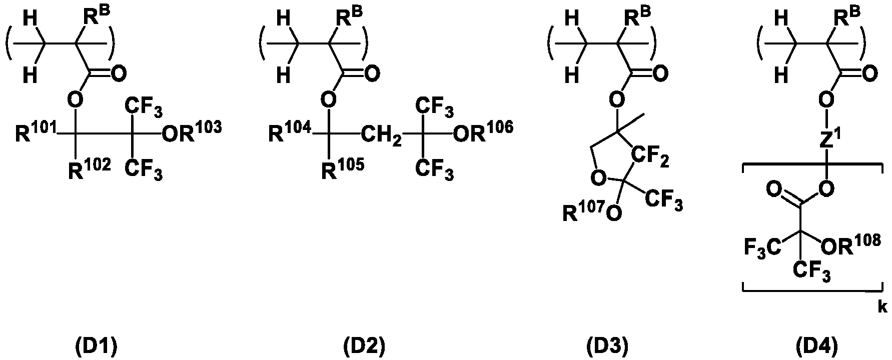 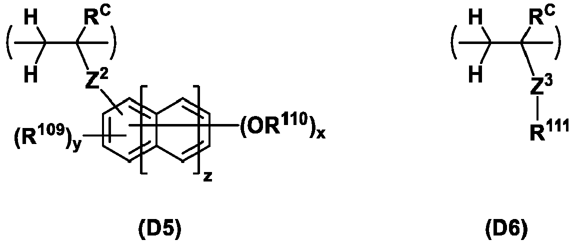
wherein R^{B} is each independently hydrogen, fluorine, methyl or trifluoromethyl,
R^{C} is each independently hydrogen or methyl,
R¹⁰¹, R¹⁰² , R¹⁰⁴ and R¹⁰⁵ are each independently hydrogen or a C₁-C₁₀ saturated hydrocarbyl group,
R¹⁰³, R¹⁰⁶, R¹⁰⁷ and R¹⁰⁸ are each independently hydrogen, a C₁-C₁₅ hydrocarbyl group, C₁-C₁₅ fluorinated hydrocarbyl group, or acid labile group,
when R¹⁰³, R¹⁰⁶, R¹⁰⁷ and R¹⁰⁸ each are a hydrocarbyl or fluorinated hydrocarbyl group, an ether bond or carbonyl moiety may intervene in a carbon-carbon bond,
R¹⁰⁹ is hydrogen or a C₁-C₅ straight or branched hydrocarbyl group in which a heteroatom-containing moiety may intervene in a carbon-carbon bond,
R¹¹⁰ is hydrogen or a C₁-C₅ straight or branched hydrocarbyl group in which a heteroatom-containing moiety may intervene in a carbon-carbon bond,
R¹¹¹ is a C₁-C₂₀ saturated hydrocarbyl group in which at least one hydrogen is substituted by fluorine, and in which some constituent -CH₂- may be replaced by an ester bond or ether bond,
x is an integer of 1 to 3, y is an integer satisfying 0 ≤ y ≤ 5+2z-x, z is 0 or 1, k is an integer of 1 to 3,
Z¹ is a C₁-C₂₀ (k+1)-valent hydrocarbon group or C₁-C₂₀ (k+1)-valent fluorinated hydrocarbon group,
Z² is a single bond, *-C(=O)-O- or *-C(=O)-NH-, * designates a point of attachment to the carbon atom in the backbone,
Z³ is a single bond, -O-, ^{∗}-C(=O)=O-Z³¹-Z³²- or ^{∗}-C(=O)-NH-Z³¹-Z³²-, Z³¹ is a single bond or C₁-C₁₀ saturated hydrocarbylene group, Z³² is a single bond, ester bond, ether bond, or sulfonamide bond, and * designates a point of attachment to the carbon atom in the backbone.

7. The positive resist composition of claim 1, further comprising an organic solvent.

8. The positive resist composition of claim 1 wherein the base polymer has a dissolution rate in alkaline developer of up to 5 nm/min.

9. The positive resist composition of claim 1 which forms a resist film, the resist film in an unexposed region having a dissolution rate in alkaline developer of up to 10 nm/min.

10. The positive resist composition of claim 1 which forms a resist film, the resist film in an exposed region having a dissolution rate in alkaline developer of at least 50 nm/sec.

11. A resist pattern forming process comprising the steps of:
applying the chemically amplified positive resist composition of any one of claims 1 to 10 onto a substrate to form a resist film thereon,
exposing the resist film to a pattern of EB, and
developing the exposed resist film in an alkaline developer.

12. The process of claim 11 wherein the substrate has the outermost surface of a material containing at least one element selected from chromium, silicon, tantalum, molybdenum, cobalt, nickel, tungsten, and tin.

13. The process of claim 11 wherein the substrate is a mask blank of transmission or reflection type.

14. A mask blank of transmission or reflection type which is coated with the chemically amplified positive resist composition of any one of claims 1 to 10.
